# EUROPÄISCHE PATENTSCHRIFT

(11) **EP 1 029 019 B1**
(45) Veröffentlichungstag und Bekanntmachung des Hinweises auf die Patenterteilung: **03.03.2004**
(21) Anmeldenummer: 98952737.9
(22) Anmeldetag: 22.10.1998
(51) Int. Cl.: C09K 11/06, H05B 33/14

(54) **SUBSTITUIERTE POLY(ARYLENVINYLENE), VERFAHREN ZUR HERSTELLUNG UND DEREN VERWENDUNG IN ELEKTROLUMINESZENZELEMENTEN**
SUBSTITUTED POLY(ARYLENE VINYLENES), METHOD FOR PRODUCING THE SAME, AND THEIR USE IN ELECTROLUMINESCENT ELEMENTS
POLY(ARYLENEVINYLENES) SUBSTITUES, LEUR PROCEDE DE PREPARATION ET LEUR UTILISATION DANS DES ELEMENTS ELECTROLUMINESCENTS

(30) Priorität: 05.11.1997 DE 19748814
(43) Veröffentlichungstag der Anmeldung: 23.08.2000
(73) Patentinhaber: Covion Organic Semiconductors GmbH, 65926 Frankfurt (DE)
(72) Erfinder: SPREITZER, Hubert, D-65929 Frankfurt am Main (DE); KREUDER, Willi, D-55126 Mainz (DE); BECKER, Heinrich, D-61479 Glashütten (DE); SCHENK, Hermann, D-65719 Hofheim (DE); YU, Nu, Knoxville, TN 37922 (US)
(74) Vertreter: Luderschmidt, Schüler & Partner GbR
(86) Internationale Anmeldenummer: PCT/EP1998/006722
(87) Internationale Veröffentlichungsnummer: WO 1999/024526

(56) Entgegenhaltungen:
- WO-A-98/25874
- WO-A-98/27136
- US-A- 5 558 904
- US-A- 5 817 430
- CHUNG S -J ET AL: "IMPROVED-EFFICIENCY LIGHT-EMITTING DIODES PREPARED FROM ORGANIC- SOLUBLE PPV DERIVATIVES WITH PHENYLANTHRACENE AND BRANCHED ALKOXY PENDENTS" ADVANCED MATERIALS, Bd. 10, Nr. 9, 18. Juni 1998, Seiten 684-688, XP000774673

## Beschreibung

Es besteht ein hoher industrieller Bedarf an großflächigen Festkörper-Lichtquellen, für eine Reihe von Anwendungen, überwiegend im Bereich von Anzeigeelementen, der Bildschirmtechnologie und der Beleuchtungstechnik. Die an diese Lichtquellen gestellten Anforderungen können zur Zeit von keiner der bestehenden Technologien völlig befriedigend gelöst werden.

Als Alternative zu herkömmlichen Anzeige- und Beleuchtungselementen, wie Glühlampen, Gasentladungslampen und nicht selbstleuchtenden Flüssigkristallanzeigeelementen, sind bereits seit einiger Zeit Elektrolumineszenz (EL)-materialien und -vorrichtungen, wie lichtemittierende Dioden (LED), in Gebrauch.

Neben anorganischen Elektrolumineszenzmaterialien und -vorrichtungen sind seit etwa 30 Jahren auch niedermolekulare, organische Elektrolumineszenzmaterialien und -vorrichtungen bekannt (siehe z.B. US-A-3,172,862). Bis vor kurzem waren aber solche Vorrichtungen in ihrer praktischen Anwendbarkeit stark eingeschränkt.

In der EP 423 283 und der EP 443 861 werden Elektrolumineszenzvorrichtungen beschrieben, die einen Film aus einem konjugierten Polymer als lichtemittierende Schicht (Halbleiterschicht) enthalten. Solche Vorrichtungen bieten zahlreiche Vorteile, wie die Möglichkeit, großflächige, flexible Displays einfach und kostengünstig herzustellen. Im Gegensatz zu Flüssigkristalldisplays sind Elektrolumineszenzdisplays selbstleuchtend und benötigen daher keine zusätzliche rückwärtige Beleuchtungsquelle.
Eine typische Vorrichtung nach der EP 423 283 besteht aus einer lichtemittierenden Schicht in Form eines dünnen, dichten Polymerfilms (Halbleiterschicht), der mindestens ein konjugiertes Polymer enthält. Eine erste Kontaktschicht steht in Kontakt mit einer ersten Oberfläche, eine zweite Kontaktschicht mit einer weiteren Oberfläche der Halbleiterschicht. Der Polymerfilm der Halbleiterschicht hat eine genügend geringe Konzentration von extrinsischen Ladungsträgern, so daß beim Anlegen eines elektrischen Feldes zwischen den beiden Kontaktschichten Ladungsträger in die Halbleiterschicht eingebracht werden, wobei die eine Kontaktschicht positiv gegenüber der anderen wird, und die Halbleiterschicht Strahlung aussendet. Die in solchen Vorrichtungen verwendeten Polymere werden als konjugiert bezeichnet. Unter konjugiertem Polymer versteht man ein Polymer, das ein delokalisiertes Elektronensystem entlang der Hauptkette besitzt. Das delokalisierte Elektronensystem verleiht dem Polymer Halbleitereigenschaften und gibt ihm die Möglichkeit, positive und/oder negative Ladungsträger mit hoher Mobilität zu transportieren.

In EP 423 283 und der EP 443 861 ist als polymeres Material für die lichtemittierende Schicht Poly-(p-phenylen-vinylen) beschrieben, welches zur Verbesserung der Eigenschaften mit Alkyl-, Alkoxy-, Halogen- oder Nitrosubstituenten am aromatischen Kern modifiziert werden kann. Derartige Polymere sind seither in einer großen Anzahl von Studien untersucht worden und insbesondere bisalkoxysubstituierte PPVs sind schon sehr weit in Richtung Anwendungsreife hin optimiert worden (vgl. z. B. J. Salbeck, Ber. Bunsenges. Phys. Chem. 1996, 100, 1667).

In der nicht vorveröffentlichten deutschen Patentanmeldung 196 52 261.7, mit dem Titel "Arylsubstituierte Poly(p-arylenvinylene), Verfahren zur Herstellung und deren Verwendung in Elektrolumineszenzbauelementen" sind arylsubstituierte Poly(parylenvinylene) vorgeschlagen, die sich auch zur Erzeugung grüner Elektrolumineszenz eignen.

Allerdings kann die Entwicklung derartiger Polymere keinesfalls als abgeschlossen betrachtet werden und es besteht weiterhin ein breiter Raum für Verbesserungen.

So sind unter anderem immer noch Verbesserungen hinsichtlich der Lebensdauer und der Beständigkeit insbesondere unter Temperaturbelastung möglich.

Aufgabe der vorliegenden Erfindung war es daher, Elektrolumineszenzmaterialien bereitzustellen, die bei Verwendung in Beleuchtungs- oder Anzeigevorrichtungen geeignet sind, das Eigenschaftsprofil dieser Vorrichtungen zu verbessern.

Es wurde nun überraschend gefunden, daß sich Poly-(arylphenylenvinylene) deren Phenyleneinheit einen weiteren Substituenten para oder meta zum Arylrest trägt, in besonderer Weise als Elektrolumineszenzmaterialien eignen.

Gegenstand der Erfindung sind daher lösliche Poly(arylenvinylene), enthaltend mindestens 20 % Wiederholeinheiten der Formel (I), 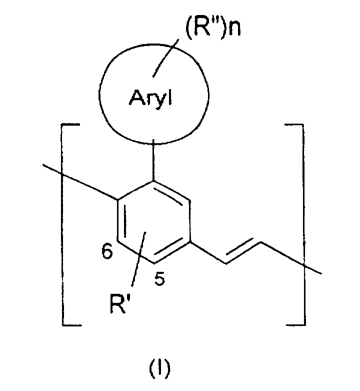 wobei die Symbole und Indizes folgende Bedeutungen haben:
- Aryl :: ist eine Arylgruppe mit 4 bis 14 C-Atomen;
- R' :: ist ein Substituent, der sich entweder in der markierten Phenylenposition 5 oder 6 befindet und ist CN, F, Cl, N(R¹R²) oder eine geradkettige, verzweigte oder cyclische Alkyl-, Alkoxy- oder Thioalkoxygruppe mit 1 bis 20 C-Atomen, in weicher ein oder mehrere H-Atome auch durch F ersetzt sein können;
- R" :: ist, gleich oder verschieden, CN, F, Cl oder eine geradkettige; verzweigte oder cyclische Alkyl- oder Alkoxygruppe mit 1 bis 20 C-Atomen, wobei ein oder mehrere nicht benachbarte CH₂-Gruppen durch -O-, -S-, -CO-, -COO-, -O-CO-, -NR¹-, -(NR²R³)⁺-A⁻, oder -CONR⁴- ersetzt sein können und wobei ein oder mehrere H-Atome durch F ersetzt sein können, oder eine Arylgruppe mit 4 bis 14 C-Atome, die durch einen oder mehrere, nicht aromatische Reste R' substituiert sein kann;
- R¹,R²,R³,R⁴: sind gleich oder verschieden, H oder ein aliphatischer oder aromatischer Kohlenwasserstoffrest mit 1 bis 20 C-Atomen;
- A⁻ :: ein einfach geladenes Anion oder dessen Äquivalent;
- n :: 0, 1, 2, 3, 4 oder 5;

Die erfindungsgemäßen Polymere eignen sich in hervorragender Weise zur Verwendung als Elektrolumineszenzmaterialien. Sie zeigen beispielsweise den Vorteil, daß sie im Dauerbetrieb auch bei erhöhten Temperaturen (z.B. mehrstündiges Erhitzen auf 85°C) eine konstante Helligkeit aufweisen.

Somit ist es nicht notwendig, bei Dauerbetrieb die Spannung nachzuregulieren, um eine anfängliche Helligkeit zu erhalten. Dieser Vorteil macht sich insbesondere bei Batteriebetrieb bemerkbar, da hierbei die wirtschaftlich mögliche Höchstspannung stark eingeschränkt ist.

Ebenso weisen Vorrichtungen, die erfindungsgemäße Polymere enthalten, eine lange Lebensdauer auf.

Die erfindungsgemäßen Polymere weisen überraschenderweise einen besonders niedrigen Anteil an Defektstrukturen auf.

Die Polymere weisen im allgemeinen 10 bis 10000, vorzugsweise 10 bis 5000, besonders bevorzugt 100 bis 5000, ganz besonders bevorzugt 250 bis 2000 Wiederholeinheiten auf.

Erfindungsgemäße Polymere enthalten zu mindestens 20% Wiederholeinheiten der Formel (I), bevorzugt mindestens 30%, besonders bevorzugt mindestens 40%.

Bevorzugt sind weiterhin auch Copolymere, bestehend aus Wiederholeinheiten der Formel (I) und Wiederholeinheiten, welche eine 2,5-Dialkoxy-1,4-phenylenvinylenstruktur aufweisen. Ebenfalls bevorzugt sind Copolymere, bestehend aus Wiederholeinheiten der Formel (I) und Wiederholeinheiten, welche eine nicht weiter substituierte 2-Aryl-1,4-arylenvinylenstruktur aufweisen.

Weiterhin bevorzugt sind Copolymere, die 1, 2 oder 3 verschiedene, Wiederholeinheiten der Formel (I) aufweisen.

Copolymere im Sinne der Erfindung umfassen statistische, alternierende, reguläre sowie blockartige Strukturen.

Ebenso bevorzugt sind Polymere, enthaltend Wiederholeinheiten der Formel (I), bei denen die Symbole und Indizes folgende Bedeutungen haben:
- Aryl: ist Phenyl, 1- bzw. 2-Naphthyl, 1-, 2- bzw. 9-Anthracenyl, 2-, 3- bzw. 4-Pyridinyl, 2-, 4- bzw. 5-Pyrimidinyl, 2-Pyrazinyl, 3- bzw. 4-Pyridazinyl, 2-, 3-, 4-, 5-, 6-, 7- bzw. 8-Chinolin, 2- bzw. 3-Thiophenyl, 2- bzw. 3-Pyrrolyl, 2- bzw. 3-Furanyl und 2-(1,3,4-Oxadiazol)yl;
- R': ist gleich oder verschieden, CN, F, Cl, CF₃ oder eine geradkettige oder verzweigte Alkoxygruppe mit 1 bis 12 C-Atomen;
- R": ist gleich oder verschieden eine geradkettige oder verzweigte Alkyl- oder Alkoxygruppe mit 1 bis 12 C-Atomen;
- n: ist 0, 1, 2 oder 3, besonders bevorzugt 0, 1 oder 2.

Besonders bevorzugt sind Polymere, in denen in der Formel (I) der Arylsubstituent folgende Bedeutung hat: Phenyl, 1-Naphthyl, 2-Naphthyl oder 9-Anthracenyl.

Des weiteren sind Polymere besonders bevorzugt, in denen in der Formel (I) der Arylsubstituent folgendes Substitutionsmuster aufweist:
2-, 3- bzw. 4-Alkyl(oxy)phenyl, 2,3-, 2,4-, 2,5-, 2,6-, 3,4- oder 3,5-Dialkyl(oxy)phenyl, 2,3,4,-, 2,3,5-, 2,3,6-, 2,4,5, 2,4,6- oder 3,4,5-Trialkyl(oxy)phenyl, 2-, 3-, 4-, 5-, 6-, 7-oder 8-Alkyl(oxy)-1-naphthyl, 1-, 3-, 4-, 5-, 6-, 7- oder 8-Alkyl(oxy)-2-naphthyl und 10-Alkyl(oxy)-9-anthracenyl.

Die erfindungsgemäßen Polymere sind beispielsweise aus Edukten der Formel (II), in welcher die Symbole und Indizes die unter Formel (I) erläuterte Bedeutung haben und Hal, Hal' für Cl, Br oder I stehen, durch Dehydrohalogenierungspolymerisation zu erhalten; dies geschieht in der Regel durch Umsetzung eines oder mehrerer Monomere in einem geeigneten Lösungsmittel mit einer geeigneten Base.

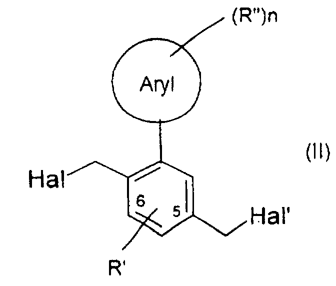

Diese Monomere sind ― mit Ausnahme von 2,5-Bis(chlormethyl)-4-methoxy-4'-(3,7-dimethyloctyloxy)-biphenyl und 2,5-Bis(chlormethyl)-4-methoxy-3'-(3,7-dimethyloctyloxy)-biphenyl, die beide in WO 98/25874 offenbart wurden ― neu und daher ebenfalls Gegenstand dieser Erfindung.
Dazu werden die Monomere in geeigneten Lösungsmitteln in geeigneten Konzentrationen gelöst, auf die geeignete Reaktionstemperatur gebracht und mit der geeigneten Menge einer geeigneten Base versetzt. Nach Ablauf einer geeigneten Reaktionszeit kann die Reaktionslösung z. B. durch Säurezugabe abgebrochen werden. Im Anschluß daran reinigt man das Polymer nach geeigneten, dem Fachmann geläufigen Verfahren, wie z. B. Umfällen oder Extraktion.
Geeignete Lösungsmittel stellen beispielsweise Ether (z. B. Diethylether, THF, Dioxan, Dioxolan, tert.-Butylmethylether), aromatische Kohlenwasserstoffe (z. B. Toluol, Xylole, Anisol, Methylnaphthaline), Alkohole (z. B. Ethanol, tert.-Butanol), chlorierte Verbindungen (z. B. Chlorbenzol, Dichlorbenzol) und Mischungen aus diesen Lösungsmitteln dar.
Einen geeigneten Konzentrationsbereich stellt dabei das Intervall von 0.005 bis 5 mol/l (Monomer/Lösungsvolumen) dar. Bevorzugt ist dabei der Bereich von 0.01 bis 2 mol/l, ganz besonders bevorzugt der Bereich von 0.01 bis 0.5 mol/l.
Die Reaktionstemperatur beträgt in der Regel zwischen -80 und 200°C, bevorzugt zwischen 20 und 140°C.
Als Basen sind beispielsweise Alkalimetallhydroxide (NaOH, KOH), -hydride (NaH, KH) und -alkoholate (NaOEt, KOEt, NaOMe, KOMe, KO^{t}Bu), Metallorganyle (nBuLi, sBuLi, tBuLi, PhLi) und organische Amine (LDA, DBU, DMAP, Pyridin) geeignet. Eine geeignete Menge liegt im Bereich von 2 bis 10 Äquivalenten (bezogen auf ein Äquivalent Monomer), bevorzugt 3.5 bis 8, besonders bevorzugt 4 bis 6 Äquivalente. Die Reaktionszeit beträgt in der Regel zwischen 5 Minuten und 24 Stunden, bevorzugt zwischen 0.5 und 6, ganz besonders bevorzugt zwischen 1 und 4 Stunden.

Dieses Verfahren ist ebenfalls Gegenstand der Erfindung.

Die in Formel (II) angegebenen Biarylderivate können nach dem in Schema 1 skizzierten Weg gewonnen werden:

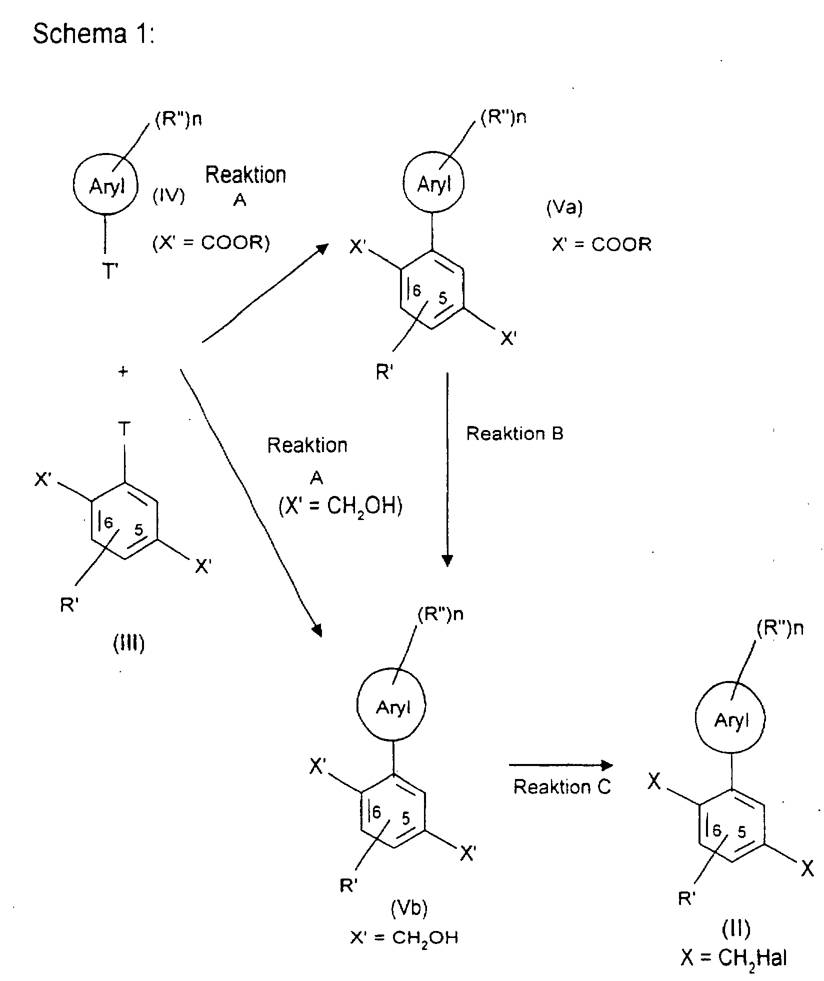

Die Ausgangsverbindungen der Formeln (III) und (IV) sind sehr gut zugänglich, da sie in einfacher Weise und großer Menge aus kommerziell erhältlichen Verbindungen herstellbar sind.

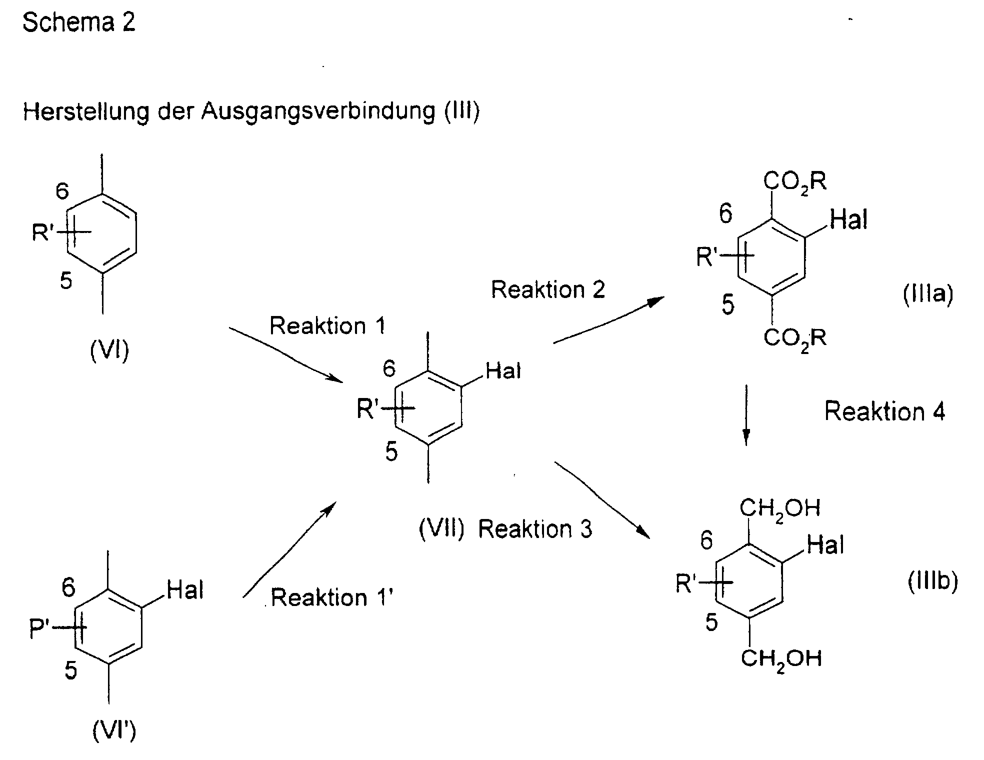

Die Reaktionen in Schema 2 sind wie folgt zu erläutern: 1,4-Dimethyl-Verbindung (VI) ist in der Regel kommerziell erhältlich (z. B. 2,5-Dimethylphenol, 2,5-Dimethylanilin, 2,5-Dimethylbenzonitril, 2,5-Dimethylanisol) oder aus kommerziell erhältlichen Verbindungen einfach herzustellen (z. B. Alkylierung eines entsprechenden Phenols oder Amins). Verbindung (VI) kann nach Standardmethoden am Aromaten halogeniert, z.B. chloriert oder bromiert, werden (siehe z.B. Organikum, VEB Deutscher Verlag der Wissenschaften, 15. Auflage, S. 391 ff., Leipzig 1984). Die damit erhaltenen Verbindungen (VII) sind in guten Ausbeuten und industriellen Mengen zugänglich.
Analog sind auch Verbindungen vom Typ (VI') entweder kommerziell erhältlich oder leicht darstellbar (z. B. 2,5-Dibrom-p-xylol). Diese Verbindungen können dann durch Standardreaktionen (z. B. nucleophile Substitution eines Halogens mit einem Alkoxyrest) ebenfalls in Verbindungen vom Typ (VII) umgewandelt werden. (VII) kann, vorzugsweise katalytisch (Kobaltkatalysator, Luftsauerstoff, siehe z.B.
EP-A 0 121 684) zu den entsprechenden 1,4-Dicarbonsäuren (IIIa) umgesetzt werden. Bei geeigneter Wahl der Reaktionsbedingungen ist dies unabhängig vom Substituenten möglich. Die erhaltenen Säuren, (IIIa) mit R = H, sind gegebenenfalls nach Standardmethoden in entsprechende Ester (R≠H) überführbar.

Die auf diese Weise nahezu quantitativ erhaltenen Verbindungen der Formel (IIIa) sind über geläufige Reduktionsreaktionen in die Bisalkohole (IIIb) überführbar. Diese sind auch direkt durch Oxidation (siehe z.B. A. Belli et al., Synthesis 1980, 477) aus den Verbindungen der Formel (VII) erhältlich.

Es kann sich auch als vorteilhaft erweisen, erst auf Stufe der Carbonsäure bzw. ihres Esters, den Substituenten (P') in den Substituenten (R') umzuwandeln, d. h. die Reaktion (1') erst hier durchzuführen. Dies ist vorallem bei langkettigen Alkoxysubstituenten sinnvoll, da diese sonst eventuell durch die Luftoxidation zerstört würden.

Gegebenenfalls kann das Halogenatom auf einer geeigneten Stufe, wie im folgenden für die Verbindungen der Formel (IVa) beschrieben, gegen eine Boronsäure(ester)- oder Trialkylzinn-Gruppe ausgetauscht werden.

Die Herstellung entsprechender Perfluoralkylsulfonate kann beispielsweise durch Veresterung entsprechender Phenolfunktionen erfolgen.

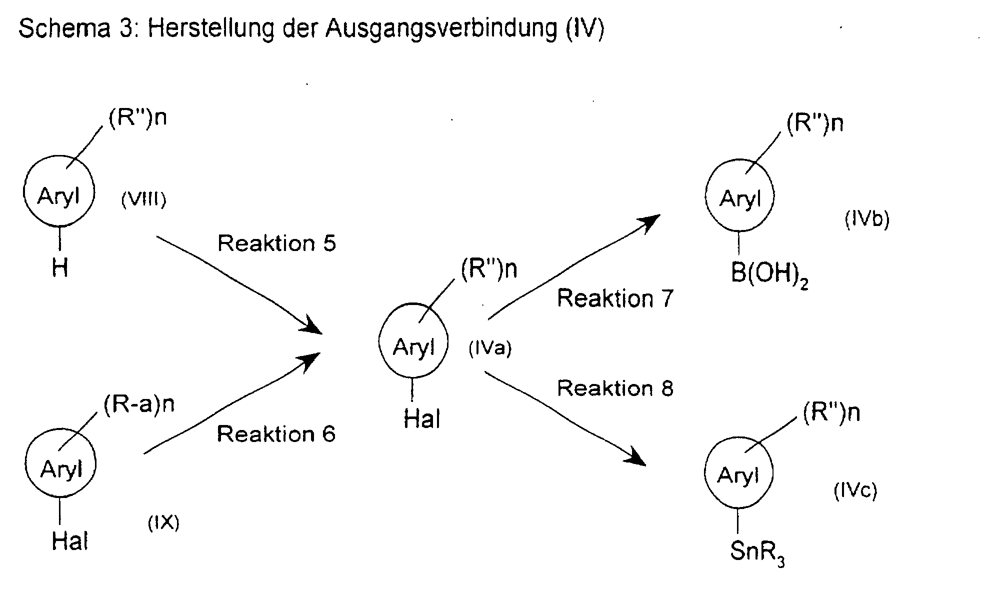

Schema 3 ist wie folgt zu erläutern: Die Verbindungen (VIII) sind in der Regel käuflich zu erwerben (z. B. diverse Alkyl- und Dialkylaromaten, Alkoxyaromaten) oder einfach aus entsprechenden Vorstufen (z. B. Hydrochinon, Brenzcatechin, Naphthol u.ä.) z.B. durch Alkylierung herzustellen. Verbindung (VIII) kann dann durch einfache Halogenierungsreaktionen (Reaktion 5) wie oben beschrieben in Verbindungen der Formel (IVa) umgewandelt werden. Viele Verbindungen der Formel (IX) sind wohlfeile Chemikalien (z. B. Bromphenol, Bromanilin), welche durch Reaktion 6 (z. B. Alkylierung von Phenolfunktionen) einfach in Verbindungen der Formel (IVa) überführbar sind. Diese sind nun durch entsprechende Reagentien (z. B. Mg-Späne, n-BuLi, s-BuLi) zu metallieren und dann durch entsprechende weitere Umsetzung, z. B. mit Trialkylzinnchlorid, Borsäuretrialkylester, in die entsprechenden Verbindungen der Formel (IVb) bzw. (IVc) umwandelbar.

Damit wird gezeigt, daß die Ausgangsverbindungen (III) und (IV) in der geforderten Variationsbreite einfach zugänglich sind. Die Ausgangsverbindungen (III) und (IV) werden durch eine Kupplungsreaktion (Reaktion A in Schema 1) zu Zwischenprodukten der Formel (V) umgesetzt.

Dazu werden die Verbindungen der Formeln (III) und (IV) in einem inerten Lösungsmittel bei einer Temperatur im Bereich von 0°C bis 200°C in Gegenwart eines Palladiumkatalysators zur Reaktion gebracht.
Dabei enthält jeweils eine der Verbindungen, vorzugsweise die der Formel (III), eine Halogen- oder Perfluoralkylsulfonat-Gruppe, die andere eine Boronsäure(ester)-Gruppe (IVb) oder eine Trialkylzinn-Gruppe (IVc).

Zur Durchführung der angegebenen Reaktion A mit Boronsäure(ester)n der Formel (IVb), Variante Aa, Suzuki-Kupplung, werden die aromatische Borverbindung, die aromatische Halogenverbindung bzw. das Perfluoralkylsulfonat, eine Base und katalytische Mengen des Palladiumkatalysators in Wasser oder in ein oder mehrere inerte organische Lösungsmittel oder vorzugsweise in eine Mischung aus Wasser und einem oder mehreren inerten organischen Lösungsmitteln gegeben und bei einer Temperatur von 0 bis 200°C, bevorzugt bei 30 bis 170°C, besonders bevorzugt bei 50 bis 150°C, insbesonders bevorzugt bei 60 bis 120°C für einen Zeitraum von 1 h bis 100 h, bevorzugt 5 h bis 70 h, besonders bevorzugt 5 h bis 50 h, gerührt. Das Rohprodukt kann nach dem Fachmann bekannten und dem jeweiligen Produkt angemessenen Methoden, z.B. durch Umkristallisation, Destillation, Sublimation, Zonenschmelzen, Schmelzkristallisation oder Chromatographie, aufgereinigt werden.

Für das beschriebene Verfahren geeignete organische Lösungsmittel sind beispielsweise Ether, z. B. Diethylether, Dimethoxyethan, Diethylenglykoldimethylether, Tetrahydrofuran, Dioxan, Dioxolan, Diisopropylether, tert.-Butylmethylether, Kohlenwasserstoffe, z. B. Hexan, iso-Hexan, Heptan, Cyclohexan, Toluol, Xylol, Alkohole, z. B. Methanol, Ethanol, 1-Propanol, 2-Propanol, Ethylenglykol, 1-Butanol, 2-Butanol, tert.-Butanol, Ketone, z. B. Aceton, Ethylmethylketon, iso-Butylmethylketon, Amide, z.B. Dimethylformamid, Dimethylacetamid, N-Methylpyrrolidon, Nitrile, z.B. Acetonitril, Propionitril, Butyronitril, und Mischungen derselben.

Bevorzugte organische Lösungsmittel sind Ether, wie Dimethoxyethan, Diethylenglykoldimethylether, Tetrahydrofuran, Dioxan, Diisopropylether, Kohlenwasserstoffe, wie Hexan, Heptan, Cyclohexan, Toluol, Xylol, Alkohole, wie Methanol, Ethanol, 1-Propanol, 2-Propanol, 1-Butanol, 2-Butanol, tert.-Butanol, Ethylenglykol, Ketone, wie Ethylmethylketon, iso-Butylmethylketon, Amide, wie Dimethylformamid, Dimethylacetamid, N-Methylpyrrolidon und Mischungen derselben.

Besonders bevorzugte Lösungsmittel sind Ether, z. B. Dimethoxyethan, Tetrahydrofuran, Kohlenwasserstoffe, z. B. Cyclohexan, Toluol, Xylol, Alkohole, z. B. Ethanol, 1-Propanol, 2-Propanol, 1-Butanol, tert.-Butanol und Mischungen derselben.

In einer besonders bevorzugten Variante werden bei dem beschriebenen Verfahren Wasser und ein oder mehrere in Wasser unlösliche Lösungsmittel eingesetzt. Beispiele sind Mischungen aus Wasser und Toluol sowie Wasser, Toluol und Tetrahydrofuran.

Basen, die bei dem beschriebenen Verfahren vorzugsweise Verwendung finden sind Alkali- und Erdalkalimetallhydroxide, Alkali- und Erdalkalimetallcarbonate, Alkalimetallhydrogencarbonate, Alkali- und Erdalkalimetallacetate, Alkali- und Erdalkalimetallalkoholate, sowie primäre, sekundäre und tertiäre Amine.

Besonders bevorzugt sind Alkali- und Erdalkalimetallhydroxide, Alkali- und Erdalkalimetallcarbonate und Alkalimetallhydrogencarbonate. Insbesondere bevorzugt sind Alkalimetallhydroxide, wie Natriumhydroxid und Kaliumhydroxid, sowie Alkalimetallcarbonate und Alkalimetallhydrogencarbonate, wie Lithiumcarbonat, Natriumcarbonat und Kaliumcarbonat.

Die Base wird bei dem angebenen Verfahren bevorzugt mit einem Anteil von 100 bis 1000 Mol-%, besonders bevorzugt 100 bis 500 Mol-%, ganz besonders bevorzugt 150 bis 400 Mol-%, insbesondere 180 bis 250 Mol-%, bezogen auf die aromatische Borverbindung, eingesetzt.

Der Palladiumkatalysator enthält Palladiummetall oder eine Palladium (0) oder (II) Verbindung und einen Komplexliganden, vorzugsweise einen Phosphanliganden.

Die beiden Komponenten können eine Verbindung bilden, z.B. das besonders bevorzugte Pd(PPh₃)₄, oder getrennt eingesetzt werden.

Als Palladiumkomponente eignen sich beispielsweise Palladiumverbindungen, wie Palladiumketonate, Palladiumacetylacetonate, Nitrilpalladiumhalogenide, Olefinpalladiumhalogenide, Palladiumhalogenide, Allylpalladiumhalogenide und Palladiumbiscarboxylate, bevorzugt Palladiumketonate, Palladiumacetylacetonate, bis-η²-Olefinpalladiumdihalogenide, Palladium(II)halogenide, η³-Allylpalladiumhalogenid Dimere und Palladiumbiscarboxylate, ganz besonders bevorzugt Bis(dibenzylidenaceton)palladium(O) [Pd(dba)₂)], Pd(dba)₂ CHCl₃, Palladiumbisacetylacetonat, Bis(benzonitril)palladiumdichlorid, PdCl₂, Na₂PdCl₄, Dichlorobis(dimethylsulfoxid)palladium(II), Bis(acetonitril)palladiumdichlorid, Palladium-II-acetat, Palladium-II-propionat, Palladium-II-butanoat und (1c,5c-Cyclooctadien)palladiumdichlorid.

Ebenso als Katalysator dienen kann Palladium in metallischer Form, im folgenden nur Palladium genannt, vorzugsweise Palladium in pulverisierter Form oder auf einem Trägermaterial, z.B. Palladium auf Aktivkohle, Palladium auf Aluminiumoxid, Palladium auf Bariumcarbonat, Palladium auf Bariumsulfat, Palladium auf Aluminiumsilikaten, wie Montmorillonit, Palladium auf SiO₂ und Palladium auf Calciumcarbonat, jeweils mit einem Palladiumgehalt von 0,5 bis 10 Gew.-%. Besonders bevorzugt sind Palladium in pulverisierter Form, Palladium auf Aktivkohle, Palladium auf Barium- und/oder Calciumcarbonat und Palladium auf Bariumsulfat, jeweils mit einem Palladiumgehalt von 0,5 bis 10 Gew.-% insbesondere bevorzugt ist Palladium auf Aktivkohle mit einem Palladiumgehalt von 5 oder 10 Gew.-%.

Der Palladiumkatalysator wird bei dem erfindungsgemäßen Verfahren mit einem Anteil von 0,01 bis 10 Mol-%, bevorzugt 0,05 bis 5 Mol-%, besonders bevorzugt 0,1 bis 3 Mol-%, insbesondere bevorzugt 0,1 bis 1,5 Mol-%, bezogen auf die aromatische Halogenverbindung oder das Perfluoralkylsulfonat, eingesetzt.

Für das Verfahren geeignete Liganden sind beispielsweise Phosphane, wie Trialkylphosphane, Tricycloalkylphosphane, Triarylphosphane, wobei die drei Substituenten am Phosphor gleich oder verschieden, chiral oder achiral sein können und wobei einer oder mehrere der Liganden die Phosphorgruppen mehrerer Phosphane verknüpfen können und wobei ein Teil dieser Verknüpfung auch ein oder mehrere Metallatome sein können.
Beispiele für im Rahmen des hier beschriebenen Verfahrens verwendbare Phosphane sind Trimethylphosphan, Tributylphosphan, Tricyclohexylphosphan, Triphenylphosphan, Trisolylphosphan, Tris(o-tolyl)phosphan, Tris-(4-dimethylaminophenyl)-phosphan, Bis(diphenylphosphano)methan, 1,2-Bis(diphenylphosphano)ethan, 1,3-Bis(diphenylphosphano)propan und 1,1'-Bis(diphenylphosphano)-ferrocen.
Weitere geeignete Liganden sind beispielsweise Diketone, z. B. Acetylaceton und Octafluoracetylaceton und tert. Amine, z. B. Trimethylamin, Triethylamin, Tri-npropylamin und Triisopropylamin.
Bevorzugte Liganden sind Phosphane und Diketone, besonders bevorzugt sind Phosphane.
Ganz besonders bevorzugte Liganden sind Triphenylphosphan, 1,2-Bis(diphenylphosphano)ethan, 1,3-Bis(diphenylphosphano)propan und 1,1'-Bis(diphenylphosphano)-ferrocen, insbesondere Triphenylphosphan.

Für das Verfahren weiterhin geeignet sind wasserlösliche Liganden, die beispielsweise Sulfonsäuresalz- und/oder Sulfonsäurereste und/oder Carbonsäuresalz- und/oder Carbonsäurereste und/oder Phosphonsäuresalz und/oder Phosphonsäurereste und/oder Phosphoniumgruppen und/oder Peralkylammoniumgruppen und/oder Hydroxygruppen und/oder Polyethergruppen mit geeigneter Kettenlänge enthalten.

Bevorzugte Klassen von wasserlöslichen Liganden sind mit den obigen Gruppen substituierte Phosphane, wie Trialkylphosphane, Tricycloalkylphosphane, Triarylphosphane, Dialkylarylphosphane, Alkyldiarylphosphane und Heteroarylphosphane wie Tripyridylphosphan und Trifurylphosphan, wobei die drei Substituenten am Phosphor gleich oder verschieden, chiral oder achiral sein können und wobei einer oder mehrere der Liganden die Phosphorgruppen mehrerer Phosphane verknüpfen können und wobei ein Teil dieser Verknüpfung auch ein oder mehrere Metallatome sein können, Phosphite, Phosphinigsäureester und Phosphonigsäureester, Phosphole, Dibenzophosphole und Phosphoratome enthaltende cyclische bzw. oligo- und polycyclische Verbindungen.

Der Ligand wird bei dem Verfahren mit einem Anteil von 0,1 bis 20 Mol %, bevorzugt 0,2 bis 15 Mol %, besonders bevorzugt 0,5 bis 10 Mol %, insbesonders bevorzugt 1 bis 6 Mol %, bezogen auf die aromatische Halogenverbindung oder das Perfluoralkylsulfonat, eingesetzt. Es können gegebenenfalls auch Mischungen zweier oder mehrerer verschiedener Liganden eingesetzt werden.

Das eingesetzte Boronsäurederivat kann ganz oder teilweise als Anhydrid vorliegen.

Vorteilhafte Ausführungsformen des beschriebenen Verfahrens der Variante Aa sind z.B. in WO 94/101 05, EP-A-679 619, WO-A-694 530 und PCT/EP 96/03154 beschrieben, auf die hiermit ausdrücklich Bezug genommen wird. Sie gelten durch Zitat als Bestandteil der Beschreibung dieser Anmeldung.

Bei der Variante Ab, auch Stille-Kupplung genannt, wird eine aromatische Zinnverbindung, vorzugsweise der Formel (IVc), mit einer aromatischen Halogenverbindung oder einen aromatischen Perfluoralkylsulfonat vorzugsweise der Formel (III), bei einer Temperatur im Bereich von 0°C bis 200°C in einem inerten organischen Lösungsmittel in Gegenwart eines Palladiumkatalysators umgesetzt.

Ein Überblick über diese Reaktion findet sich z.B. bei J.K. Stille, Angew. Chemie Int. Ed. Engl. 1986, 25, 508.

Zur Durchführung des Verfahrens werden bevorzugt die aromatische Zinnverbindung, die aromatische Halogenverbindung bzw. das Perfluoralkylsulfonat, in ein oder mehrere inerte organische Lösungsmittel gegeben und bei einer Temperatur von 0°C bis 200°C, bevorzugt bei 30°C bis 170°C, besonders bevorzugt bei 50°C bis 150°C, insbesondere bevorzugt bei 60°C bis 120°C für einen Zeitraum von 1 h bis 100 h, bevorzugt 5 h bis 70 h, besonders bevorzugt 5 h bis 50 h, gerührt. Nach beendeter Umsetzung wird der als Feststoff anfallende Pd-Katalysator beispielsweise durch Filtration abgetrennt und das Rohprodukt vom Lösungsmittel bzw. den Lösungsmitteln befreit. Anschließend kann nach dem Fachmann bekannten und dem jeweiligen Produkt angemessene Methoden, z.B. durch Umkristallisation, Destillation, Sublimation, Zonenschmelzen, Schmelzkristallisation oder Chromatographie, weiter aufgereinigt werden.
Für das beschriebene Verfahren geeignete organische Lösungsmittel sind beispielsweise Ether, z.B. Diethylether, Dimethoxyethan, Diethylenglykoldimethylether, Tetrahydrofuran, Dioxan, Dioxolan, Diisopropylether, tert.-Butylmethylether, Kohlenwasserstoff, z.B. Hexan, iso-Hexan, Heptan, Cyclohexan, Benzol, Toluol, Xylol, Alkohole, z.B. Methanol, Ethanol, 1-Propanol, 2-Propanol, Ethylenglykol, 1-Butanol, 2-Butanol, tert.-Butanol, Ketone, z.B. Aceton, Ethyl-methylketon, iso-Butylmethylketon, Amide, z.B. Dimethylformamid (DMF), Dimethylacetamid, N-Methylpyrrolidon, Nitrile, z.B. Acetonitril, Propionitril, Butyronitril und Mischungen derselben.

Bevorzugte organische Lösungsmittel sind Ether, wie Dimethoxyethan, Diethylenglykoldimethylether, Tetrahydrofuran, Dioxan, Diisopropylether, Kohlenwasserstoffe, wie Hexan, Heptan, Cyclohexan, Benzol, Toluol, Xylol, Alkohole, wie Methanol, Ethanol, 1-Propanol, 2-Propanol, 1-Butanol, 2-Butanol, tert.-Butanol, Ethylenglykol, Ketone, wie Ethylmethylketon, oder Amide, wie DMF.

Besonders bevorzugte Lösungsmittel sind Amide, ganz besonders bevorzugt ist DMF.

Der Palladiumkatalysator enthält Palladiummetall oder eine Palladium (0) oder (II) Verbindung und einen Komplexliganden, vorzugsweise einen Phosphanliganden.

Die beiden Komponenten können eine Verbindung bilden, z.B. Pd(PPh₃)₄, oder getrennt eingesetzt werden.

Als Palladiumkomponente eignen sich beispielsweise Palladiumverbindungen, wie Palladiumketonate, Palladiumacetylacetonate, Nitrilpalladiumhalogenide, Olefinpalladiumhalogenide, Palladiumhalogenide, Allylpalladiumhalogenide und Palladiumbiscarboxylate, bevorzugt Palladiumketonate, Palladiumacetylacetonate, bis-η²-Olefinpalladiumdihalogenide, Palladium(II)halogenide, η³-Allylpalladiumhalogenid Dimere und Palladiumbiscarboxylate, ganz besonders bevorzugt Bis(dibenzylidenaceton)palladium(0) [Pd(dba)₂)], Pd(dba)₂ CHCl₃, Palladiumbisacetylacetonat, Bis(benzonitril)palladiumdichlorid, PdCl₂, Na₂PdCl₄, Dichlorobis(dimethylsulfoxid)palladium(II), Bis(acetonitril)palladiumdichlorid, Palladium-II-acetat, Palladium-II-propionat, Palladium-II-butanoat und (1c,5c-Cyclooctadien)palladiumdichlorid.

Der Palladiumkatalysator wird bei dem beschriebenen Verfahren mit einem Anteil von 0,01 bis 10 Mol-%, bevorzugt 0,05 bis 5 Mol-%, besonders bevorzugt 0,1 bis 3 Mol-%, insbesondere bevorzugt 0,1 bis 1,5 Mol-%, bezogen auf die aromatische Halogenverbindung oder das Perfluoralkylsulfonat, eingesetzt.

Für das beschriebene Verfahren geeignete Liganden sind beispielsweise Phosphane, wie Trialkylphosphane, Tricycloalkylphosphane, Triarylphosphane, wobei die drei Substituenten am Phosphor gleich oder verschieden, chiral oder achiral sein können und wobei einer oder mehrere der Liganden die Phosphorgruppen mehrerer Phosphane verknüpfen können und wobei ein Teil dieser Verknüpfung auch ein oder mehrere Metallatome sein können.

Der Ligand wird bei dem beschriebenen Verfahren mit einem Anteil von 0,1 bis 20 Mol-%, bevorzugt 0,2 bis 15 Mol-%, besonders bevorzugt 0,5 bis 10 Mol-%, insbesonders bevorzugt 1 bis 6 Mol-%, bezogen auf die aromatische Halogenverbindung oder das Perfluoralkylsulfonat, eingesetzt.

### Reaktion B

Falls die Gruppe X' in dem Zwischenprodukt (V) -COOR ist, wird zum Bisalkohol, X' = CH₂OH, reduziert.

Die Reduktion kann nach bekannten, dem Fachmann geläufigen Methoden erfolgen, wie sie beispielsweise in Houben-Weyl, 4. Aufl, Bd. 6, 16, Kap. VIII, Georg-Thieme-Verlag, Stuttgart 1984, beschrieben sind.

Bevorzugte Ausführungsformen sind
a) Umsetzung mit LiAlH₄ oder Diisobutylaluminiumhydrid (DIBAL-H) in Tetrahydrofuran (THF) oder Toluol, wie beispielsweise in Organikum (s.o.), S. 612 ff. beschrieben
b) Umsetzung mit Borhydriden, wie BH₃, wie beispielsweise in Houben-Weyl, 4. Aufl, Bd. 6, 16, Kap. VIII, S. 211-219, Georg-Thieme-Verlag, Stuttgart 1984, beschrieben.
c) Umsetzung mit Wasserstoff in Gegenwart eines Katalysators, . wie beispielsweise in Houben-Weyl, 4. Aufl, Bd. 6, 16, Kap. VIII, S. 110 f, Georg-Thieme-Verlag, Stuttgart 1984, beschrieben
d) Reaktion mit Natrium oder Natriumhydrid.

Besonders bevorzugt ist die Reduktion mit LiAlH₄ oder DIBAL-H.

### Reaktion C

Erfindungsgemäß können die OH-Gruppen in den Bisalkoholen der Formel (V) durch nucleophile Substitution gegen Halogen ausgetauscht werden.

Zur Herstellung von Chloriden und Bromiden ist es bevorzugt, den entsprechenden Bisalkohol mit HCl bzw. HBr, beispielsweise in Eisessig, umzusetzen (siehe z.B. Houben-Weyl, Band 5/4, S. 385 ff, 1960) oder mit Thionylchlorid bzw. -bromid, gegebenenfalls in Gegenwart eines Katalysators, zur Reaktion zu bringen (siehe z.B. Houben-Weyl, Band 5/1b, S. 862 ff., 1962).
Chloride lassen sich auch bevorzugt durch Reaktion mit Phosgen (siehe z.B.
Houben-Weyl, Band V, 3, S. 952 ff, 1962) oder mit BCl₃, Bromide durch Reaktion mit PBr₃ herstellen.

Iodide lassen sich vorzugsweise durch Reaktion mit Phosphor/Iod nach A.I. Vogel (siehe z.B. Houben-Weyl, Band V, 4, s. 615 f., 1969) herstellen.
Alternativ lassen sich die Halogenide vergleichbar der FINKELSTEIN-Reaktion gegeneinander austauschen; somit können auch Monomere, die zwei unterschiedliche Halogenide, bzw. deren Gemische enthalten, vorteilhaft eingesetzt werden.
Die Aufarbeitung erfolgt in allen Fällen in einfacher Weise nach bekannten, dem Fachmann geläufigen Methoden.

Mit den hier aufgeführten Synthesemethoden lassen sich beispielsweise die nachfolgend aufgeführten Monomeren, welche zu erfindungsgemäßen Polymeren umgesetzt werden können, herstellen.

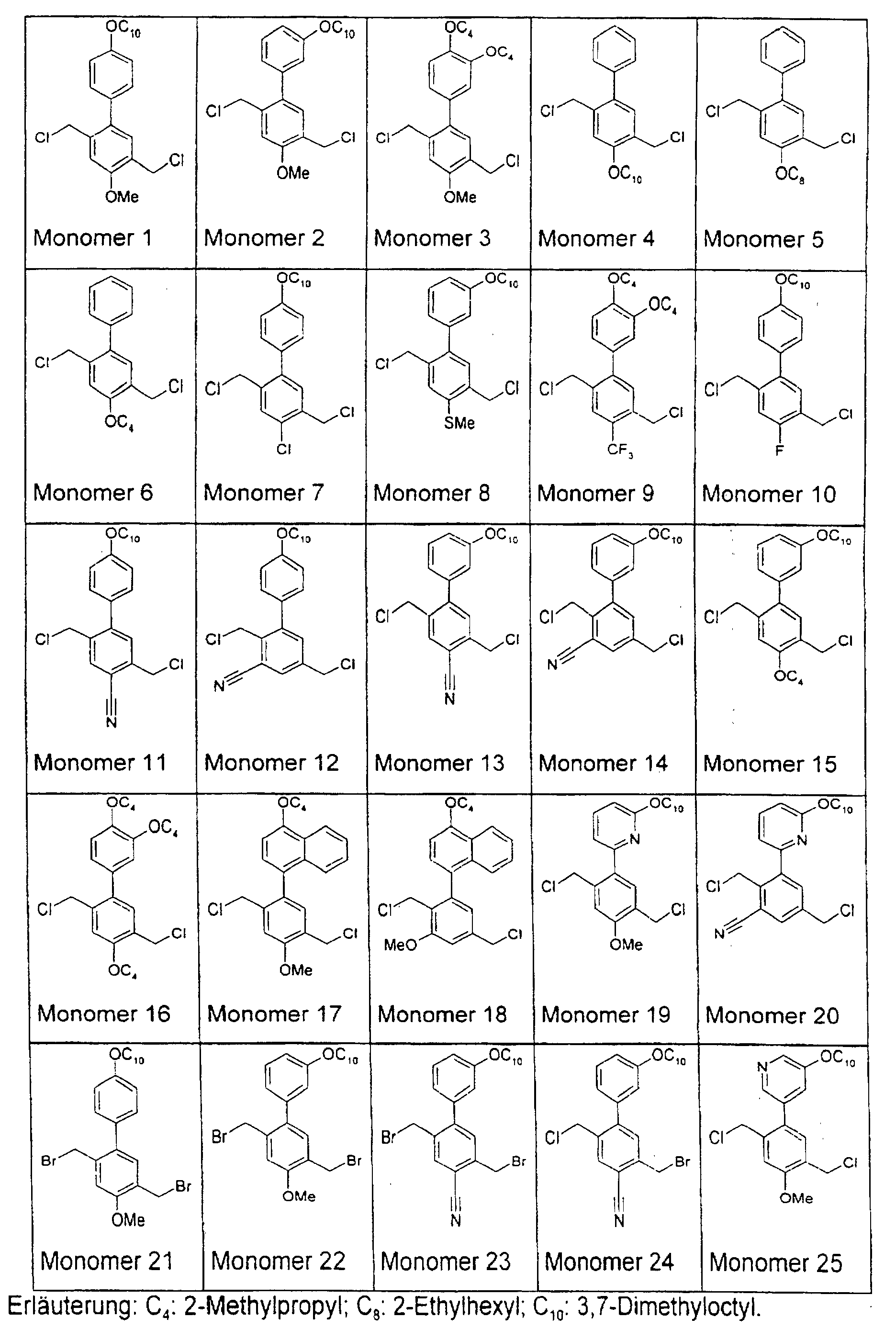

Aus den derartig zugänglichen Monomeren nach Formel (II) lassen sich nun durch die oben angegebene Polymerisationsvariante - eventuell unter Zusatz weiterer Comonomere - Polymere, welche Wiederholeinheiten der Formel (I) enthalten, synthetisieren. Derartige Comonomere sind beispielsweise die im folgenden aufgeführten Verbindungen.

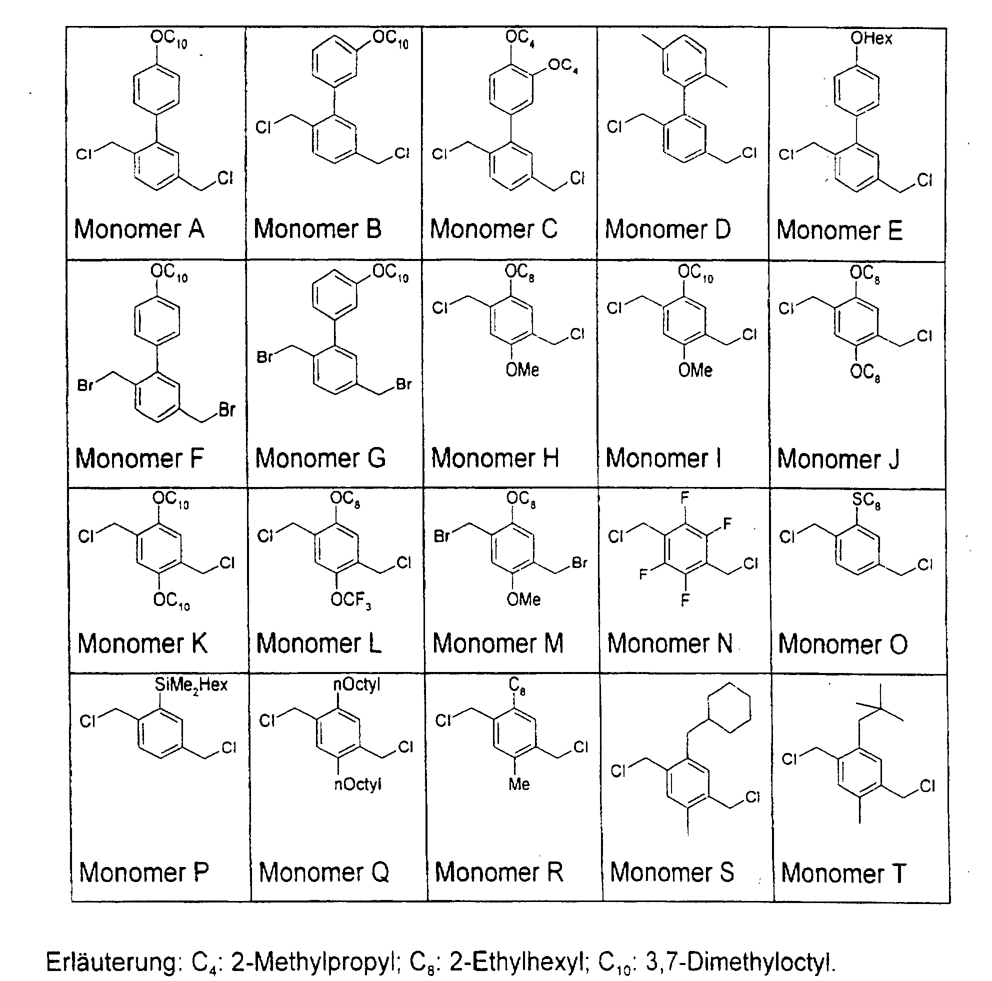

Die so erzeugten erfindungsgemäßen Homo- oder Copolymere eignen sich ganz besonders als Elektroluminszenzmaterialien.

Als Elektrolumineszenzmaterialien im Sinne der Erfindung gelten Materialien, die als aktive Schicht in einer Elektrolumineszenzvorrichtung Verwendung finden können. Aktive Schicht bedeutet, daß die Schicht befähigt ist, bei Anlegen eines elektrischen Feldes Licht abzustrahlen (lichtemittierende Schicht) und/oder daß sie die Injektion und/oder den Transport der positiven und/oder negativen Ladungen verbessert (Ladungsinjektions- oder Ladungstransportschicht).

Gegenstand der Erfindung ist daher auch die Verwendung eines Polymers, enthaltend mindestens 20 % Wiederholeinheiten der Formel (I), in einer Elektrolumineszenzvorrichtung, insbesondere als Elektrolumineszenzmaterial.

Um als Elektrolumineszenzmaterialien Verwendung zu finden, werden die Polymere, enthaltend Struktureinheiten der Formel (I), im allgemeinen nach bekannten, dem Fachmann geläufigen Methoden, wie Eintauchen (Dipping) oder Lackschleudern (Spincoating), in Form eines Films auf ein Substrat aufgebracht.

Gegenstand der Erfindung ist somit ebenfalls eine Elektrolumineszenzvorrichtung mit einer oder mehreren aktiven Schichten, wobei mindestens eine dieser aktiven Schichten ein oder mehrere erfindungsgemäße Polymere enthält. Die aktive Schicht kann beispielsweise eine lichtemittierende Schicht und/oder eine Transportschicht und/oder eine Ladungsinjektionsschicht sein.

Der allgemeine Aufbau solcher Elektrolumineszenzvorrichtungen ist beispielsweise in US 4,539,507 und US 5,151,629 beschrieben. Polymere enthaltende Elektrolumineszenzvorrichtungen sind beispielsweise in WO-A 90/13148 oder EP-A 0 443 861 beschrieben.

Sie enthalten üblicherweise eine elektrolumineszierende Schicht zwischen einer Kathode und einer Anode, wobei mindestens eine der Elektroden transparent ist. Zusätzlich können zwischen der elektrolumineszierenden Schicht und der Kathode eine oder mehrere Elektroneninjektions- und/oder Elektronentransportschichten eingebracht sein und/oder zwischen der elektrolumineszierenden Schicht und der Anode eine oder mehrere Lochinjektions- und/oder Lochtransportschichten eingebracht sein. Als Kathode können vorzugsweise Metalle oder metallische Legierungen, z.B. Ca, Mg, Al, In, Mg/Ag dienen. Als Anode können Metalle, z.B. Au, oder andere metallisch leitende Stoffe, wie Oxide, z.B. ITO (Indiumoxid/Zinnoxid) auf einem transparentem Substrat, z.B. aus Glas oder einem transparenten Polymer, dienen.

Im Betrieb wird die Kathode auf negatives Potential gegenüber der Anode gesetzt. Dabei werden Elektronen von der Kathode in die Elektroneninjektionsschicht-/Elektronentransportschicht bzw. direkt in die lichtemittierende Schicht injiziert. Gleichzeitig werden Löcher von der Anode in die Lochinjektionsschicht/ Lochtransportschicht bzw. direkt in die lichtemittierende Schicht injiziert.

Die injizierten Ladungsträger bewegen sich unter dem Einfluß der angelegten Spannung durch die aktiven Schichten aufeinander zu. Dies führt an der Grenzfläche zwischen Ladungstransportschicht und lichtemittierender Schicht bzw. innerhalb der lichtemittierenden Schicht zu Elektronen/Loch-Paaren, die unter Aussendung von Licht rekombinieren.
Die Farbe des emittierten Lichtes kann durch die als lichtemittierende Schicht verwendeten Materialien variiert werden.

Elektrolumineszenzvorrichtungen finden z.B. Anwendung als selbstleuchtende Anzeigeelemente, wie Kontrollampen, alphanumerische Displays, Hinweisschilder, und in optoelektronischen Kopplern.

Die Erfindung wird durch die nachfolgenden Beispiele näher erläutert, ohne sie dadurch einschränken zu wollen.

### Teil 1: Synthese der Monomere

### A. Synthese von Verbindungen der Formel (III)

### Beispiel A1: Synthese von 2-Brom-5-methoxyterephthalsäurediethylester:

### a) Synthese von 4-Brom-2,5-dimethylanisol

Zu einer vorgelegten Mischung aus 2,5-Dimethylanisol (250 g, 1835 mmol) und Fe-Pulver (3.25 g) wurde unter Rühren tropfenweise Brom (291.5 g, 1835 mmol) zugesetzt. Der Beginn der Reaktion war durch Gasentwicklung sichtbar. Danach tropfte man das restliche Brom bei Raumtemperatur unter Wasserbadkühlung innerhalb 30-40 Minuten zu. Die Reaktionsmischung wurde ca. 4 Stunden weitergerührt. Anschließend wurde vom Fe-Pulver abgetrennt, wenig Chloroform zugesetzt und mit Wasser ausgeschüttelt, was zu einer Aufhellung der Lösung führte. Nach Schütteln mit 50 ml gesättigter wäßriger Na₂SO₃-Lösung war die Lösung vollends entfärbt. Man schüttelte noch einmal mit verdünnter wäßriger NaOH und zweimal mit H₂O und zog nach Trocknung das Lösemittel ab.
Das Rohprodukt wurde im Vakuum fraktioniert destilliert.
Das Produkt erhielt man als viskoses, farbloses Öl (Siedepunkt 68°C, 0.8 mbar): 285 g (72%)
¹H NMR (CDCl₃): [ppm] = 7.25 (s, 1 H, H-Aryl), 6.68 (s, 1 H, H-Aryl), 3.78 (s, 3 H, O-Me), 2.36, 2.14 (jeweils s, 3 + 3 H, CH₃).

### b) Synthese von 2-Brom-5-methoxyterephthalsäure

In einem 1-I-Autoklav (HC-22) mit Scheibenrührer, Rückflußkühler, Gaseinleitung und Gasauslaß wurde eine Lösung von Kobaltacetattetrahydrat (1.25 g, 5 mmol), Manganacetat-tetrahydrat (1.23 g), HBr (0.81 g), Natriumacetat (1.37 g) und 4-Brom-2,5-dimethylanisol (107.5 g, 0.5 mol) in 380 g Eisessig vorgelegt.
Die Reaktionslösung wurde unter Stickstoffatmosphäre (17 bar) unter Rühren auf 150°C erhitzt. Bei dieser Temperatur wurde Luft (17 bar) durch die Lösung geleitet (180-200 l/h), worauf die exotherme Reaktion sofort ansprang. Die Reaktionstemperatur blieb durch Außenkühlung bei 150°C. Nach ca. 45 Minuten war die exotherme Reaktion beendet. Zur Ermöglichung einer Nachreaktion wurde bei 150°C für 30 min. ein Luft/Stickstoff-Gemisch (10% O₂) durchgeleitet. Danach wurde die Luftzufuhr abgebrochen und Stickstoff eingeleitet.
Der Reaktorinhalt wurde unter Stickstoffatmosphäre auf 100°C abgekühlt, als Lösung in einen Kolben abgelassen und unter Rühren auf 20°C abgekühlt, wobei das Produkt auskristallisierte. Der farblose Kristallbrei wurde abgesaugt und viermal mit jeweils 40 g Eisessig gewaschen.
Nach Trocknung erhielt man 96.2 g 2-Brom-5-methoxyterephthalsäure (70%).
¹H NMR (DMSO): [ppm] = 13.5 (br, 2 H, COOH), 7.87 (s, 1 H, H-Aryl), 7.42 (s, 1 H, H-Aryl), 3.88 (s, 3 H, O-Me).

### c) Synthese von 2-Brom-5-methoxyterephthalsäurediethylester

2-Brom-5-methoxyterephthalsäure (202.89 g, 738 mmol) wurde mit 500 ml EtOH unter Schutzgas vorgelegt und dann bei RT unter Rühren mit H₂SO₄ versetzt. Anschließend kochte man bei 78°C Innentemperatur am Rückfluß und destillierte EtOH ab, bis die Innentemperatur über 100 °C lag. Es wurde zunächst erneut Ethanol zugeführt, dieses dann wieder abdestilliert. Der Vorgang wurde solange wiederholt, bis laut DC nur noch der Diester vorhanden war. Schließlich wurde alles Ethanol abgezogen, das erhaltene Rohprodukt in Ethylacetat aufgenommen, mit wäßriger NaHCO₃-Lösung extrahiert und schließlich nach Phasentrennung und Trocknung erneut alles Lösungsmittel abgezogen. Der dabei erhaltene erstarrte Feststoff konnte, nach Zerkleinern, durch Rühren mit Hexan gereinigt werden.
Man erhielt 190.4 g (78%) hellgelbe Kristalle.
Schmelzpunkt: 61-63 °C
¹H NMR (CDCl₃): [ppm] = 8.00 (s, 1 H, H-Aryl), 7.34 (s, 1 H, H-Aryl), 4.43 + 4.37 (jeweils q, 2 + 2 H, OCH₂, J = 7.5 Hz), 3.92 (s, 3 H, O-Me), 1.42 + 1.38 (jeweils t, 3 + 3 H, CH₃, J = 7.5 Hz).

### Beispiel A2: Synthese von 2-Brom-5-fluorterephthalsäurediethylester:

### a) Synthese von 2-Brom-5-nitro-p-xylol

740 g Brom-p-xylol wurden in Essigsäureanhydrid vorgelegt (Eisbadkühlung) und Nitriersäure (dargestellt aus 400 ml rauchender Salpetersäure und 480 ml konzentrierter Schwefelsäure) langsam zugetropft. Dabei wurde darauf geachtet, daß die Innentemperatur zwischen 22°C - 25°C blieb. Nach Beendigung der Zugabe (Dauer ca. 5h) wurde das Eisbad entfernt und noch ca. 1 h bei RT nachgerührt.
Der gesamte Ansatz wurde unter kräftigem Rühren auf 4 I Eis gegossen; es separierte sich dabei ein viskoses Öl. Die wässrige Phase wurde abdekantiert, das Öl erneut mit Wasser versetzt und gerührt. Dieser Vorgang (Abdekantieren und Reinigung) wurde dreimal wiederholt. Schließlich wurde Methanol zugegeben; man erhielt einen kristallinen Feststoff, der abgesaugt wurde. Dieser wurde nochmals aus wenig Methanol umkristallisiert.
Man erhielt schließlich 230 g (30%) orange-gelbe Kristalle.
Schmelzpunkt: 62-65°C
¹H NMR (CDCl₃): [ppm] = 7.88 (s, 1 H, H-Aryl), 7.53 (s, 1 H, H-Aryl), 2.55, 2.44 (jeweils s, 3 + 3 H, CH₃).

### b) Synthese von 2-Amino-5-brom-p-xylol

316 g 2-Brom-5-nitro-p-xylol wurden in 3000 ml Methanol gelöst und unter starkem N₂-Strom mit frisch erzeugten Raney-Nickel (ca. 4 g) versetzt und unter kräftigem Rühren auf Rückfluß erhitzt. Dann wurden 275 ml Hydrazinhydrat (80%ig in Wasser) langsam zugetropft. Nach Beendigung des Zutropfens (Dauer ca. 5 h) wurde noch ca. 6 h weiterrefluxiert. Es wurde vom Katalysator abfiltriert, das Methanol abrotiert, der Rückstand in Ethylacetat aufgenommen, mit Wasser ausgeschüttelt, getrocknet und erneut einrotiert. Das somit erhaltene Rohprodukt wurde aus Heptan umkristallisiert.
Man erhielt 238 g (87%) blaßgrüne Kristalle.
Schmelzpunkt: 92-93°C
¹H NMR (CDCl₃): [ppm] = 7.18 (s, 1 H, H-Aryl), 6.56 (s, 1 H, H-Aryl), 3,6 (s (br), 2 H, NH₂), 2.27, 2.09 (jeweils s, 3 + 3 H, CH₃).

### c) Synthese von 2-Brom-5-fluor-p-xylol

In einem 4 I Vierhalskolben wurden 373 g 2-Amino-5-brom-p-xylol in 1860 ml H₂O suspendiert, auf 3°C (Innentemperatur) gekühlt und mit 612 ml Tetrafluoroborsäure versetzt. Dann wurden 154 g NaNO₂ in 300 ml Wasser innerhalb von 60 min zugetropft. Nach 60 Minuten wurde abgesaugt, mit wenig kalter 5% Tetrafluoroborsäure, dann mit wenig kaltem Methanol und schließlich wenig kaltem Diethylether gewaschen. Der gelbe Feststoff (497 g = 90 %) wurde über Nacht im Ölpumpenvakuum getrocknet.
Der Ansatz wurde dann halbiert und jeweils in ca. 500 ml Toluol suspendiert. Es wurde mit dem Heißluftfön erhitzt; dabei wurde nach Eintreten der starken Gasentwicklung jeweils das Heizen beendet, bis diese wieder nachließ. Schließlich wurde noch refluxiert, bis Gasentwicklung vollständig beendet war. Das Toluol wurde abrotieren und das Produkt durch Vakuumdestillation gereinigt (0.1 mbar, 54-57°C).
Man erhielt (gesamt) 232 g (61 %) farbloses Öl.
¹H NMR (CDCl₃): [ppm] = 7.32 (d, 1 H, H-Aryl, J_{H-F} = 7 Hz), 6.88 (d, 1 H, H-Aryl, J_{H-F} = 10 Hz), 2.33 (s, 3 H, CH₃), 2.21 (d, 3 H, CH₃, J_{H-F} = 2 Hz).

### d) Synthese von 2-Brom-5-fluorterephthalsäure

Die Reaktion wurde analog Beispiel A1 (b) durchgeführt
Nach Trocknung erhielt man 88% 2-Brom-5-fluorterephthalsäure.
¹H NMR (DMSO-d₆): [ppm] = 13.8 (br, 2 H, COOH), 8.07 (d, 1 H, H-Aryl, J_{H-F} = 7 Hz), 7.68 (d, 1 H, H-Aryl, J_{H-F} = 10.5 Hz).

### e) Synthese von 2-Brom-5-fluorterephthalsäurediethylester

Die Reaktion wurde analog Beispiel A1 (c) durchgeführt. Die Reinigung geschah durch Ausrühren mit Hexan
Nach Trocknung erhielt man 99% 2-Brom-5-fluorterephthalsäurediethylester als fast weißes Pulver.
Schmelzpunkt: 30°C
¹H NMR (CDCl₃): [ppm] = 8.19 (d, 1 H, H-Aryl, J_{H-F} = 6.5 Hz), 7.56 (d, 1 H, H-Aryl, J_{H-F} = 10.5 Hz), 4.43 + 4.42 (jeweils q, 2 + 2 H, OCH₂, J = 7.5 Hz), 1.42 + 1.41 (jeweils t, 3 + 3 H, CH₃, J = 7.5 Hz).

### Beispiel A3: Synthese von 2-Brom-5-chlorterephthalsäurediethylester:

### a) Synthese von 2-Brom-5-chlor-p-xylol

Chlor-p-xylol wurde analog Beispiel A1 (a) bromiert. Nach Umkristallisation aus Methanol erhielt man 72% 2-Brom-5-chlor-p-xylol als weißes Pulver.
Schmelzpunkt: 66-67°C
¹H NMR (CDCl₃): [ppm] = 7.38 (s, 1 H, H-Aryl), 7.19 (s, 1 H, H-Aryl), 2.32, 2.30 (jeweils s, 3 + 3 H, CH₃).

### b) Synthese von 2-Brom-5-chlorterephthalsäure

Die Reaktion wurde analog Beispiel A1 (b) durchgeführt.
Nach Trocknung erhielt man 87% 2-Brom-5-chlorterephthalsäure.
¹H NMR (DMSO-d₆): [ppm] = 13.9 (br, 2 H, COOH), 8.07 (s, 1 H, H-Aryl,), 7.88 (s, 1 H, H-Aryl).

### c) Synthese von 2-Brom-5-chlorterephthalsäurediethylester

Die Reaktion wurde analog Beispiel A1 (c) durchgeführt. Die Reinigung geschah durch Ausrühren mit Hexan.
Nach Trocknung erhielt man 98% 2-Brom-5-chlorterephthalsäurediethylester als fast weißes Pulver.
Schmelzpunkt: 125°C
¹H NMR (CDCl₃): [ppm] = 8.08 (s, 1 H, H-Aryl), 7.84 (s, 1 H, H-Aryl), 4.43 + 4.41 (jeweils q, 2 + 2 H, OCH₂, J = 7.5 Hz), 1.42 + 1.38 (jeweils t, 3 + 3 H, CH₃, J = 7.5 Hz).

### B. Synthese von Verbindungen der Formel (IV)

### Beispiel B1: Synthese von 3-(3,7-Dimethyloctyloxy)benzolboronsäure:

### a) Synthese von 3-(3,7-Dimethyloctyloxy)brombenzol:

450 ml Ethanol wurden vorgelegt und mit Nal (10.5 g; 70 mmol) und KOH (67.3 g; 1,2 mol) versetzt. Man beobachtete einen Temperaturanstieg nach KOH-Zugabe von 25 auf 40 °C. Nach Abkühlen auf Raumtemperatur wurde 3-Bromphenol (176.5 g; 1 mol) zugegeben. Die weiße Suspension wurde dabei beige. 3,7-Dimethyloctylchlorid (186.32 g; 212.94 ml; 1,05 mol) wurde über einen Tropftrichter innerhalb 3 min. zugegeben. Es wurde 2 Stunden bei RT nachgerührt. und anschließend für 96 Stunden bei 80°C Innentemperatur gerührt. Ethanol wurde abdestilliert. Der Rückstand wurde in Ethylacetat aufgenommen und der Niederschlag wurde durch Filtration separiert. Die organische Phase wurde mit 10 gew.-%iger wäßriger NaOH-Lösung dreimal extrahiert, einmal mit H₂O gewaschen, dreimal mit H₂O, das mit CO₂ angesäuert wurde, und nochmals mit H₂O gewaschen. Nach Trocknung mit MgSO₄ wurde erneut am Rotationsverdampfer das Lösungsmittel abgezogen und das Rohprodukt durch fraktionierte Vakuumdestillation gereinigt.
Produkt: hochsiedendes farbloses Öl; 180°C bei 2-3 mbar; 262,3 g (84%)
¹H NMR (400 MHz; CDCl₃): [ppm] = 7.12 (pseudo-t; 1 H; J = 8 Hz; H-5), 7.05 (m; 2 H; H-2, H-6), 6.81 (ddd; 1 H; J₁ = 8, J₂ = 2, J₃ = 0.7 Hz; H-4), 3.97 (m; 2 H; O-CH₂), 1.81 (m; 1 H; O-CH₂-CH₂-CH), 1.70-1.50 (m; 3 H; H-alkyl), 1.35-1.13 (m; 6 H; H-alkyl), 0.93 (d; 3 H; J = 7.7 Hz; CH₃), 0.87 (d; 6 H; J = 7.7 Hz; CH₃).

### b) Synthese von 3-(3,7-Dimethyloctyloxy)benzolboronsäure:

Mg-Späne (24.7 g, 1.02 mol) wurden vorgelegt und die Apparatur unter Argon ausgeheizt. Bei Raumtemperatur wurden ca. 100 ml THF über den Tropftricher eingefüllt, sowie einige Kristalle Iod zugegeben. Anschließend tropfte man in die ruhende Lösung einige ml 3-(3,7-Dimethyloctyloxy)-brombenzol und erhitzte mit einem Heißluftgebläse an der Eintropfstelle. Nachdem die Reaktion gestartet war, ließ man unter Rühren das restliche 3-(3,7-Dimethyloctyloxy)-brombenzol (gesamt: 313 g, 1 mol, 280 ml) kontinuierlich zutropfen (70 min). Gleichzeitig wurden weitere 1100 ml THF zugegeben. Der Reaktionsansatz wurde für weitere zwei Stunden am Rückfluß gerührt.
Das erhaltene, auf Raumtemperatur abgekühlte Grignard-Reagenz wurde unter Schutzgas und schnellem Rühren so zu einer auf -70°C gekühlten Mischung aus 800 ml THF sowie 123 ml Trimethylborat (114 g, 1.10 mol) getropft, daß die Innentemperatur -60°C nicht überschritt (Dauer: 3 h). Es bildete sich eine helle Suspension.
Die Reakionsmischung wurde in 1200 g Eiswasser/40 ml konz. H₂SO₄ eingerührt. Die klaren Phasen wurden getrennt und die Wasserphase mit Ethylacetat ausgeschüttelt. Die vereinigten organischen Phasen wurden mit Wasser gerührt und nach Trocknen eingeengt.
Zur weiteren Reinigung wurde der so erhaltene farblose Feststoff mit ca. 500 ml Hexan (welches mit 2 ml konz. wäßriger HCl versetzt wurden) gerührt.
Man erhielt 239 g (86%) farbloses Kristallpulver.
Schmelzpunkt: 83-89°C.
¹H NMR (400 MHz; CDCl₃): [ppm] = 7.81 (td; 1 H; J₁ = 8, J₂ = 1.3 Hz; H-4), 7.73 (dd; 1 H; J, = 2, J₂ = 1.1 Hz; H-2), 7.43 (t; 1 H; J = 8 Hz; H-5), 7.13 (ddd; 1 H; J, = 8, J₂ = 2, J₃ = 1.1 Hz; H-6), 4.11 (m; 2 H; O-CH₂), 1.90 (m; 1 H; O-CH₂-CH₂-C*H*), 1.75-1.50 (m; 3 H; H-alkyl), 1.44-1.14 (m; 6 H; H-alkyl), 1.00 (d; 3 H; J = 7.9 Hz; CH₃), 0.88 (d; 6 H; J = 7.8 Hz; CH₃). Enthält variable Anteile an Anhydriden.

### Beispiel B2: Synthese von 4-(3,7-Dimethyloctyloxy)benzolboronsäure:

### a) Synthese von 4-(3,7-Dimethyloctyloxy)-brombenzol

Durchführung analog zu Beispiel B1, a).
Ausbeute: 85%
Siedepunkt: 180°C bei 2 mbar
¹H NMR (CDCl₃): [ppm] = 7.36, 6.77 (AA'BB', 4 H, H-Aryl), 3.95 (m, 2 H, O-CH₂), 1.82 (m, 1 H, H-3'), 1.6 (m, 3 H, H-2', H-7'), 1.24 (m, 6 H, H-4', H-5', H-6'), 0.94 (d, 3 H, Me, J = 7 Hz), 0.87 (d, 6 H, Me, J = 7 Hz).

### b) Synthese von 4-(3,7-Dimethyloctyloxy)benzolboronsäure

Durchführung analog zu Beispiel B1, b).
Ausbeute: 83%
Schmelzpunkt: 57-63°C.
¹H NMR (CDCl₃): [ppm] = 7.67, 6.92 (AA'BB', 4 H, H-Aryl), 4.6 (br, 2 H, B(OH)₂), 4.03 (m, 2 H, O-CH₂), 1.87 (m, 1 H, H-3'), 1.65 (m, 3 H, H-2', H-7'), 1.27 (m, 6 H, H-4', H-5', H-6'), 0.95 (d, 3 H, Me, J = 7 Hz), 0.87 (d, 6 H, Me, J = 7 Hz). Enthält variable Anteile von Anhydriden.

### Beispiel B3: Synthese von 3,4-Bis(-2-methylpropyloxy)benzolboronsäure

### a) Synthese von 1,2-Bis(-2-methylpropyloxy)benzol:

Brenzkatechin (220.22 g, 2 mol) und Nal (10.49 g, 0.14 mol) wurden in 900 ml Ethanol vorgelegt und zum Rückfluß erhitzt. Anschließend wurden in ca. 300 ml Ethanol gelöstes KOH (56.11 g, 1 mol) und gleichzeitig 1-Brom-2-methylpropan (137.03 g, 1 mol, 108.75 ml) langsam zugetropft. Es wurde über Nacht weiter am Rückfluß gekocht. Am nächsten Tag wurden erneut dieselbe Menge KOH und Alkylbromid zugegeben. Insgesamt wurde dieser Vorgang siebenmal wiederholt. Nach Abkühlen der Reaktionsmischung wurde vom Feststoff abdekantiert. Der Filterkuchen wurde mit Ethanol nachgewaschen. Die organische Phase wurde eingeengt. Der Filterkuchen wurde in 1I warmen Wasser aufgelöst und mit der mit Ethylacetat verdünnten organischen Phase versetzt. Nach Phasentrennung wurde wiederholt mit 10 %iger wäßriger NaOH gerührt, mit Wasser ausgewaschen und über Na₂SO₄ getrocknet. Das nach Abziehen des Lösungsmittels erhaltene Rohprodukt wurde im Vakuum fraktioniert destilliert.
Man erhielt das Produkt als farbloses Öl (Siedepunkt: 82°C bei 0.18 mbar): 333.4 g (75%).
¹H NMR (CDCl₃): [ppm] = 6.87 (ps-s, 4 H, H-Aryl), 3.75 (d, 4 H, O-CH₂, J = 8 Hz), 2.13 (ps-non, 2 H, C-H, J = 8 Hz), 1.05 (d, 12 H, CH₃, J = 8 Hz).

### b) Synthese von 3,4-Bis(2-methylpropyloxy)brombenzol:

1,2-Bis(-2-methylpropyloxy)benzol (359.61 g, 1.62 mol) wurde mit 500 ml CH₂Cl₂ vorgelegt und mit wenig Eisenpulver versetzt. Nun tropfte man unter Kühlung langsam Brom (266.88 g, 1.78 mol) (vermischt mit ca. 200 ml CH₂Cl₂) zu. Der Ansatz wurde für ca. 20 h bei Raumtemperatur gerührt. Zur Aufarbeitung wurde der Ansatz mit wäßriger Na₂SO₃ Lösung ausgerührt und anschließend das Eisenpulver abfiltriert. Die organische Phase wurde dann noch 2x mit NaHCO₃ Lösung ausgeschüttelt und anschließend mit Wasser neutral gewaschen. Nach Trocknung wurde die organische Phase eingeengt.
Durch doppelte fraktionierte Destillation erhielt man das gewünschte Produkt als farblosen Feststoff (166.9 g, 34%).
Schmelzpunkt: 47°C
¹H NMR (CDCl₃): [ppm] = 6.98 (m, 2 H, H-2, H-6), 6.73 (m, 1 H, H-5), 3.72, 3.70 (2 x d, 2 x 2 H, O-CH₂, J = 8 Hz), 2.12 (m, 2 H, CH), 1.04 (m, 12 H, CH₃).

### c) Synthese von 3,4-Bis(2-methylpropyloxy)benzolboronsäure:

Durchführung analog zu Beispiel B1, b).
Ausbeute: 76%
Schmelzpunkt: 146°C.
¹H NMR (CDCl₃): [ppm] = 7.81 (dd, 1 H, H-6, J₁ = 8 Hz, J₂ = 1.8 Hz), 7.68 (d, 1 H, H-2, J = 1.8 Hz), 6.99 (d, 1 H, H-5, J = 8 Hz), 3.89, 3.84 (2 x d, 2 x 2 H, O-CH₂, J = 8 Hz), 2.13 (m, 2 H, CH), 1.07 (m, 12 H, CH₃). Enthält variable Anteile von Anhydriden.

### Beispiel B4: Synthese von 2,5-Dimethoxybenzolboronsäure:

Die Synthese erfolgte analog Beispiel B1 (b) (2,5-Dimethoxybrombenzol: AVOCADO). Das Produkt wurde als weißes Pulver in 90% Ausbeute erhalten.
¹H NMR (CDCl₃): [ppm] = 7.38 (d, 1 H, H-6, J = 2 Hz), 6.98 (dd, 1 H, H-4, J = 2 Hz, J = 8 Hz), 6.86 (d, 1 H, H-3, J = 8 Hz), 6.10 (s, 2 H, OH), 3.88 + 3.81 (jeweils s, 3 + 3 H, OCH₃).

### Beispiel B5: Synthese von 2,5-Dimethylbenzolboronsäure:

Die Synthese ist in WO98/25874 als Beispiel B3 beschrieben.

### Beispiel B6: Synthese von 4-Fluorbenzolboronsäure:

Die Synthese erfolgte analog Beispiel B1 (b) (4-Fluorbrombenzol: Aldrich). Das Produkt wurde weißes Pulver in 86% Ausbeute erhalten. (Enthält ca. 25% Anhydrid) ¹H NMR (DMSO-d₆): [ppm] = 7.90 (dd, 2 H, H-3,H-5, J = 6 Hz, J = 8.2 Hz), 7.84 (dd, 0.5 H, H-3,H-5 Anhydrid , J = 6 Hz, J = 8.2 Hz); 7.18 (ps. t, 2 H, H-2, H-6, J = 8.4 Hz); ); 7.14(ps. t, 0.5 H, H-2, H-6-Anhydrid; J = 8.4 Hz).

### Beispiel B7: Synthese von 3,5-Difluorbenzolboronsäure:

Die Synthese erfolgte analog Beispiel B1 (b) (3,5-Difluorbrombenzol; Aldrich). Das Produkt wurde weißes Pulver in 68% Ausbeute erhalten. (Enthält ca. 10% Anhydrid) ¹H NMR (DMSO-d₆): [ppm] = 7.46 (d mit Fs., 2 H, H-2,H-6, J = 6 Hz), 7.40 (d mit Fs, 0.2 H, H-2, H-6 Anhydrid , J = 6 Hz); 7.21 (ps. t mit Fs, 1 H, H-4, J = 9.2 Hz).

### C. Kupplungsreaktionen gemäß Reaktion A

### Beispiel C1: Synthese von 2-[4-(3,7-Dimethyloctyloxy)phenyl]-5-methoxyterephthalsäurediethylester

2-Brom-5-methoxyterephthalsäurediethylester (49.67g, 150 mmol), K₂CO₃ (44.23g, 320 mmol), 140 ml Toluol und 140 ml H₂O wurden vorgelegt und 30 Minuten mit Argon gespült. Anschließend wurde 4-(3,7-Dimethyloctyloxy)boronsäure (44.51 g, 160 mmol), sowie Pd(PPh₃)₄ (0.7 g, 0,6 mmol) unter Schutzgas zugegeben. Das bräunliche, durch Phasentrennung trübe Gemisch wurde unter Schutzgasüberlagerung bei 85° C Innentemperatur kräftig gerührt. Die Reaktion war nach 24 Stunden (laut DC) beendet. Palladiumreste wurden noch durch Ausrühren mit mit 1%iger wäßriger NaCN-Lösung beseitigt. Nach Phasentrennung wurde die org. Phase zunächst mit Wasser, anschließend mit verdünnter HCl/H₂O ausgeschüttelt (neutral) und anschließend bis zur Trockene einrotiert. Das Produkt (95% Ausbeute) war ein farbloses hochviskoses Öl (Reinheit >97%).
¹H NMR (CDCl₃): [ppm] = 7.75, 7.35 (2 x s, 2 x 1 H, H-3, H-6), 7.20, 6.91 (AA'BB', 4 H, H-Aryl), 4.37, 4.12 (2 x q, 2 x 2 H, CO₂CH₂, J = 7.6 Hz), 4.02 (m, 2 H, O-CH₂), 3.97 (s, 3 H, O-Me), 1.84 (m, 1 H, H-3"), 1.62 (m, 3 H, H-2", H-7"), 1.37, 1.03 (2 x t, 2 x 3H, Ester-CH₃, J = 7.6 Hz), 1.28 (m, 6 H, H-4", H-5", H-6"), 0.96 (d, 3 H, Me, J = 7.5 Hz), 0.87 (d, 6 H, Me, J = 7.5 Hz).

### Beispiel C2: Synthese von 2-[3-(3,7-Dimethyloctyloxy)phenyl]-5-methoxyterephthalsäurediethylester

Synthese analog Beispiel C1. Das Produkt (95% Ausbeute) war ein farbloses hochviskoses Öl.
¹H NMR (CDCl₃): [ppm] = 7.78, 7.37 (2 x s, 2 x 1 H, H-3, H-6), 7.26 (t; 1 H; H-5', J = 8 Hz), 6.86 (m; 3 H; H-2', H-4', H-6'), 4.37, 4.10 (2 x q, 2 x 2 H, CO₂CH₂, J = 7.6 Hz), 4.00 (m, 2 H, O-CH₂), 3.97 (s, 3 H, O-Me), 1.83 (m, 1 H, H-3"), 1.62 (m, 3 H, H-2", H-7"), 1.37, 1.01 (2 x t, 2 x 3H, Ester-CH₃, J = 7.6 Hz), 1.28 (m, 6 H, H-4", H-5", H-6"), 0.95 (d, 3 H, Me, J = 7.5 Hz), 0.86 (d, 6 H, Me, J = 7.5 Hz).

### Beispiel C3: Synthese von 2-[3,4-Bis-(2-methylpropyl)phenyl]-5-methoxyterephthalsäurediethylester

Durchführung analog Beispiel C1. Man erhielt das Produkt als zähes Öl in 100% Ausbeute.
¹H NMR (CDCl₃): [ppm] = 7.75, 7.32 (2 x s, 2 x 1 H, H-3, H-6), 6.88 (d, 1 H, H-2, J = 2 Hz), 6.80 (m, 2 H, H-5 + H-6), 4.37, 4.12 (2 x q, 2 x 2 H, CO₂CH₂, J = 7.5 Hz), 3.96 (s, 3 H, O-Me), 3.78, 3.74 (2 x d, 2 x 2 H, O-CH₂, J = 8 Hz), 2.14 (m, 2 H, CH), 1.36, 1.02 (2 x t, 2 x 3H, Ester-CH₃, J = 7.5 Hz), 1.04 (m, 12 H, CH₃).

### Beispiel C4: Synthese von 2-[2,5-Dimethoxyphenyl]-5-methoxyterephthalsäurediethylester

Durchführung analog Beispiel C1. Man erhielt das Produkt als kristallinen Feststoff nach Ausrühren in Hexan in 72% Ausbeute.
¹H NMR (CDCl₃): [ppm] = 7.73, 7.46 (2 x s, 2 x 1 H, H-3, H-6), 6.82 (m, 3 H, H-3 + H-4 + H-6), 4.36, 4.11 (2 x q, 2 x 2 H, CO₂CH₂, J = 7.5 Hz), 3.96, 3.81, 3.75 (3 x s, 3 x 3 H, 3 x O-Me), 1.36, 1.03 (2 x t, 2 x 3H, Ester-CH₃, J = 7.5 Hz).

### Beispiel C5: Synthese von 2-[2,5-Dimethylphenyl]-5-methoxyterephthalsäurediethylester

Durchführung analog Beispiel C1. Man erhielt das Produkt als zähes Öl in 99% Ausbeute.
¹H NMR (CDCl₃): [ppm] = 7.63, 7.50 (2 x s, 2 x 1 H, H-3, H-6), 7.10 (d, 1 H; H-3, J = 8 Hz), 7.06 (dd, 1 H, H-4, J = 1.3 Hz, J = 8 Hz), 6.89 (s (br), 1 H, H-6), 4.35, 4.05 (2 x q, 2 x 2 H, CO₂CH₂, J = 7.5 Hz), 3.99 (s, 3 H, O-Me), 2.32, 2.02 (2 x s, 2 x 3 H, CH₃), 1.35, 0.92 (2 x t, 2 x 3H, Ester-CH₃, J = 7.5 Hz).

### Beispiel C6: Synthese von 2-[3-(3,7-Dimethyloctyloxy)phenyl]-5-fluorterephthalsäurediethylester

Durchführung analog Beispiel C1. Man erhielt das Produkt als zähes Öl in 98% Ausbeute.
¹H NMR (CDCl₃): [ppm] = 7.93 (d, 1 H, H-6, J_{H-F} = 7 Hz), 7.55 (d, 1 H, H-3, J_{H-F} = 11 Hz), 7.26 (t (br); 1 H; H-5', J = 8 Hz), 6.87 (m; 3 H; H-2', H-4', H-6'), 4.42, 4.13 (2 x q, 2 x 2 H, CO₂CH₂, J = 7.8 Hz), 3.99 (m, 2 H, O-CH₂), 1.83 (m, 1 H, H-3"), 1.60 (m, 3 H, H-2", H-7"), 1.40, 1.05 (2 x t, 2 x 3H, Ester-CH₃, J = 7.8 Hz), 1.25 (m, 6 H, H-4", H-5", H-6"), 0.94 (d, 3 H, Me, J = 7.5 Hz), 0.87 (d, 6 H, Me, J = 7.5 Hz).

### Beispiel C7: Synthese von 2-[3,4-Bis-(2-methylpropyl)phenyl]-5-fluorterephthalsäurediethylester

Durchführung analog Beispiel C1. Man erhielt das Produkt als zähes Öl in 100% Ausbeute.
¹H NMR (CDCl₃): [ppm] = 7.91 (d, 1 H, H-6, J_{H-F} = 7 Hz), 7.50 (d, 1 H, H-3, J_{H-F} = 11 Hz), 6.89 (d; 1 H; H-5', J = 8 Hz), 6.80 (m; 2 H; H-2', H-6'), 4.42, 4.14 (2 x q, 2 x 2 H, CO₂CH₂, J = 7.6 Hz), 3.78, 3.75 (2 x d, 2 x 2 H, O-CH₂, J = 8 Hz), 2.14 (m, 2H, CH), 1.40, 1.07 (2 x t, 2 x 3H, Ester-CH₃, J = 7.5 Hz), 1.05 (m, 12 H, CH₃).

### Beispiel C8: Synthese von 2-[4-(3,7-Dimethyloctyloxy)phenyl]-5-chlorterephthalsäurediethylester

Durchführung analog Beispiel C1. Man erhielt das Produkt als Öl in 93% Ausbeute.
¹H NMR (CDCl₃): [ppm] = 7.83, 7.78 (2 x s, 2 x 1 H, H-3, H-6), 7.22, 6.92 (AA'BB', 4 H, H-Aryl), 4.41, 4.25 (2 x q, 2 x 2 H, CO₂CH₂, J = 7.6 Hz), 4.03 (m, 2 H, O-CH₂), 1.83 (m, 1 H, H-3"), 1.60 (m, 3 H, H-2", H-7"), 1.41, 1.07 (2 x t, 2 x 3H, Ester-CH₃, J = 7.6 Hz), 1.30 (m, 6 H, H-4", H-5", H-6"), 0.96 (d, 3 H, Me, J = 7.5 Hz), 0.87 (d, 6 H, Me, J = 7.5 Hz).

### Beispiel C9: Synthese von 2-Chlor-5-phenylterephthalsäurediethylester

Durchführung analog Beispiel C1. Man erhielt das Produkt als Öl nach Vakuumdestillation (0.1 mbar, 170°C) in 80% Ausbeute.
¹H NMR (CDCl₃): [ppm] = 7.83, 7.80 (2 x s, 2 x 1 H, H-3, H-6), 7.35 (m (AA'BB'C), 5 H, H-Phenyl), 4.42, 4.11 (2 x q, 2 x 2 H, CO₂CH₂, J = 7.5 Hz), 1.40, 1.02 (2 x t, 2 x 3H, Ester-CH₃, J = 7.6 Hz).

### Beispiel C10: 2-[3,5-Difluorphenyl]-5-methoxyterephthalsäurediethylester

Die Durchführung erfolgte analog Beispiel C1. Man erhielt das Produkt als farblosen Feststoff nach Kristallisation aus Hexan 62% Ausbeute.
¹H NMR (CDCl₃): [ppm] = 7.99, 7.89 (2 x s, 2 x 1 H, H-3, H-6), 6.88-6.83 (m, 3 H, H-Phenyl), 4.44, 4.17 (2 x q, 2 x 2 H, CO₂CH₂, J = 7.0 Hz), 3.97 (s, 3H, O-CH₃), 1.41, 1.10 (2 x t, 2 x 3H, Ester-CH₃, J = 7.0 Hz).

### D. Reduktionen gemäß Reaktion B

### Beispiel D1: Synthese von 2,5-Bishydroxymethyl-4-methoxy-4'-(3,7-dimethyloctyloxy)biphenyl

LiAlH₄ (7.9 g, 208 mmol) wurde unter Argonüberlagerung mit ca. 250 ml THF vorgelegt. 2-[4-(3,7-Dimethyloctyloxy)phenyl]-5-methoxyterephthalsäurediethylester (72.2 g, 149 mmol) wurde im Tropftrichter mit etwa 60 ml THF verdünnt und langsam zugetropft. Dabei wurde die Reaktionsmischung kräftig gerührt. Der mit nochmals 100 ml THF verdünnte Ansatz wurde dann bei 67°C am Rückfluß gekocht. Nach 2 h wurde auf RT abgekühlt. Zur Aufarbeitung gab man nach beendeter Reduktion vorsichtig 8 ml Wasser zu. Anschließend wurden 8 ml wäßriger NaOH-Lösung (15%ig) und schließlich 24 ml Wasser zugegeben. Nach jeder Zugabe wurde für ca. 15 Minuten nachgerührt ("1:1:3 Methode"). Von dem entstandenen Feststoff wurde abgesaugt, dieser erneut mit THF ausgerührt und schließlich die vereinigten organischen Phasen eingeengt. Umkristallisation aus Hexan/Ethylacetat (20:1). Man erhielt das Produkt (93% Ausbeute) als farblose Kristalle. Schmelzpunkt: 101°C
¹H NMR (CDCl₃): [ppm] = 7.21, 6.93 (AA'BB', 4 H, H-Aryl), 7.18, 7.10 (2 x s, 2 x 1 H, H-3, H-6), 4.70, 4.62 (2 x s, 2 x 2 H, CH₂O), 4.02 (m, 2 H, O-CH₂), 3.93 (s, 3 H, O-Me), 1.85 (m, 1 H, H-3'), 1.65 (br, 2 H, OH), 1.60 (m, 3 H, H-2', H-7'), 1.28 (m, 6 H, H-4', H-5', H-6'), 0.96 (d, 3 H, Me, J = 7.5 Hz), 0.86 (d, 6 H, Me, J = 7.5 Hz).

### Beispiel D2: Synthese von 2,5-Bishydroxymethyl-4-methoxy-3'-(3,7-dimethyloctyloxy)biphenyl

Synthese analog Beispiel D1. Ausrühren mit heißem Hexan. Man erhielt das Produkt (99% Ausbeute) als farblosen, wachsartigen Feststoff.
Schmelzpunkt: 55°C
¹H NMR (CDCl₃): [ppm] = 7.29 (t; 1 H; J = 8 Hz; H-5'), 7.21, 7.12 (2 x s, 2 x 1 H, H-3, H-6), 6.87 (m; 3 H; H-2', H-4', H-6'), 4.70, 4.64 (2 x d, 2 x 2 H, CH₂O, J = 8 Hz), 4.01 (m, 2 H, O-CH₂), 3.93 (s, 3 H, O-Me), 2.29, 1.63 (2 x t, 2 x 1 H, OH, J = 8 Hz), 1.84 (m, 1 H, H-3'), 1.60 (m, 3 H, H-2', H-7'), 1.25 (m, 6 H, H-4', H-5', H-6'), 0.94 (d, 3 H, Me, J = 7.5 Hz), 0.87 (d, 6 H, Me, J = 7.5 Hz).

### Beispiel D3: Synthese von 2,5-Bishydroxymethyl-4-methoxy-3',4'-bis-(2-methylpropyl)biphenyl

Durchführung analog Beispiel D1. Man erhielt das Produkt als weiße Kristalle nach Umkristallisation in Ethylacetat/Hexan (1:2) in 78% Ausbeute.
Schmelzpunkt: 110-111°C
¹H NMR (CDCl₃): [ppm] = 7.19, 7.10 (2 x s, 2 x 1 H, H-3, H-6), 6.89 (d, 1 H, H-5', J = 8 Hz), 6.84 (d, 1 H, H-2', J = 2 Hz), 6.80 (dd, 1 H, H-6', J = 8 Hz, J = 2 Hz), 4.71, 4.63 (2 x s, 2 x 2 H, CH₂O), 3.94 (s, 3 H, O-Me), 3.78, 3.75 (2 x d, 2 x 2 H, O-CH₂, J = 8 Hz), 2.15 (m, 2 H, CH), 1.05 (m, 12 H, CH₃).

### Beispiel D4: Synthese von 2,5-Bishydroxymethyl-4,2',5'-trimethoxybiphenyl

Durchführung analog Beispiel D1. Man erhielt das Produkt als weißes Pulver nach Ausrühren in Hexan in 96% Ausbeute.
Schmelzpunkt: 91.5-92.5°C
¹H NMR (CDCl₃): [ppm] = 7.14, 7.10 (2 x s, 2 x 1 H, H-3, H-6), 6.91 (d, 1 H, H-3', J = 8 Hz), 6.87 (dd, 1 H, H-4', J = 8 Hz, J = 2 Hz), 6.73 (d, 1 H, H-6', J = 2 Hz), 4.71, 4.40 (2 x d (br), 2 x 2 H, CH₂O), 3.94, 3.78, 3.68 (3 x s, 3 x 3 H, 3 x O-Me), 2.1 (s (br), 2 H, OH). Die CH₂OH-Gruppen wiesen Diastereotopie wegen gehinderter Rotation auf.

### Beispiel D5: Synthese von 2,5-Bishydroxymethyl-4-methoxy-2',5'-dimethylbiphenyl

Durchführung analog Beispiel D1. Man erhielt das Produkt als weißes Pulver nach Ausrühren in Hexan in 96% Ausbeute.
Schmelzpunkt: 147.5-150°C
¹H NMR (CDCl₃): [ppm] = 7.14 (d, 1 H, H-3', J = 8 Hz), 7.11, 7.03 (2 x s, 2 x 1 H, H-3, H-6), 7.07 (dd, 1 H, H-4', J = 8 Hz, J = 1.2 Hz), 6.91 (s (br), 1 H, H-6'), 4.69, 4.40 (2 x s, 2 x 2 H, CH₂O), 3.93 (s, 3 H, O-Me), 2.31, 2.00 (2 x s, 2 x 3 H, CH₃).

### Beispiel D6: Synthese von 2,5-Bishydroxymethyl-4-fluor-3'-(3,7-dimethyloctyloxy)biphenyl

Durchführung analog Beispiel D1. Allerdings wurde nicht reines LiAlH₄ verwendet, sondern zur Abmilderung ein Äquivalent iso-Propanol zugegeben, d. h. die Reduktion wurde mit LiAlH₃(OⁱPr) durchgeführt. Man erhielt das Produkt als hochviskoses Öl in 94% Ausbeute (Reinheit ca. 98%ig).
¹H NMR (CDCl₃): [ppm] = 7.30 (m, 3 H, H-3, H-6, H-5'), 6.88 (m, 3 H, H-2', H-4', H-6'), 4.78, 4.59 (2 x d, 2 x 2 H, CH₂O, J = 5 Hz), 4.00 (m, 2 H, O-CH₂), 1.85 (m, 2 H, H-3", OH), 1.60 (m, 4 H, H-2", H-7", OH), 1.25 (m, 6 H, H-4", H-5", H-6"), 0.94 (d, 3 H, Me, J = 7.5 Hz), 0.86 (d, 6 H, Me, J = 7.5 Hz).

### Beispiel D7: Synthese von 2,5-Bishydroxymethyl-4-fluor-3',4'-bis-(2-methylpropyl)biphenyl

Durchführung analog Beispiel D6. Man erhielt das Produkt als weißes Pulver nach Ausrühren in Hexan in 87% Ausbeute.
Schmelzpunkt: 78-79°C
¹H NMR (CDCl₃): [ppm] = 7.31 (d, 1 H, H-6, J_{H-F} = 7 Hz), 7.27 (d, 1 H, H-3, J_{H-F} = 11 Hz), 6.90 (d; 1 H; H-5', J = 8 Hz), 6.84 (d; 1 H; H-2', J = 2 Hz), 6.80 (dd; 1 H; H-6', J = 8 Hz, J = 2 Hz), 4.78, 4.60 (2 x s, 2 x 2 H, CH₂O), 3.80, 3.75 (2 x d, 2 x 2 H, O-CH₂, J = 8 Hz), 2.15 (m, 2 H, CH), 1.05 (m, 12 H, CH₃).

### Beispiel D8: Synthese von 2,5-Bishydroxymethyl-4-chlor-4'-(3,7-dimethyloctyloxy)biphenyl

Durchführung analog Beispiel D1. Man erhielt das Produkt als weißes Pulver nach Ausrühren in Ethylacetat/Hexan (1/10) in 87% Ausbeute.
Schmelzpunkt: 90°C
¹H NMR (CDCl₃): [ppm] = 7.56, 7.37 (2 x s, 2 x 1 H, H-3, H-6), 7.23, 6.93 (AA'BB', 4 H, H-Aryl), 4.79, 4.60 (2 x s, 2 x 2 H, CH₂O), 4.02 (m, 2 H, O-CH₂), 1.85 (m, 1 H, H-3"), 1.65 (m, 3 H, H-2", H-7"), 1.35 (m, 6 H, H-4", H-5", H-6"), 0.96 (d, 3 H, Me, J = 7.5 Hz), 0.87 (d, 6 H, Me, J = 7.5 Hz).

### Beispiel D9: Synthese von 2,5-Bishydroxymethyl-4-(3,7-dimethyloctyloxy)-biphenyl

1060 ml 3,7-Dimethyloctanol wurden unter Schutzgas mit 46 g Natrium versetzt. Es wurde bis zur vollständigen Bildung des Natriumsalzes ca. 3 h bei 120°C gerührt. Anschließend wurden 223 g 2-Chlor-5-phenylterephthalsäurediethylester bei etwa 100°C innerhalb 20 Minuten zugetropft. Hierbei bildete sich eine trübe, gelbliche Mischung. Zur Vervollständigung der nucleophilen Substitution wurde weitere 5 Stunden bei 130°C nachgerührt. Anschließend wurde der abgekühlte Ansatz mit 500 ml Wasser versetzt, nach Phasentrennung für mehrere Stunden mit Ethanol refluxiert und schließlich vom Lösungsmittel befreit. Das so erhaltene Rohprodukt erwies sich (laut NMR) als Gemisch verschiedener Ester. Jedoch war die Substitution des Chlors durch die Dimethyloctyloxy-Gruppe vollständig. Dieses Rohprodukt wurde direkt analog der Beschreibung in D1 mit LiAlH₄ reduziert. Man erhielt schließlich nach zweifachem Ausrühren mit Ethylacetat/Hexan (1/10) das Produkt (35%) als weiße Kristalle.
Schmelzpunkt: 112-115°C
¹H NMR (CDCl₃): = [ppm] 7.36 (m (AA'BB'C), 5 H, H-Phenyl), 7.19, 7.12 (2 x s, 2 x 1 H, H-3, H-6), 4.72, 4.61 (2 x d, 2 x 2 H, CH₂O, J = 6 Hz), 4.13 (m, 2 H, O-CH₂), 2.35, 1.48 (2 x t, 2 x 1 H, OH, J = 6 Hz), 1.88 (m, 1 H, H-3"), 1.65 (m, 3 H, H-2", H-7"), 1.25 (m, 6 H, H-4", H-5", H-6"), 0.97 (d, 3 H, Me, J = 7.5 Hz), 0.87 (d, 6 H, Me, J = 7.5 Hz).

### Beispiel D10: Synthese von 2,5-Bishydroxymethyl-4-methoxy-3',5'-difluorbiphenyl

Die Durchführung erfolgte analog Beispiel D1. Man erhielt das Produkt als weißes Pulver nach Umkristallisation aus n-Hexan.
Schmelzpunkt: 123°C
¹H NMR (CDCl₃): [ppm] = 7.60, 7.26 (2 x s, 2 x 1 H, H-3, H-6); 6.96-6.89 (m, 2H, H-2', H6'), 6.82 (tt, 1 H, H-4', J = 8.9, J = 2.0); 4.72, 4.58 (2 x s, 2 x 2 H, CH₂O), 4.02 (s, 3 H, O-CH₃), 1,84, 1.73 (2 br. s, je 1H, OH).

### E. Halogenierungen gemäß Reaktion C

### Beispiel E1: Synthese von 2,5-Bischlormethyl-4-methoxy-4'-(3,7-dimethyloctyloxy)-biphenyl

Unter N₂ wurde 2,5-Bishydroxymethyl-4-methoxy-4'-(3,7-dimethyloctyloxy)biphenyl (54.9 g, 137 mmol) vorlegt und Thionylchlorid (20 ml, 274 mmol) vorsichtig zugeben. Der Ansatz rührte 20 Stunden bei Raumtemperatur. Der Ansatz wurde vorsichtig auf wäßrige NaHCO₃-Lösung gegossen, und mit Ethylacetat extrahiert und schließlich wurde die organische Phase noch neutral gewaschen. Nach dem Trocknen über MgSO₄ wurde das Ethylacetat abgezogen und das Produkt (40% Ausbeute) durch Destillation an einer Kurzwegdestille (0.3 mbar, 265°C) als farbloses, hochviskoses Öl erhalten.
¹H NMR (CDCl₃): [ppm] = 7.29, 6.95 (AA'BB', 4 H, H-Aryl), 7.27, 7.03 (2 x s, 2 x 1 H, H-3, H-6), 4.65, 4.53 (2 x s, 2 x 2 H, CH₂Cl), 4.04 (m, 2 H, O-CH₂), 3.94 (s, 3 H, O-Me), 1.85 (m, 1 H, H-3'), 1.63 (m, 3 H, H-2', H-7'), 1.28 (m, 6 H, H-4', H-5', H-6'), 0.97 (d, 3 H, Me, J = 7.5 Hz), 0.88 (d, 6 H, Me, J = 7.5 Hz).

### Beispiel E2: Synthese von 2,5-Bischlormethyl-4-methoxy-3'-(3,7-dimethyloctyloxy)-biphenyl

Durchführung analog Beispiel E1; das Produkt (46% Ausbeute) wurde durch Destillation an einer Kurzwegdestille (10⁻³ mbar, 180°C) als farbloses, hochviskoses Öl erhalten (Reinheit: 99 %).
¹H NMR (CDCl₃): [ppm] = 7.32 (t; 1 H; J = 8 Hz; H-5'), 7.30, 7.04 (2 x s, 2 x 1 H, H-3, H-6), 6.93 (m; 3 H; H-2', H-4', H-6'), 4.66, 4.53 (2 x s, 2 x 2 H, CH₂Cl), 4.04 (m, 2 H, O-CH₂), 3.95 (s, 3 H, O-Me), 1.84 (m, 1 H, H-3'), 1.60 (m, 3 H, H-2', H-7'), 1.25 (m, 6 H, H-4', H-5', H-6'), 0.94 (d, 3 H, Me, J = 7.5 Hz), 0.86 (d, 6 H, Me, J = 7.5 Hz).

### Beispiel E3: Synthese von 2,5-Bischlormethyl-4-methoxy-3',4'-bis-(2-methylpropyl)biphenyl

Durchführung analog Beispiel E1; allerdings wurde Hexan als Lösungsmittel zugegeben (1 molare Lösung). Das Produkt kristallisierte aus der Lösung aus. Nach nochmaligem Ausrühren in Hexan erhielt man ein farbloses Pulver in 60% Ausbeute. Schmelzpunkt: 97°C
¹H NMR (CDCl₃): [ppm] = 7.28, 7.03 (2 x s, 2 x 1 H, H-3, H-6), 6.94 (d, 1 H, H-2', J = 2 Hz), 6.91 (d, 1 H, H-5', J = 8 Hz), 6.86 (dd, 1 H, H-6', J = 8 Hz, J = 2 Hz), 4.65, 4.53 (2 x s, 2 x 2 H, CH₂Cl), 3.94 (s, 3 H, O-Me), 3.80, 3.79 (2 x d, 2 x 2 H, O-CH₂, J = 8 Hz), 2.15 (m, 2 H, CH), 1.06 (m, 12 H, CH₃).

### Beispiel E4: Synthese von 2,5-Bischlormethyl-4,2',5'-trimethoxybiphenyl

Durchführung analog Beispiel E3. Das Produkt kristallisierte aus der Lösung aus. Nach nochmaligem Ausrühren in Hexan erhielt man ein farbloses Pulver in 57% Ausbeute.
Schmelzpunkt: 71-73°C
¹H NMR (CDCl₃): [ppm] = 7.23, 7.09 (2 x s, 2 x 1 H, H-3, H-6), 6.89, 6.81 (m, 2 + 1 H, H-3', H-4', H-6'), 4.65, 4.45 (2 x br, 2 x 2 H, CH₂Cl), 3.94, 3.80, 3.70 (3 x s, 3 x 3 H, 3 x O-Me). Die CH₂Cl-Gruppen wiesen Diastereotopie wegen gehinderter Rotation auf.

### Beispiel E5: Synthese von 2,5-Bischlormethyl-4-methoxy-2',5'-dimethylbiphenyl

Durchführung analog Beispiel E3. Das Produkt wurde als viskoses Öl durch Destillation am Kurzwegverdampfer (10⁻³ mbar, 115°C) in 67% Ausbeute erhalten. ¹H NMR (CDCl₃): [ppm] = 7.16 (d, 1 H, H-3', J = 8 Hz), 7.15, 7.07 (2 x s, 2 x 1 H, H-3, H-6), 7.10 (dd, 1 H, H-4', J = 8 Hz, J = 1.2 Hz), 6.96 (s (br), 1 H, H-6'), 4.67, 4.63 (AB, 2 H, CH₂Cl, J = 12 Hz), 4.39, 4.30 (AB, 2 H, CH₂Cl, J = 12 Hz), 3.95 (s, 3 H, O-Me), 2.33, 2.03 (2 x s, 2 x 3 H, CH₃). Die CH₂Cl-Gruppen wiesen Diastereotopie wegen gehinderter Rotation auf.

### Beispiel E6: Synthese von 2,5-Bischlormethyl-4-fluor-3'-(3,7-dimethyloctyloxy)-biphenyl

Durchführung analog Beispiel E3. Das Produkt wurde als viskoses Öl durch Destillation am Kurzwegverdampfer (10⁻³ mbar, 180°C) in 68% Ausbeute erhalten.
¹H NMR (CDCl₃): [ppm] = 7.34 (m, 2 H, H-6, H-5'), 7.28 (d, 1 H, H-3, J_{H-F} = 10 Hz), 6.92 (m, 3 H, H-2', H-4', H-6'), 4.64, 4.48 (2 x s, 2 x 2 H, CH₂Cl), 4.04 (m, 2 H, O-CH₂), 1.83 (m, 1 H, H-3"), 1.60 (m, 3 H, H-2", H-7"), 1.25 (m, 6 H, H-4", H-5", H-6"), 0.95 (d, 3 H, Me, J = 7.5 Hz), 0.87 (d, 6 H, Me, J = 7.5 Hz).

### Beispiel E7: Synthese von 2,5-Bischlormethyl-4-fluor-3',4'-bis-(2-methylpropyl)biphenyl

Durchführung analog Beispiel E3. Das Produkt wurde als viskoses Öl durch Destillation am Kurzwegverdampfer (10⁻³ mbar, 185°C) in 70% Ausbeute erhalten.
¹H NMR (CDCl₃): [ppm] δ = 7.33 (d, 1 H, H-6, J_{H-F} = 7 Hz), 7.26 (d, 1 H, H-3, J_{H-F} = 10 Hz), 6.93 (d; 1 H; H-5', J = 8 Hz), 6.91 (d; 1 H; H-2', J = 2 Hz), 6.84 (dd; 1 H; H-6', J = 8 Hz, J = 2 Hz), 4.65, 4.47 (2 x s, 2 x 2 H, CH₂Cl), 3.80, 3.77 (2 x d, 2 x 2 H, O-CH₂, J = 8 Hz), 2.16 (m, 2 H, CH), 1.06 (m, 12 H, CH₃).

### Beispiel E8: Synthese von 2,5-Bischlormethyl-4-chlor-4'-(3,7-dimethyloctyloxy)biphenyl

Durchführung analog Beispiel E3. Das Produkt wurde als viskoses Öl durch Destillation am Kurzwegverdampfer (10⁻³ mbar, 190°C) in 65% Ausbeute erhalten. ¹H NMR (CDCl₃): [ppm] δ = 7.58, 7.38 (2 x s, 2 x 1 H, H-3, H-6), 7.29, 6.97 (AA'BB', 4 H, H-Aryl), 4.70, 4.47 (2 x s, 2 x 2 H, CH₂Cl), 4.05 (m, 2 H, O-CH₂), 1.85 (m, 1 H, H-3"), 1.63 (m, 3 H, H-2", H-7"), 1.28 (m, 6 H, H-4", H-5", H-6"), 0.97 (d, 3 H, Me, J = 7.5 Hz), 0.88 (d, 6 H, Me, J = 7.5 Hz).

### Beispiel E9: Synthese von 2,5-Bischlormethyl-4-(3,7-dimethyloctyloxy)-biphenyl

Durchführung analog Beispiel E3. Das Produkt wurde als viskoses Öl durch doppelte Destillation am Kurzwegverdampfer (10⁻³ mbar, 1. 135°C, 2. 190°C) in 44% Ausbeute erhalten.
¹H NMR (CDCl₃): = [ppm] 7.40 (m (AA'BB'C), 5 H, H-Phenyl), 7.29, 7.05 (2 x s, 2 x 1 H, H-3, H-6), 4.66, 4.51 (2 x s, 2 x 2 H, CH₂Cl), 4.13 (m, 2 H, O-CH₂), 1.90 (m, 1 H, H-3"), 1.66 (m, 3 H, H-2", H-7"), 1.28 (m, 6 H, H-4", H-5", H-6"), 0.99 (d, 3 H, Me, J = 7.5 Hz), 0.88 (d, 6 H, Me, J = 7.5 Hz).

### Beispiel E10: Synthese von 2,5-Bis(chlormethyl)-4-methoxy-3',5'-bisfluorbiphenyl

Durchführung analog Beispiel E1. Das Produkt wurde durch Kristallisation aus Heptan gereinigt.
Schmelzpunkt: 117°C
¹H NMR (CDCl₃): [ppm] δ = 7.54, 7.24 (2 x s, 2 x 1 H, H-3, H-6), 7.00-6.92 (m, 2 H, H-2', H-6'), 6.86 (tt, 1 H, H-4', J = 8.7 Hz, J = 2 Hz), 4.60, 4.48 (2 x s, 2 x 2 H, CH₂Cl), 3.99 (s, 3 H, O-Me).

### Z. Synthese von Comonomeren

### Z1. Synthese von 2,5-Bis(chlormethyl)-1-methoxy-4-(3,7-dimethyloctyloxy)benzol:

### a) Herstellung von 3,7-Dimethyloctyl-1-chlorid:

In einem 1 L Vierhalsrundkolben mit Tropftrichter, Intensivkühler und Magnetrührkern wurden 275 ml (1.46 mol) 3,7-Dimethyl-1-octanol vorgelegt und auf -3°C gekühlt. Dann wurden 0.7 ml Pyridin zugefügt und 129 ml (1.77 mol, 1.2 eq) Thionylchlorid so zugetropft, daß die Temperatur 15°C nicht überstieg (75 Minuten). Das entstehende HCl-Gas wurde in einer Waschflasche mit Ca(OH)₂/Wasser abgefangen. Dann wurde innerhalb von 40 Minuten auf 130°C erhitzt. Nach zwei Stunden bei dieser Temperatur wurde auf 50°C abgekühlt, flüchtige Bestandteile wurden durch Anlegen eines Vakuums von 100 mbar abdestilliert. Der Rückstand wurde nun auf Raumtemperatur abgekühlt, mit 200 ml n-Hexan verdünnt und zuerst zweimal mit je 50 ml 10%iger NaOH Lösung in Wasser, dann mit 50 ml Wasser und schließlich mit 50 ml gesättigter wäßriger NaHCO₃-Lösung gewaschen. Die Lösung wurde mit Na₂SO₄ getrocknet, das Lösungsmittel durch Destillation am Rotationsverdampfer entfernt. Der Rückstand wurde durch Destillation im Vakuum (13 mbar, 86-87°C) gereinigt. Man erhielt 178.9 g (1.01 mol, 69%) 3,7-Dimethyloctyl-1-chlorid als farbloses Öl.
Siedepunkt: 86-87°C, 13 mbar. ¹H NMR (400 MHz, CDCl₃): (ppm) = 3.61-3.49 (m, 2H, CH₂Cl); 1.82-1.74 (m, 1H); 1.69-1.48 (m, 3H); 1.37-1.21 (m, 3H); 1.19-1.09 (m, 3H); 0.89 (d, J = 6.7 Hz, 3H; CH₃); 0.87 (d, J = 6.7 Hz, 6H; 2 x CH₃).

### b) Herstellung von 1-Methoxy-4-(3,7-dimethyloctyloxy)benzol:

In einem 2 L Vierhalsrundkolben mit Tropftrichter, Intensivkühler, Gasableitung und Magnetrührkern wurden 184.4 g (1.48 mol) p-Methoxyphenol, 275.9 g (1.56 mol, 1.05 eq) 3,7-Dimethyloctyl-1-chlorid, 106.9 g KOH (85%ig, 1.62 mol, 1.09 eq) und 15.04 g Natrumiodid in 620 ml trockenem Ethanol gelöst und unter magnetischem Rühren 64 Stunden zum Sieden erhitzt. Es wurde auf Raumtemperatur abgekühlt und die Reaktionslösung wurde von dem angefallenen Feststoff abdekantiert. Die Reaktionslösung wurde im Rotationsverdampfer eingeengt. Der Feststoff wurde in 400 ml 10%iger wäßriger NaOH Lösung aufgenommen. Diese Lösung wurde zweimal mit je 400 ml Toluol extrahiert. Die organischen Phasen wurden vereinigt, mit 100 ml 10%iger wäßriger NaOH Lösung gewaschen und mit Na₂SO₄ getrocknet. Das Lösungsmittel wurde im Vakuum im Rotationsverdampfer abdestilliert. Der Rückstand wurde im Vakuum (1 mbar) destilliert (Kopftemperatur: 159-162°C). Man erhielt 372.4 g (1.41 mol, 95%) 1-Methoxy-4-(3,7-dimethyloctyloxy)benzol als farbloses Öl.
Siedepunkt: 159-162°C/1 mbar. ¹H NMR (400 MHz, CDCl₃): (ppm) = 6.82 (d, J = 0.8 Hz, 4H; Hₐᵣₒₘ); 3.97-3.88 (m, 2H; OCH₂); 3.75 (s, 3H; OCH₃); 1.84-1.75 (m, 1 H); 1.71-1.47 (m, 3H); 1.38-1.23 (m, 3H); 1.22-1.09 (m, 3H); 0.93 (d, J = 6.6 Hz, 6H; CH₃); 0.86 (d, J = 6.7 Hz, 6H; 2 x CH₃).

### c) Herstellung von 2,5-Bis(chlormethyl)-1-methoxy-4-(3,7-dimethyloctyloxy)benzol:

In einem 4 L Vierhalskolben mit mechanischem Rührer, Rückflußkühler, Thermometer und Tropftrichter wurden unter N₂ 304.96 g (1.03 mol) 1-(3,7-Dimethyloctyloxy)-4-methoxybenzol und 85.38 g (2.84 mol) Paraformaldehyd vorgelegt und mit 490 ml (580.6 g, 5.89 mol) 37proz. HCl versetzt; man erhielt eine gelbe Suspension. Daraufhin wurden 990 ml (1070 g, 10.5 mol) Essigsäureanhydrid so zugetropft, daß die Innentemperatur 70°C nicht überschritt ( Dauer: 1.5 Std. ). Die letzten 100 ml wurden auf einmal zugegeben; hierbei kam es zu einem Temperaturanstieg von 70°C auf 75°C; die Reaktionsmischung verfärbte sich von beigebraun nach rötlich. Der Ansatz wurde 3.5 Stunden bei 70-75°C gerührt. Dann wurde unter Rühren auf Raumtemperatur abgekühlt, dabei kristallisierte bei 32°C ein heller Feststoff aus und es kam zu einem Temperaturanstieg auf 35°C. Der Ansatz wurde über Nacht bei Raumtemperatur stehengelassen, es schied sich dabei ein heller Feststoff ab. Das Reaktionsgemisch wurde mit 940 ml kalt gesättigter Na-Acetat-Lösung versetzt ( Dauer: ca. 15 min. ) 700 ml 25 %ige NaOH wurden nun so zugetropft, daß die Innentemperatur 30°C nicht überschritt (Dauer: ca. 35 min.). Der Ansatz wurde nun auf 52°C hochgeheizt (Dauer: ca. 30 min.) und dann unter schnellem Rühren im Eisbad abgekühlt (Dauer: ca. 30 min.). Der cremefarbene, körnige Feststoff wurde abgesaugt und mit 200 ml H₂O gewaschen. Der Feststoff ( 451g ) wurde mit 2500 ml Hexan versetzt, bei Raumtemperatur gerührt und dann mit 300 ml kochendem H₂O versetzt Es wurde 20 Minuten gerührt und die wäßrige Phase abgetrennt. Die gelbliche org. Phase wurde noch 3x mit je 300 ml H₂O ausgerührt, der pH-Wert betrug 5. Die org. Phase wurde über Na₂SO₄ getrocknet und filtriert. Das Filtrat wurde eingeengt und in der Tiefkühltruhe kristallisiert.
Der auskristallisierte Niederschlag (447 g) wurde abgesaugt, mit -20°C kaltem Hexan gewaschen und zur Umkristallisation in 1000 ml Hexan bei 60°C gelöst. Es wurde bei -20°C kristallisiert, der Feststoff abgesaugt und im Vakuum bei Raumtemperatur getrocknet. Man erhielt 279.6 g (0.774 mol, 75%) 2,5-Bis(chlormethyl)-1-methoxy-4-(3,7-dimethyloctyloxy)benzol als farblosen Feststoff.
Schmp.: 65°C;
¹H NMR (400 MHz, CDCl₃): (ppm) = 6.92 (d, J = 2.0 Hz, 2H; Hₐᵣₒₘ); 4.63 (d, J = 2.6 Hz, 4 H; CH₂Cl); 4.07-3.98 (m, 2H; OCH₂); 3.85 (s, 3H; OCH₃); 1.88-1.80 (m, 1 H); 1.76-1.66 (br. m, 1 H); 1.65-1.49 (m, 2H); 1.40-1.26 (m, 3H); 1.23-1.12 (m, 3H); 0.95 (d, J = 6.8 Hz, 3H; CH₃); 0.87 (d, J = 6.8 Hz, 6H; 2 x CH₃). ¹³C NMR (100 MHz, CDCl₃): (ppm) = 151.0, 150.7 (C1, C4); 127.1, 126.8 (C2, C5); 114.4, 113.3 (C3, C6); 67.5 (OCH₂); 56.3 (OCH₃); 41.3 (2 x CH₂Cl); 39.2 (C2'); 37.3, 36.3 (C4', C6'); 29.9 (C3'); 28.0 (C7'); 24.7 (C5'); 22.7, 22.6, 19.7 (3 x CH₃).

### Z2. Synthese von Herstellung von 2,5-Bis(chlormethyl)-1,4-bis(3,7-dimethyloctyloxy)benzol

### a) Herstellung von 1,4-Bis(3,7-dimethyloctyloxy)benzol:

In einem 2 L Vierhalsrundkolben mit Tropftrichter, Intensivkühler, Gaszuleitung und Magnetrührkern wurden 84.2 g KOH (85%ig, 1.28 mol, 1.28 eq) und 14.9 g Natrumiodid (0.10 mol) in 600 ml trockenem Ethanol gelöst. Hierbei stieg die Temperatur auf 35°C an. In die trübe Lösung wurden nun 55.1 g (0.50 mol) Hydrochinon zugegeben und 221 g 3,7-Dimethyloctyl-1-chlorid (1.25 mol, 1.25 eq) wurden langsam zugetropft. Die hellbraune Suspension wurde unter magnetischem Rühren 10 Stunden zum Sieden erhitzt. Es wurden nun weitere 21 g KOH (85%ig, 0.32 mol) und 55 g 3,7-Dimethyloctyl-1-chlorid (0.31 mol, 0.31 eq) zugesetzt. Man erhitzte dann weitere 84 Stunden zum Sieden.
Es wurde auf Raumtemperatur abgekühlt und die Reaktionslösung wurde im Rotationsverdampfer eingeengt. Der Feststoff wurde mit 500 ml Essigsäureethylester extrahiert. Diese Lösung wurde je dreimal mit je 200 ml 10%iger wäßriger NaOH Lösung und 200 ml Wasser gewaschen und dann mit MgSO₄ getrocknet. Das Lösungsmittel wurde im Vakuum im Rotationsverdampfer abdestilliert. Der Rückstand wurde im Vakuum (0.05 mbar) destilliert (Kopftemperatur: 166-170°C). Man erhielt 147.4 g (0.37 mol, 75%) 1,4-Bis(3,7-dimethyloctyloxy)benzol als farbloses Öl.
Siedepunkt: 166-170°C/0.05 mbar. ¹H NMR (400 MHz, CDCl₃): (ppm) = 6.82 (s, 4H; Hₐᵣₒₘ); 3.98-3.88 (m, 4H; OCH₂); 1.84-1.75 (m, 2H); 1.71-1.61 (br. m, 2H); 1.59-1.49 (m, 4H); 1.40-1.09 (m, 12H); 0.93 (d, J = 6.5 Hz, 6H; 2xCH₃); 0.86 (d, J = 6.5 Hz, 12H; 4 x CH₃).

### b) Herstellung von 2,5-Bis(chlormethyl)-1,4-bis(3,7-dimethyloctyloxy)benzol:

In einem 1 L Vierhalskolben mit mechanischem Rührer, Rückflußkühler, Thermometer und Tropftrichter wurden unter N₂ 58.6 g (150 mmol) 1,4-Bis(3,7-dimethyloctyloxy)benzol und 12.43 g (414 mmol) Paraformaldehyd vorgelegt und mit 71.4 ml (858 mmol) 37proz. HCl versetzt; man erhielt eine gelbe Suspension. Daraufhin wurden 144 ml (156 g, 1.53 mol) Essigsäureanhydrid so zugetropft, daß die Innentemperatur 70°C nicht überschreitet ( Dauer: 2 Std.). Der Ansatz wurde 9 Stunden bei 70-75°C gerührt. Dann wurden nochmals 110 ml (119 g, 1.17 mol) Essigsäureanhydrid zugesetzt und es wurde nochmals 8 Stunden bei 70-75°C gerührt. Dann wurde unter Rühren auf Raumtemperatur abgekühlt, dabei kristallisierte ein heller Feststoff aus. Das Reaktionsgemisch wurde mit 240 ml kalt gesättigter Na-Acetat-Lösung versetzt ( Dauer: ca. 15 min. ) und 100 ml 25 %ige NaOH wurden nun so zugetropft, daß die Innentemperatur 30°C nicht überschreitet (Dauer: ca. 35 min.). Der körnige Feststoff wurde zwischen 300 ml Hexan und 300 ml Wasser verteilt. Die org. Phase wurde über Na₂SO₄ getrocknet und filtriert. Das Filtrat wurde eingeengt und im Kühlschrank kristallisiert.
Es wurde nochmals aus 170 ml Hexan umkristallisiert (Waschen mit -20°C kaltem Hexan). Man erhielt 28.3 g (58.0 mmol, 39%) 2,5-Bis(chlormethyl)-1,4-bis(3,7-dimethyloctyloxy)benzol als farblosen Feststoff.
Schmp.: 55°C; ¹H NMR (400 MHz, CDCl₃): (ppm) = 6.92 (s, 2H; Hₐᵣₒₘ); 4.62 (s, 4 H; CH₂Cl); 4.07-3.97 (m, 4H; OCH₂); 1.88-1.80 (m, 2H); 1.76-1.66 (br. m, 2H); 1.65-1.49 (m, 4H); 1.40-1.13 (m, 12H); 0.95 (d, J = 6.5 Hz, 6H; 2 x CH₃); 0.87 (d, J = 6.8 Hz, 12H; 2 x CH₃).

### Z3. Synthese von 2,5-Bischlormethyl-3'-(3,7-dimethyloctyloxy)biphenyl:

### a) Synthese von 2-(3'-(3,7-Dimethyloctyloxy)phenyl)-terephthalsäuredimethylester:

Bromterephthalsäuredimethylester (49.7 g, 182 mmol, von TransWorld, Rockville MD, USA, bezogen bzw. analog Beispiel A1 hergestellt), K₂CO₃ (50.3 g, 364 mmol) und 170 ml Toluol und 170 ml H₂O wurden vorgelegt und 30 Minuten mit Argon gespült. Anschließend wurde 3-(3,7-Dimethyloctyloxy)boronsäure (55.7 g, 200 mmol) (vgl. B1), sowie Pd(PPh₃)₄ (0.93 g, 0.8 mmol) unter Schutzgas zugegeben. Das gelb-grünliche, trübe Gemisch wurde unter Schutzgasüberlagerung bei 85° C Innentemperatur kräftig gerührt. Nach 24 Stunden war die Reaktion beendet. Nach Phasentrennung wurde die organische Phase mit verdünnter HCl / H₂O ausgeschüttelt (neutral). Die wäßrige Phase schüttelte man mit Ethylacetat aus und vereinigte die organischen Phasen. Diese wurden eingeengt und bei 2 mbar getrocknet. Man erhielt das Produkt als gelbes Öl in ausreichender Reinheit (größer 95%): 76.1 g (98%).
¹H NMR (400 MHz; CDCl₃): [ppm] = 8.07 (d; 1 H; J = 2 Hz; H-3), 8.05 (dd; 1 H; J₁ = 8, J₂ = 2 Hz; H-5), 7.82 (d; 1 H; J = 8 Hz; H-6), 7.29 (t; 1 H; J = 8 Hz; H-5'), 6.90 (m; 3 H; H-2', H-4', H-6'), 4.01 (m; 2 H; O-CH₂), 3.94, 3.67 (jeweils: s; 3 H; CO₂-CH₃), 1.84 (m; 1 H; O-CH₂-CH₂-CH), 1.63-1.48 (m; 3 H; H-alkyl), 1.37-1.12 (m; 6 H; H-alkyl), 0.96 (d; 3 H; J = 7.8 Hz; CH₃), 0.87 (d; 6 H; J = 7.7 Hz; CH₃).

### b) Synthese von 2,5-Bishydroxymethyl-3'-(3,7-dimethyloctyloxy)biphenyl:

LiAlH₄ (9.4 g, 248 mmol) wurde unter N₂ in 300 ml THF vorgelegt. Bei RT wurde dann langsam 2-(3'-(3,7-Dimethyloctyloxy)phenyl)terephthalsäuredimethylester (75.5 g, 177 mmol), gelöst in 120 ml THF, zutropft. Anschließend wurde 4 h unter Rückfluß gerührt. Nach dem Abkühlen wurde überschüssiges LiAlH₄ vorsichtig durch H₂O-Zugabe vernichtet. Anschließend wurde halbkonzentrierte H₂SO₄ vorsichtig ( ca. 50 ml ) zugetropft. Der Ansatz war dabei sehr zähflüssig. Nach 1 h Nachrührzeit war eine klare Lösung und unten im Kolben ein grauer Niederschlag zu sehen. Die klare Lösung wurde abdekantiert und das Lösungsmittel abgezogen. Der zurückgebliebene Niederschlag wurde mit viel Wasser und Ethylacetat gerührt, nach Filtration die organische Phase abgetrennt, das Lösungsmittel abgezogen und mit der ersten organischen Phase vereinigt. Die vereinigten organischen Phasen wurden in Ethylacetat aufgenommen und mit Wasser fünfmal extrahiert. Nach Trocknung über MgSO₄ wurde das Lösungsmittel abgezogen. Das entstehende Öl wurde mehrfach mit Hexan gerührt und am Ölpumpenvakuum getrocknet. Das Produkt wurde so als reines hellgelbes, hochviskoses Öl (54 g, 82 %) erhalten.
¹H NMR (400 MHz; CDCl₃): [ppm] = 7.50 (d; 1 H; J = 7.8 Hz; H-6), 7.34 (dd; 1 H; J₁ = 7.8, J₂ = 1.9 Hz; H-5), 7.30 (dt; 1 H; J₁ = 8, J₂ = 1 Hz; H-5'), 7.26 (d; 1 H; J = 1.9 Hz; H-3), 6.88 (m; 3 H; H-2', H-4', H-6'), 4.69, 4.59 (jeweils: s; 2 H; CH₂-OH), 4.00 (m; 2 H; O-CH₂), 1.97 (s; 2 H; OH), 1.82 (m; 1 H; O-CH₂-CH₂-CH), 1.67-1.50 (m; 3 H; H-alkyl), 1.40-1.13 (m; 6 H; H-alkyl), 0.95 (d; 3 H; J = 7.5 Hz; CH₃), 0.87 (d; 6 H; J = 7.6 Hz; CH₃).

### c) Synthese von 2,5-Bischlormethyl-3'-(3,7-dimethyloctyloxy)biphenyl:

Unter N₂ wurde 2,5-Bishydroxymethyl-3'-(3,7-dimethyloctyloxy)biphenyl (50.7 g, 137 mmol) vorlegt und Thionylchlorid (20 ml, 274 mmol) vorsichtig zugeben. Es wurde noch zweimal (nach 2 und nach 8 Stunden) jeweils 2 ml Thionylchlorid nachgegeben und der Ansatz schließlich insgesamt 20 Stunden bei Raumtemperatur gerührt. Der Ansatz wurde vorsichtig auf wäßrige NaHCO₃-Lösung gegossen, und mit Ethylacetat extrahiert und schließlich wurde die organische Phase noch neutral gewaschen. Nach dem Trocknen über MgSO₄ wurde das Ethylacetat abgezogen und der Ansatz im Vakuum fraktioniert destilliert. Man erhielt das Produkt (39 g, 70 %) als hochviskoses farbloses Öl (Siedepunkt: 212°C bei 0.67 mbar).
¹H NMR (300 MHz; CDCl₃): [ppm] = 7.54 (d; 1 H; J = 8.3 Hz; H-6), 7.41 (dd; 1 H; J₁ = 8.2, J₂ = 2.1 Hz; H-5), 7.34 (d; 1 H; J₁ = 8, J₂ = 1 Hz; H-5'), 7.31 (d; 1 H; J = 2 Hz; H-3), 6.94 (m; 3 H; H-2'; H-4', H-6'); 4.61, 4.52 (jeweils: s; 2 H; CH₂Cl), 4.04 (m; 2H; O-CH₂), 1.84 (m; 1 H; O-CH₂-CH₂-CH), 1.72-1.46 (m; 3 H; H-alkyl), 1.38-1.10 (m; 6 H; H-alkyl), 0.94 (d; 3 H; J = 6.7 Hz; CH₃), 0.86 (d; 6 H; J = 6.9 Hz; CH₃).

### Z4. Synthese von 2,5-Bischlormethyl-4'-(3,7-dimethyloctyloxy)biphenyl:

Die Synthese ist in WO98/25874 als Beispiel E6 beschrieben.

### Z5: Synthese von 2,5-Bischlormethyl-3',4'-bis-(2-methylpropyl)biphenyl

Die Synthese ist in WO98/25874 als Beispiel E7 beschrieben.

### Teil 2: Synthese und Charakterisierung der Polymere:

Die Zusammensetzung der Copolymere P1 bis P17 sowie V1 bis V7 wurde durch oxidativen Abbau und nachfolgende qualitative und quantitative Analyse der so zurückerhaltenen Monomereinheiten belegt. Es wurde gefunden, daß der Anteil der Monomereinheiten im Copolymer gleich dem in der Synthese eingesetzten Verhältnis der Monomere war.

### P: Synthese von erfindungsgemäßen Polymeren:

### Beispiel P1:

### Copolymer aus 50% 2,5-Bis(chlormethyl)-1,4-bis(3,7-dimethyloctyloxy)benzol und 50% 2,5-Bis(chlormethyl)-3'-(3,7-dimethyloctyloxy)- 4-methoxybiphenyl (Polymer P1):

### Herstellung von Poly(2,5-(3,7-dimethyloctyloxy)-p-phenylenvinylen)co(2-(3'-(3,7-dimethyloctyloxy)phenyl-5-methoxy)-p-phenylenvinylen).

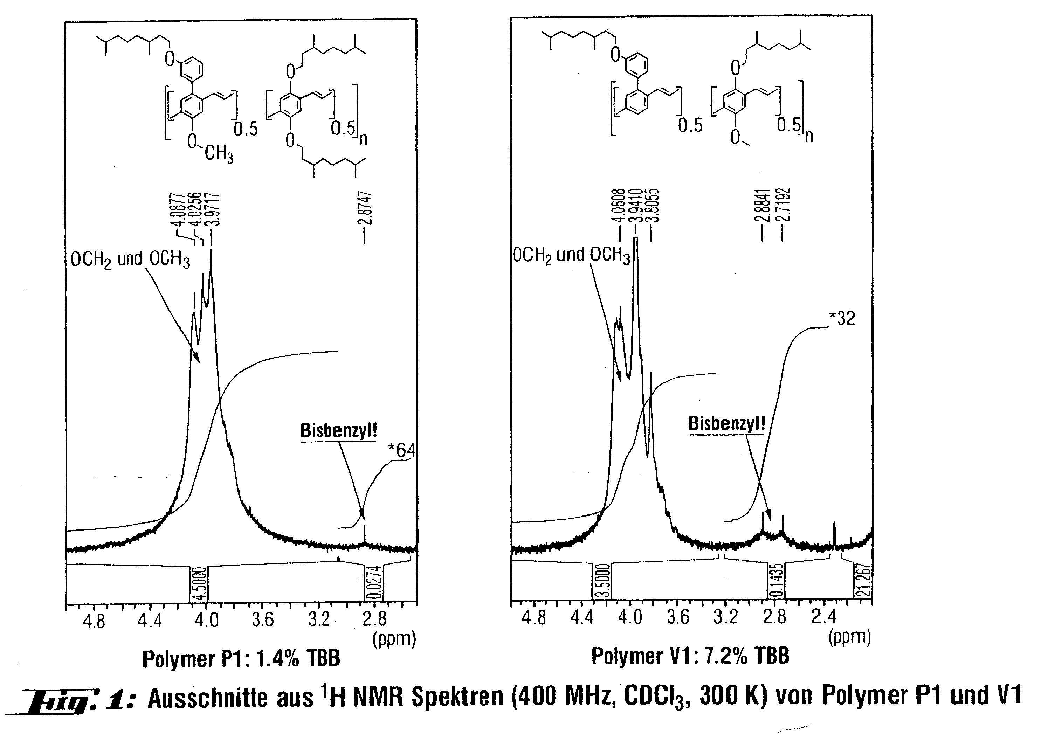

In einem trockenen 1 L Vierhalskolben mit mechanischem Teflonrührer, Rückflußkühler, Thermometer und Tropftrichter wurden 590 g trockenes und O₂freies 1,4-Dioxan auf 99°C erhitzt. Dann wurde eine Lösung von 1.95 g (4.00 mmol) 2,5-Bis(chlormethyl)-1,4-bis(3',7'-dimethyloctyloxy)benzol und 1.75 g (4.00 mmol) 2,5-Bis(chlormethyl)-3'-(3,7-dimethyloctyloxy)-4-methoxybiphenyl in 30 ml trockenem 1,4-Dioxan zugesetzt. Nun wurde eine Lösung von 2.36 g (21 mmol) Kalium-tert-butylat in 21 ml trockenem 1,4-Dioxan innerhalb von 5 Minuten zu der intensiv gerührten Mischung getropft. Die Farbe veränderte sich dabei von farblos über gelb nach orangerot. Nach 5 Minuten wurden weitere 1.79 g (16 mmol) Kalium-tert-butylat, gelöst in 16 ml 1,4-Dioxan, zugegeben. Nach 2 Stunden Rühren bei 98-100°C wurde auf 55°C abgekühlt und ein Gemisch aus 4 ml Essigsäure und 4 ml 1,4-Dioxan wurde zugesetzt. Die nun orange Lösung wurde auf 0.85 L intensiv gerührtes Wasser gegossen. Das ausgefallene Polymer wurde durch Filtration durch einen Polypropylenfilter isoliert und im Vakuum getrocknet. Die Rohausbeute betrugt 2.22g (5.70 mmol, 71 %).
Das Polymer wurde unter Erhitzen auf 60°C in 250 ml THF gelöst und durch Zusatz von 250 ml Methanol bei 40°C gefällt. Nach Trocknen im Vakuum wurde dieser Schritt wiederholt. Man erhielt nach Trocknung im Vakuum 1.37 g (= 3.52 mmol, 44%) des Polymer P1 als hell-orange Fasern.
¹H NMR (400 MHz, CDCl₃): δ (ppm) = 7.8-6.6 (br. m, 6 H); 4.2-3.6 (br. m, 4.5 H); 2.87 (br. s, Bisbenzyl); 2.0-0.9 (br. m, 15 H); 0.85, 0.84 (2 s, 13.5 H). Das ¹H NMR Spektrum von Polymer P1 ist in Abbildung 1 wiedergegeben. Durch Integration des Signals bei 2.87 ppm errechnet sich der Gehalt an TBB-Gruppen zu 1.4 %.
GPC: THF + 0.25% Oxals.; Säulensatz SDV500, SDV1000, SDV10000 (Fa. PSS), 35°C, UV Detektion 254 nm, Polystyrol-Standard: M_{w} = 1.35×10⁶ g/mol, Mₙ = 1.27 × 10⁵ g/mol.

### Beispiel P2:

### Copolymer aus 50% 2,5-Bis(chlormethyl)-4-methoxy-3'-(3,7-dimethyloctyloxy)biphenyl und 50% 2,5-Bis(chlormethyl)-3',4'-bis(2-methylpropyloxy)biphenyl (Polymer P2):

### Herstellung von Poly(2-(3'-(3,7-dimethyloctyloxy)phenyl)-5-methoxy)-pphenylenvinylen)co(2-(3',4'-bis(2-methylpropyloxy))phenyl)-p-phenylenvinylen).

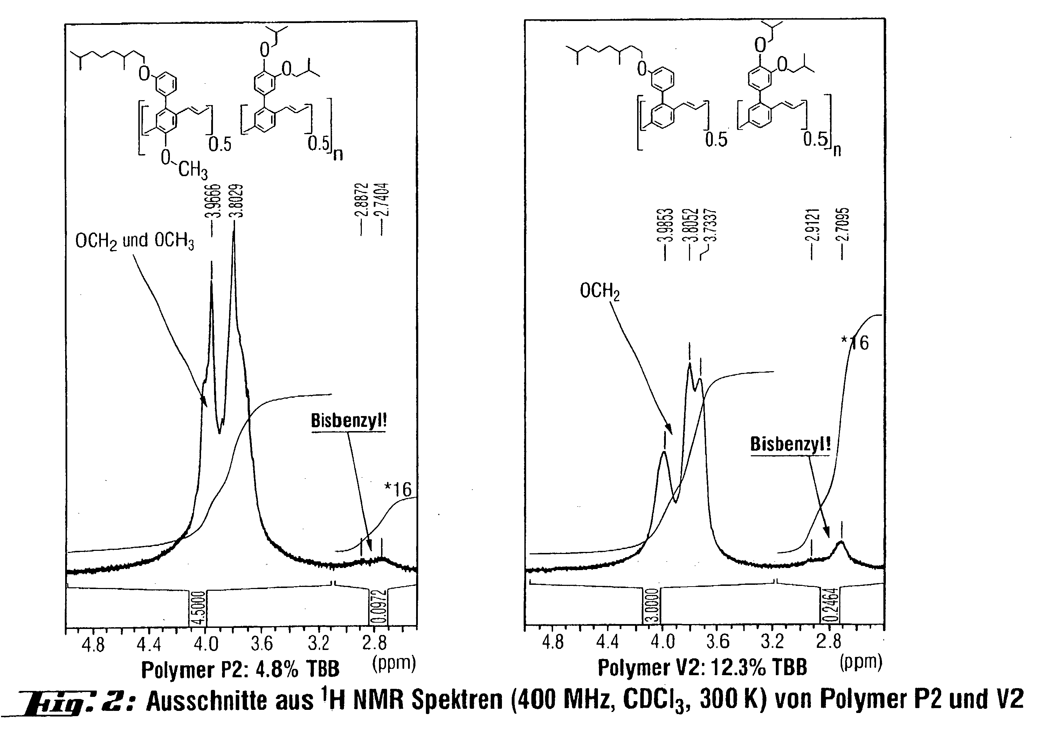

In einem ausgeheizten 6 L Vierhalskolben mit mechanischem Teflonrührer, Rückflußkühler, Thermometer und Tropftrichter wurden 3400 ml trockenes und O₂freies 1,4-Dioxan auf 99°C erhitzt. Dann wurde eine Lösung von 12.45 g (28.5 mmol) 2,5-Bis(chlormethyl)-4-methoxy-3'-(3,7-dimethyloctyloxy)biphenyl (Bsp. E2) und 11.25 g (28.5 mmol) 2,5-Bis(chlormethyl)-3',4'-bis(2-methylpropyloxy)biphenyl (Bsp. Z5) in 50 g trockenem 1,4-Dioxan zugesetzt. Nun wurde eine Lösung von 16.6g (148 mmol) Kalium-tert-butylat in 148 ml trockenem 1,4-Dioxan innerhalb von 5 Minuten zu der intensiv gerührten Mischung getropft. Die Farbe veränderte sich dabei von farblos über gelb nach gelb-orange. Nach 5 Minuten wurden weitere 15.4g (137 mmol) Kalium-tert-butylat, gelöst in 140 ml 1,4-Dioxan, zugegeben. Nach 2 Stunden Rühren bei 98-100°C wurde auf 50°C abgekühlt und ein Gemisch aus 33 ml Essigsäure und 35 ml 1,4-Dioxan wurde zugesetzt. Die nun orange Lösung wurde auf 3.8 L intensiv gerührtes Wasser gegossen. Das ausgefallene fasrige Polymer wurde durch Filtration durch einen Polypropylenfilter isoliert, zweimal mit Methanol gewaschen und im Vakuum getrocknet. Die Rohausbeute lag bei 15.33 g (78%).
Das Polymer wurde unter Erhitzen auf 60°C in 1.7 L THF gelöst und durch Zusatz der gleichen Menge Methanol bei 40°C gefällt. Nach Waschen mit Methanol und Trocknen im Vakuum wurde dieser Schritt wiederholt (1.2 L THF/1.2 L Methanol). Man erhielt nach Trocknung im Vakuum 8.68 g (= 25.3 mmol, 44%) des Polymer P2 als gelb-orange Fasern.
¹H NMR (400 MHz, CDCl₃): δ [ppm] = 7.7-6.5 (br. m, 8 H; Hₐᵣₒₘ, Olefin-H); 4.2-3.6 (br. m, 4.5 H; OCH3, OCH2); 2.8-2.7 ppm (br. m, Bisbenzyl), 2.1-0.6 (br. m, 19H; aliph. H).
Durch die Integration des Signals bei 2.8-2.7 ppm errechnete sich ein Gehalt an TBB Gruppen von 4.8%. Das ¹H NMR Spektrum von Polymer P2 ist in Abbildung 2 wiedergegeben.
GPC: THF + 0.25% Oxals.: Säulensatz SDV500, SDV1000, SDV10000 (Fa. PSS), 35°C, UV Detektion 254 nm, Polystyrol-Standard: M_{w} = 1.5×10⁶ g/mol, Mₙ = 2.8×10⁵ g/mol.

### Beispiel P3:

### Copolymer aus 75% 2,5-Bis(chlormethyl)-4-methoxy-3'-(3,7-dimethyloctyloxy)biphenyl und 25% 2,5-Bis(chlormethyl)-3',4'-bis(2-methylpropyloxy)biphenyl (Polymer P3):

### Herstellung von Poly(2-(3'-(3,7-dimethyloctyloxy)-5-methoxy)phenyl)-pphenylenvinylen)co(2-(3',4'-bis(2-methylpropyloxy))phenyl)-p-phenylenvinylen).

Analog Beispiel P2 wurden 2.62 g (6.00 mmol) 2,5-Bis(chlormethyl)-4-methoxy-3'-(3,7-dimethyloctyloxy)biphenyl und 0.79 g (2.00 mmol) 2,5-Bis(chlormethyl)-3',4'bis(2-methylpropyloxy)biphenyl in 540 ml trockenem 1,4-Dioxan polymerisiert. Nach zweimaliger Umfällung aus THF/MeOH erhielt man 1.30 g (= 46%) des Polymers P3 als feines oranges Pulver.
¹H NMR (400 MHz, CDCl₃): δ (ppm) = 7.7-6.5 (br. m, 8 H; Hₐᵣₒₘ, Olefin-H); 4.2-3.7 (br. m, 4.75 H; OCH₃, OCH₂); 2.8-2.7 ppm (br, Bisbenzyl), 2.1-0.6 (br. m, 17.75 H; aliph. H).
Durch die Integration des Signals bei 2.8-2.7 ppm errechnete sich ein Gehalt an TBB Gruppen von 1.8%)
GPC: THF + 0.25% Oxals.; Säulensatz SDV500, SDV1000, SDV10000 (Fa. PSS), 50°C, UV Detektion 254 nm, Polystyrol-Standard: M_{w} = 1.2×10⁶ g/mol, Mₙ = 1.8×10⁵ g/mol.

### Beispiel P4:

### Copolymer aus 25% 2,5-Bis(chlormethyl)-1,4-bis(3,7-dimethyloctyloxy)benzol und 75% 2,5-Bis(chlormethyl)-3'-(3,7-dimethyloctyloxy)- 4-methoxybiphenyl (Polymer P4):

### Herstellung von Poly(2,5-(3,7-dimethyloctyloxy)-p-phenylenvinylen)co(2-(4'-(3,7-dimethyloctyloxy)phenyl-5-methoxy)-p-phenylenvinylen).

Analog Beispiel P1 wurden 0.97 g (2.00 mmol) 2,5-Bis(chlormethyl)-1,4-bis(3',7'dimethyloctyloxy)benzol und 2.62 g (6.00 mmol) 2,5-Bis(chlormethyl)-3'-(3,7-dimethyloctyloxy)-4-methoxybiphenyl in 590 g 1,4-Dioxan polymerisiert. Die Reinigung wurde durch zweimaliges Lösen in 300 ml Chlorbenzol (110°) und Fällen mit Ethylenglycol bewerkstelligt. Man erhielt 1.50 g (50%) Polymer P4 als orange Flocken.
¹H NMR (400 MHz, C₂D₂Cl₄, 363K): δ (ppm) = 8.0-6.8 (br. m, 6.5 H; Hₐᵣₒₘ, H_{Olefin}); 4.4-3.7 (br. m, 4.75 H, OCH₃, OCH₂); 2.7 (br. s, Bisbenzyl); 2.0-0.9 (br. m, 23.75 H). Die Integration des Signals bei 2.7 ppm ergab einen TBB Gehalt von 1.0%.

### Beispiel P5:

### Quarternäres Copolymer aus 25% 2,5-Bis(chlormethyl)-1-methoxy-4-(3,7-dimethyloctyloxy)benzol, 25% 2,5-Bis(chlormethyl)-1,4-bis(3,7-dimethyloctyloxy)benzol, 25% 2,5-Bis(chlormethyl)-3'-(3,7-dimethyloctyloxy)biphenyl und 25% 2,5-Bis(chlormethyl)-4-methoxy-3'-(3,7-dimethyloctyloxy)biphenyl (Polymer P5):

### Herstellung von Poly(2-methoxy-5-(3,7-dimethyloctyloxy)-p-phenylenvinylen)co(2-(3'-(3,7-dimethyloctyloxy)phenyl)-p-phenylenvinylen)co(2,5-bis(3,7-dimethyloctyloxy)-p-phenylenvinylen)co(5-methoxy-2-(3'-(3,7-dimethyloctyloxy)phenyl) -p-phenylenvinylen)

In einem trockenen 1 L Vierhalskolben mit mechanischem Rührer, Rückflußkühler, Thermometer und Tropftrichter wurden 600 g trockenes und O₂-freies 1,4-Dioxan vorgelegt und unter Rühren auf 98°C erhitzt. Dann wurden (723 mg) 2,5-Bis(chlormethyl)-1-methoxy-4-(3,7-dimethyloctyloxy)benzol, (975 mg) 2,5-Bis(chlormethyl)-1,4-bis(3,7-dimethyloctyloxy)benzol, (815 mg) 2,5-Bis(chlormethyl)-3'-(3,7-dimethyloctyloxy)biphenyl und (875 mg) 2,5-Bis(chlormethyl)-4-methoxy-3'-(3,7-dimethyloctyloxy)biphenyl (je 2 mmol), gelöst in 50 ml trockenem 1,4-Dioxan, zugesetzt. Dann wurde eine Lösung von 2.36 g (21 mmol) Kalium-tert-butylat in 21 ml trockenem 1,4-Dioxan innerhalb von 5 Minuten zu der intensiv gerührten Mischung getropft. Die Viskosität der Lösung nahm leicht zu. Nach 5 Minuten Rühren bei 98°C wurden nochmals 1.79 g (16 mmol, 2.0 eq) Kalium-tert-butylat in 16 ml 1,4-Dioxan innerhalb von einer Minute zugesetzt. Nach weiteren 2 Stunden Rühren bei 97°-98°C wurde auf 45°C abgekühlt und ein Gemisch aus 2.2 ml Essigsäure und 2.2 ml 1,4-Dioxan wurden zugesetzt. Das Polymer wurde nach 20 Minuten Nachrühren durch Zusetzen der Reaktionslösung zu 1 L intensiv gerührtem Wasser ausgefällt. Das so erhaltene Polymer wurde abfiltriert und zweimal mit je 100 ml Methanol gewaschen. Nach Vakuumtrocknung bei Raumtemperatur wurden 1.71 rohes Polymer erhalten.
Das Rohprodukt wurde unter Erhitzen auf 60°C in 200 ml THF gelöst und durch Zusatz von 200mL Methanol gefällt. Nach Trocknen im Vakuum und Waschen mit 100 ml Methanol wurde dieser Schritt wiederholt (200 ml THF/200 ml Methanol). Man erhielt nach zweitägiger Trocknung im Vakuum 1.13 g (= 3.2 mmol, 40 %) des Polymer P5 als hell-orange Fasern.
¹H NMR (400 MHz, CDCl₃): δ (ppm) = 7.9-6.6 (br. m; ca 9 H); 4.2-3.7 (br. s, 4 H); 2.9-2.8 (br. m, Bisbenzyl); 1.9-0.8 (br. m, ca. 19 H). Die Integration des Signals bei 2.9-2.8 ppm ergab einen TBB Gehalt von 4.7 ppm.
GPC: THF + 0.25% Oxals.; Säulensatz SDV500, SDV1000, SDV10000 (Fa. PSS), 35°C, UV Detektion 254 nm, Polystyrol-Standard: Mw = 1.0×10⁶ g/mol, Mn = 1.9×10⁵ g/mol.

### Beispiel P6:

### Copolymer aus 50% 2,5-Bis(chlormethyl)-3',4'-bis(2-methylpropyloxy)biphenyl und 50% 2,5-Bis(chlormethyl)-4-methoxy-3',4'-bis(2-methylpropyloxy)biphenyl (Polymer P6):

### Herstellung von Poly[2-(3',4'-bis(2-methylpropyloxy))-phenyl-p-phenylenvinylen]co[2-(3',4'-bis(2-methylpropyloxy)phenyl)-5-methoxy-p-phenylenvinylen].

Analog Beispiel P2 wurden 11.42 g (28.9 mmol) 2,5-Bis(chlormethyl)-3',4'-bis(2-methylpropyloxy)biphenyl (Bsp. Z5) und 12.28 g (28.9 mmol) 2,5-Bis(chlormethyl)-4-methoxy-3',4'-bis(2-methylpropyloxy)biphenyl (Bsp. E3) in 3400 ml trockenem 1,4-Dioxan polymerisiert. Nach zweimaliger Umfällung aus THF/MeOH erhielt man 10.5 g (= 53%) des Polymers P6 als gelbe Fasern.
¹H NMR (400 MHz, CDCl₃): δ [ppm] = 7.6-6.5 (br. m, 7.5 H; Hₐᵣₒₘ, Olefin-H); 4.1-3.7 (br. m, 5.5 H; OCH₃, OCH₂); 2.8-2.7 ppm (br. m, Bisbenzyl), 2.1 (br. s, 2H, CH), 1.2-0.8 (br. m, 12 H; aliph. H).
Durch die Integration des Signals bei 2.8-2.7 ppm errechnete sich ein Gehalt an TBB Gruppen von 4.4%)
GPC: THF + 0.25% Oxals.; Säulensatz SDV500, SDV1000, SDV10000 (Fa. PSS), 50°C, UV Detektion 254 nm, Polystyrol-Standard: M_{w} = 1.1×10⁶ g/mol, Mₙ = 2.5×10⁵ g/mol.

### Beispiel P7:

### Copolymer aus 50% 2,5-Bis(chlormethyl)-4-methoxy-3'-(3,7-dimethyloctyloxy)biphenyl und 50% 2,5-Bis(chlormethyl)- 3'-(3,7-dimethyloctyloxy)biphenyl (Polymer P7):

### Herstellung von Poly[2-(3'-(3,7-dimethyloctyloxy))phenyl-5-methoxy-pphenylenvinylen]co[2-(3'-(3,7-dimethyloctyloxy))-phenyl-p-phenylenvinylen].

Analog Beispiel P2 wurden 12.45 g (28.5 mmol) 2,5-Bis(chlormethyl)-4-methoxy-3'-(3,7-dimethyloctyloxy)biphenyl (Bsp. E2) und 11.60 g (28.5 mmol) 2,5-Bis(chlormethyl)-3'-(3,7-dimethyloctyloxy)biphenyl (Bsp. Z3) in 3400 ml trockenem 1,4-Dioxan bei 98°C polymerisiert. Nach zweimaliger Umfällung aus THF/MeOH erhielt man 8.7 g (= 44%) des Polymers P7 als gelbe Fasern.
¹H NMR (400 MHz, CDCl₃): δ [ppm] = 7.8-6.5 (br. m, 8.5 H; Hₐᵣₒₘ, Olefin-H); 4.1-3.6 (br. m, 3.5 H; OCH₃, OCH₂); 3.0-2.7 ppm (br. m, Bisbenzyl); 1.9-0.8 (br. m, 19 H; aliph. H).
Durch die Integration des Signals bei 3.0-2.7 ppm errechnete sich ein Gehalt an TBB Gruppen von 4.6%)
GPC: THF + 0.25% Oxals.; Säulensatz SDV500, SDV1000, SDV10000 (Fa. PSS), 50°C, UV Detektion 254 nm, Polystyrol-Standard: M_{w} = 1.0×10⁶ g/mol, Mₙ = 2.4×10⁵ g/mol.

### Beispiel P8:

### Copolymer aus 50% 2,5-Bis(chlormethyl)-3'-(3,7-dimethyloctyloxy)biphenyl und 50% 2,5-Bis(chlormethyl)-4-methoxy-3',4'-bis(2-methylpropyloxy)biphenyl (Polymer P8):

### Herstellung von Poly[(2-(3'-(3,7-dimethyloctyloxy))phenyl-p-phenylenvinylen)co(2-(3',4'-bis(2-methylpropyloxy))phenyl-5-methoxy-p-phenylenvinylen].

Analog Beispiel P2 wurden 11.60 g (28.5 mmol) 2,5-Bis(chlormethyl)-3'-(3,7-dimethyloctyloxy)biphenyl (Bsp. Z3) und 12.11 g (28.5 mmol) 2,5-Bis(chlormethyl)-4-methoxy-3',4'-bis(2-methylpropyloxy)biphenyl (Bsp. E3) in 3400 ml trockenem 1,4-Dioxan bei 99°C polymerisiert. Nach zweimaliger Umfällung aus THF/MeOH erhielt man 8.13 g (= 42%) des Polymers P8 als feine Polymerfasern.
¹H NMR (400 MHz, CDCl₃): δ [ppm] = 7.9-6.6 (br. m, 8 H; Hₐᵣₒₘ, Olefin-H); 4.1-3.6 (br. m, 4.5 H; OCH₃, OCH₂); 2.9-2.6 ppm (br. m, Bisbenzyl); 2.13 (br. s, 1 H, CH); 1.9-0.8 (br. m, 15.5 H; aliph. H).
Durch die Integration des Signals bei 2.9-2.6 ppm errechnete sich ein Gehalt an TBB Gruppen von 5.0%)
GPC: THF + 0.25% Oxals.; Säulensatz SDV500, SDV1000, SDV10000 (Fa. PSS), 50°C, UV Detektion 254 nm, Polystyrol-Standard: M_{w} = 1.3×10⁶ g/mol, Mₙ = 2.3×10⁵ g/mol.

### Beispiel P9:

### Copolymer aus 50% 2,5-Bis(chlormethyl)-3'-(3,7-dimethyloctyloxy)biphenyl und 50% 2,5-Bis(chlormethyl)-4-fluor-3',4'-bis(2-methylpropyloxy)biphenyl (Polymer P9):

### Herstellung von Poly[(2-(3'-(3,7-dimethyloctyloxy))phenyl-p-phenylenvinylen)co(2-(3',4'-bis(2-methylpropyloxy))phenyl-5-fluor-p-phenylenvinylen)].

Analog Beispiel P2 wurden 5.80 g (14.23 mmol) 2,5-Bis(chlormethyl)-3'-(3,7-dimethyloctyloxy)biphenyl (Bsp. Z3) und 5.88 g (14.23 mmol) 2,5-Bis(chlormethyl)-4-fluor-3',4'-bis(2-methylpropyloxy)biphenyl (Bsp. E7) in 3200 ml trockenem 1,4-Dioxan bei 98°C polymerisiert. Nach zweimaliger Umfällung aus THF/MeOH erhielt man 8.13 g (= 42%) des Polymers P9 als gelbes Pulver.
¹H NMR (400 MHz, CDCl₃): δ [ppm] = 8.0-6.6 (br. m, 8 H; Hₐᵣₒₘ, Olefin-H); 4.2-3.6 (br. m, 3 H; OCH₃, OCH₂); 3.0-2.6 ppm (br. m, Bisbenzyl); 2.1 (br. s, 1H, CH); 1.9-0.8 (br. m, 15.5 H; aliph. H).
Durch die Integration des Signals bei 3.0-2.6 ppm errechnete sich ein Gehalt an TBB Gruppen von 8.5%)
GPC: THF + 0.25% Oxals.; Säulensatz SDV500, SDV1000, SDV10000 (Fa. PSS), 50°C, UV Detektion 254 nm, Polystyrol-Standard: M_{w} = 9.5×10⁵ g/mol, Mₙ = 1.1 ×10⁵ g/mol.

### Beispiel P10:

### Copolymer aus 40% 2,5-Bis(chlormethyl)-4-chloro-4'-(3,7-dimethyloctyloxy)biphenyl und 60% 2,5-Bis(chlormethyl)-3',4'-bis(2-methylpropyloxy)biphenyl (Polymer P10):

### Herstellung von Poly[(2-(4'-(3,7-dimethyloctyloxy)phenyl)-5-chloro-pphenylenvinylen)co(2-(3',4'-bis(2-methylpropyloxy))phenyl-p-phenylenvinylen)].

Analog Beispiel P2 wurden 2.83 g (6.4 mmol) 2,5-Bis(chlormethyl)-4-chloro-4'-(3,7-dimethyloctyloxy)biphenyl (Bsp. E8) und 3.79 g (9.6 mmol) 2,5-Bis(chlormethyl)-3',4'-bis(2-methylpropyloxy)biphenyl (Bsp. Z5) in 1100 ml trockenem 1,4-Dioxan bei 98°C polymerisiert. Nach zweimaliger Umfällung aus Chlorbenzol/MeOH erhielt man 1.6 g (= 42%) des Polymers P10 als gelbes Pulver.
¹H NMR (400 MHz, CDCl₃): δ [ppm] = 8.0-6.6 (br. m, 8 H; Hₐᵣₒₘ, Olefin-H); 4.1-3.6 (br. m, 3.2 H; OCH₃, OCH₂); 3.0-2.7 ppm (br. m, Bisbenzyl); 2.2 (br. s, 1H, CH); 1.9-0.8 (br. m, 15 H; aliph. H).
Durch die Integration des Signals bei 3.0-2.7 ppm errechnete sich ein Gehalt an TBB Gruppen von 9.5%.

### Beispiel P11:

### Copolymer aus 50 % 1,4-Bis(chlormethyl)-2-(3,7-dimethyloctyloxy)-5-methoxybenzol, 30% 2,5-Bis(chlormethyl)-4-methoxy-3'-(3,7-dimethyloctyloxy)biphenyl und 20% 2,5-Bis(chlormethyl)-3'-(3,7-dimethyloctyloxy)biphenyl (Polymer P11):

### Herstellung von Poly[2-methoxy-5-(3,7-dimethyloctyloxy)-p-phenylenvinylen]co[2-(3'-(3,7-dimethyloctyloxy)phenyl)-5-methoxy-p-phenylenvinylen]co[2-(3'-(3,7'dimethyloctyloxy))-phenyl-p-phenylenvinylen].

Analog Beispiel P2 wurden 7.47 g (28.5 mmol) 1,4-Bis(chlormethyl)-2-(3,7-dimethyloctyloxy)-5-methoxybenzol (Bsp. Z1), 6.22 g (17.1 mmol) 2,5-Bis(chlormethyl)-4-methoxy-3'-(3,7-dimethyloctyloxy)biphenyl (Bsp. E2) und 4.64 g (11.4 mmol) 2,5-Bis(chlormethyl)-3'-(3,7-dimethyloctyloxy)biphenyl (Bsp. Z3) in 3450 ml trockenem 1,4-Dioxan bei 98-100°C polymerisiert. Nach zweimaliger Umfällung aus THF/MeOH erhielt man 7.9 g (= 43%) des Polymers P11 als orange-rote Fasern.
¹H NMR (400 MHz, CDCl₃): δ [ppm] = 7.7-6.4 (br. m, 6.2 H; Hₐᵣₒₘ, Olefin-H); 4.1-3.6 (br. m, 4.4 H; OCH₃, OCH₂); 3.0-2.8 ppm (br. m, Bisbenzyl); 1.9-0.8 (br. m, 19 H; aliph. H).
Durch die Integration des Signals bei 3.0-2.8 ppm errechnete sich ein Gehalt an TBB Gruppen von 3.3%.
GPC: THF + 0.25% Oxals.; Säulensatz SDV500, SDV1000, SDV10000 (Fa. PSS), 50°C, UV Detektion 254 nm, Polystyrol-Standard: M_{w} = 1.0×10⁶ g/mol, Mₙ = 2.4×10⁵ g/mol.

### Beispiel P12:

### Copolymer aus 25% 2,5-Bis(chlormethyl)-3'-(3,7-dimethyloctyloxy)biphenyl, 25% 2,5-Bis(chlormethyl)-4-methoxy-3'-(3,7-dimethyloctyloxy)biphenyl, 25% 2,5-Bis(chlormethyl)-4-methoxy-3',4'-bis(2-methylpropyloxy)biphenyl und 25% 2,5-Bis(chlormethyl)-3',4'-bis(2-methylpropyloxy)biphenyl (Polymer P12):

Analog Beispiel P2 wurden 5.80 g (14.2 mmol) 2,5-Bis(chlormethyl)-3'-(3,7-dimethyloctyloxy)biphenyl (Bsp. Z3), 6.22 g (14.2 mmol) 2,5-Bis(chlormethyl)-4-methoxy-3'-(3,7-dimethyloctyloxy)biphenyl (Bsp. E2), 6.05 g (14.2 mmol) 2,5-Bis(chlormethyl)-4-methoxy-3',4'-bis(2-methylpropyloxy)biphenyl (Bsp. E3) und 5.63 g (14.2 mmol) 2,5-Bis(chlormethyl)-3',4'-bis(2-methylpropyloxy)biphenyl (Bsp. Z5) in 3400 ml trockenem 1,4-Dioxan bei 99°C polymerisiert. Nach Neutralisation, Fällung und zweimaliger Umfällung aus THF/MeOH erhielt man 9.12 g (47%) des Polymers P12 als feine gelbe Fasern.
¹H NMR (400 MHz, CDCl₃): δ [ppm] = 7.7-6.5 (br. m, 8 H; Hₐᵣₒₘ, Olefin-H); 4.1-3.6 (br. m, 4.5 H; OCH₃, OCH₂); 2.9-2.6 ppm (br. m, Bisbenzyl); 2.14 (br. s, 1H, CH); 1.9-0.8 (br. m, 15.5 H; aliph. H).
Durch die Integration des Signals bei 2.9-2.6 ppm errechnete sich ein Gehalt an TBB Gruppen von 6.0%.
GPC: THF + 0.25% Oxals.; Säulensatz SDV500, SDV1000, SDV10000 (Fa. PSS), 50°C, UV Detektion 254 nm, Polystyrol-Standard: M_{w} = 1.1×10⁶ g/mol, Mₙ = 1.8×10⁵ g/mol.

### Beispiel P13:

### Copolymer aus 50% 2,5-Bis(chlormethyl)-3'-(3,7-dimethyloctyloxy)biphenyl und 50% von 2,5-Bischlormethyl-4-(3,7-dimethyloctyloxy)-biphenyl (Polymer P13):

### Herstellung von Poly[(2-(3'-(3,7-dimethyloctyloxy))phenyl-p-phenylenvinylen)co(2-phenyl-5-(3,7-dimethyloctyloxy)-p-phenylenvinylen)].

Analog Beispiel P2 wurden 8.85 g (21.7 mmol) 2,5-Bis(chlormethyl)-3'-(3,7-dimethyloctyloxy)biphenyl (Bsp. Z3) und 8.85 g (21.7 mmol) 2,5-Bischlormethyl-4-(3,7-dimethyloctyloxy)-biphenyl (Bsp. E9) in 2250 g trockenem 1,4-Dioxan bei 99°C polymerisiert. Nach zweimaliger Umfällung aus THF/MeOH erhielt man 7.6 g (= 52%) des Polymers P13 als gelbes Pulver.
¹H NMR (400 MHz, CDCl₃): δ [ppm] = 7.7-6.6 (br. m, 9 H; Hₐᵣₒₘ, Olefin-H); 4.4-3.6 (br. m, 2 H; OCH₃, OCH₂); 2.9-2.6 ppm (br. m, Bisbenzyl); 1.9-0.8 (br. m, 19 H; aliph. H).
Durch die Integration des Signals bei 2.9-2.6 ppm errechnete sich ein Gehalt an TBB Gruppen von 7.0%.
GPC: THF + 0.25% Oxals.; Säulensatz SDV500, SDV1000, SDV10000 (Fa. PSS), 50°C, UV Detektion 254 nm, Polystyrol-Standard: M_{w} = 1.1×10⁶ g/mol, Mₙ = 1.3×10⁵ g/mol.

### Beispiel P14:

### Copolymer aus 50% 2,5-Bis(chlormethyl)-3',4'-bis(2-methylpropyloxy)biphenyl und 50% 2,5-Bis(chlormethyl) -3'-(3,7-dimethyloctyloxy)-4-fluor-biphenyl (Polymer P14):

### Herstellung von Poly[(2-(3',4'-bis(2-methylpropyloxy)phenyl)-p-phenylenvinylen)co(2-(3'-(3,7-dimethyloctyloxy))phenyl-5-fluor-p-phenylenvinylen)].

Analog Beispiel P2 wurden 3.26 g (8.25 mmol) 2,5-Bis(chlormethyl)-3',4'-bis(2-methylpropyloxy)biphenyl (Bsp. Z5) und 3.51 g (8.25 mmol) 2,5-Bis(chlormethyl)-4-fluor-3',4'-bis(2-methylpropyloxy)biphenyl (Bsp. E6) in 1000 ml trockenem 1,4-Dioxan bei 98°C polymerisiert. Nach zweimaliger Umfällung aus THF/MeOH erhielt man 3.3 g (= 59%) des Polymers P14 als gelbes Pulver.
¹H NMR (400 MHz, CDCl₃): δ [ppm] = 7.9-6.5 (br. m, 8 H; Hₐᵣₒₘ, Olefin-H); 4.2-3.5 (br. m, 3 H; OCH₃, OCH₂); 2.9-2.5 ppm (br. s, Bisbenzyl); 2.2-0.8 (br. m, 16.5 H; aliph. H).
Durch die Integration des Signals bei 2.9-2.5 ppm errechnete sich ein Gehalt an TBB Gruppen von 8.5%.
¹⁹F NMR (376 MHz, CDCl₃): δ [ppm] = 120 (br. m); durch interne Referenz (C₆F₆) konnte bestimmt werden, daß der Anteil der Fluor-haltigen Gruppen 50% beträgt.
GPC: THF + 0.25% Oxals.; Säulensatz SDV500, SDV1000, SDV10000 (Fa. PSS), 50°C, UV Detektion 254 nm, Polystyrol-Standard: M_{w} = 1.05×10⁶ g/mol, Mₙ = 1.9 × 10⁵ g/mol.

### Beispiel P15:

### Copolymer aus 50% 2,5-Bis(chlormethyl)-3'-(3,7-dimethyloctyloxy)biphenyl und 50% von 2,5-Bischlormethyl-4,2',5'-trimethoxybiphenyl (Polymer P15):

### Herstellung von Poly[(2-(3'-(3,7-dimethyloctyloxy))phenyl)-p-phenylenvinylen)co(2-(2',5'-dimethoxy)phenyl)-5-methoxy-p-phenylenvinylen].

Analog Beispiel P2 wurden 3.36 g (8.25 mmol) 2,5-Bis(chlormethyl)-3'-(3,7-dimethyloctyloxy)biphenyl (Bsp. Z3) und 2.82 g (8.25 mmol) 2,5-Bis(chlormethyl)-4,2',5'-trimethoxybiphenyl (Bsp. E4) in 1000 ml trockenem 1,4-Dioxan bei 98-100°C polymerisiert. Nach zweimaliger Umfällung aus THF/MeOH erhielt man 1.95 g (= 54%) des Polymers P 15 als gelbes Pulver.
¹H NMR (400 MHz, CDCl₃): δ [ppm] = 7.6-6.6 (br. m, 8 H; Hₐᵣₒₘ, Olefin-H); 4.4-3.6 (br. m, 5.5 H; OCH₃, OCH₂); 2.9-2.6 ppm (br. s, Bisbenzyl); 2.0-0.8 (br. m, 9.5 H; aliph. H).
Durch die Integration des Signals bei 2.9-2.6 ppm errechnete sich ein Gehalt an TBB Gruppen von 5.5%.
¹⁹F NMR (376 MHz, CDCl₃): δ [ppm] = 116 (br. s); durch interne Referenz (C₆F₆) konnte bestimmt werden, daß der Anteil der Fluor-haltigen Gruppen 50% beträgt. GPC: THF + 0.25% Oxals.; Säulensatz SDV500, SDV1000, SDV10000 (Fa. PSS), 50°C, UV Detektion 254 nm, Polystyrol-Standard: M_{w} = 1.0×10⁶ g/mol, Mₙ = 1.9×10⁵ g/mol.

### Beispiel P16:

### Copolymer aus 30% 2,5-Bis(chlormethyl)-3'-(3,7-dimethyloctyloxy)biphenyl, 30% 2,5-Bis(chlormethyl)-3',4'-bis(2-methylpropyloxy)biphenyl und 40% 2,5-Bis(chlormethyl)-4-methoxy-2',5'-dimethylbiphenyl (Polymer P16)

Analog Beispiel P2 wurden 6.96 g (16.6 mmol) 2,5-Bis(chlormethyl)-3'-(3,7-dimethyloctyloxy)biphenyl (Bsp. Z3), 6.75 (16.6 mmol) 2,5-Bis(chlormethyl)-3',4'bis(2-methylpropyloxy)biphenyl (Bsp. Z5) und 7.04 g (22.1 mmol) 2,5-Bis(chlormethyl)-4-methoxy-2',5'-dimethylbiphenyl (Bsp. E5) in 3400 ml trockenem 1,4-Dioxan bei 98°C polymerisiert. Nach zweimaliger Umfällung aus THF/MeOH erhielt man 6.70 g (= 40%) des Polymers P16 als grün-gelbe Fasern.
¹H NMR (400 MHz, CDCl₃): δ [ppm] = 7.8-6.6 (br. m, 7.9 H; Hₐᵣₒₘ, Olefin-H); 4.2-3.6 (br. m, 3 H; OCH₃, OCH₂); 2.9-2.7 ppm (br. s, Bisbenzyl); 2.4-0.8 (br. m, 12.3 H; aliph. H).
Durch die Integration des Signals bei 2.9-2.7 ppm errechnete sich ein Gehalt an TBB Gruppen von 4.0%.
GPC: THF + 0.25% Oxals.; Säulensatz SDV500, SDV1000, SDV10000 (Fa. PSS), 50°C, UV Detektion 254 nm, Polystyrol-Standard: M_{w} = 1.2×10⁶ g/mol, Mₙ = 2.7×10⁵ g/mol.

### Beispiel P17:

### Copolymer aus 50% 2,5-Bis(chlormethyl)-3'-(3,7-dimethyloctyloxy)biphenyl und 50% 2,5-Bis(chlormethyl)-4-methoxy-3',5'-bisfluorbiphenyl (Polymer P9):

### Herstellung von Poly[(2-(3'-(3,7-dimethyloctyloxy))phenyl)-p-phenylenvinylen)co(2-3',5'-difluorphenyl-5-methoxy-p-phenylenvinylen)].

Analog Beispiel P2 wurden 4.27 g (10.5 mmol) 2,5-Bis(chlormethyl)-3'-(3,7-dimethyloctyloxy)biphenyl (Bsp. Z3) und 3.35 g (10.5 mmol) 2,5-Bis(chlormethyl)-4-methoxy-3',5'-bisfluorbiphenyl (Bsp. E10) in 2500 ml trockenem 1,4-Dioxan bei 98°C polymerisiert. Nach zweimaliger Umfällung aus THF/MeOH erhielt man 2.99 g (= 49%) des Polymers P9 als gelbes Pulver.
¹H NMR (400 MHz, CDCl₃): δ [ppm] = 8.1-6.6 (br. m, 8 H; Hₐᵣₒₘ, Olefin-H); 4.2-3.6 (br. m, 2.5 H; OCH₃, OCH₂); 3.0-2.6 ppm (br. s, Bisbenzyl); 2.1 (br. s, 1H, CH); 1.9-0.8 (br. m, 9.5 H; aliph. H).
Durch die Integration des Signals bei 3.0-2.6 ppm errechnete sich ein Gehalt an TBB Gruppen von 4.5%.
GPC: THF + 0.25% Oxals.; Säulensatz SDV500, SDV1000, SDV10000 (Fa. PSS), 50°C, UV Detektion 254 nm, Polystyrol-Standard: M_{w} = 9×10⁵ g/mol, Mₙ = 1.8 ×10⁵ g/mol.

### V. Synthese von nicht erfindungsgemäßen Vergleichsbeispielen:

### Beispiel V1:

### Copolymer aus 50% 2,5-Bis(chlormethyl)-1-methoxy-4-(3,7-dimethyloctyloxy)benzol und 50% 2,5-Bis(chlormethyl)-3'-(3,7-dimethyloctyloxy)biphenyl (Polymer V1):

### Herstellung von Poly(2-methoxy-5-(3,7-dimethyloctyloxy)-p-phenylenvinylen)co-(2-(3'-(3,7-dimethyloctyloxy)phenyl)-p-phenylenvinylen)

In einem trockenen 6 L Vierhalskolben mit mechanischem Rührer, Rückflußkühler, Thermometer und Tropftrichter wurden 3.5 L trockenes und O₂-freies 1,4-Dioxan vorgelegt und unter Rühren auf 95°C erhitzt. Dann wurden 9.00 g (24.9 mmol) 2,5-Bis(chlormethyl)-1-methoxy-4-(3,7-dimethyloctyloxy)benzol und 10.13 g (24.9 mmol) 2,5-Bis(chlormethyl)-3'-(3,7-dimethyloctyloxy)biphenyl, gelöst in 30 ml trockenem 1,4-Dioxan, zugesetzt. Nun wurde eine Lösung von 13.97 g (124.5 mmol, 2.5 eq) Kalium-*tert*-butylat in 125 ml trockenem 1,4-Dioxan innerhalb von 5 Minuten zu der intensiv gerührten Mischung getropft. Die Farbe veränderte sich dabei von farblos über gelb nach orangerot. Nach 5 Minuten Rühren bei 95-96°C wurde nochmals dieselbe Menge (13.97 g, 124.5 mmol, 2.5 eq) Kalium-tert-butylat in 125 ml 1,4-Dioxan innerhalb von einer Minute zugesetzt. Nach weiteren 2 Stunden Rühren bei 95°-97°C wurde auf 55°C abgekühlt und ein Gemisch aus 30 ml Essigsäure und 30 ml 1,4-Dioxan zugesetzt. Zu der nun hell-orangen Lösung wurden unter intensivem Rühren 1.8 L Wasser innerhalb von 5 Minuten zugegeben. Das ausgefallene Polymer wurde abfiltriert und zweimal mit je 100 ml Methanol gewaschen. Nach Vakuumtrocknung wurden 14.1 g rohes Polymer erhalten.

Das Rohprodukt wurde unter Erhitzen auf 60°C in 1.8 L THF gelöst und durch Zusatz von 2 L Methanol gefällt. Nach Trocknen im Vakuum und Waschen mit 200 ml Methanol wurde dieser Schritt wiederholt. Man erhielt nach zweitägiger Trocknung im Vakuum 10.80 g (= 34.7 mmol, 70%) des Polymer V1 als hell-orange Fasern.
¹H NMR (400 MHz, CDCl₃): (ppm) = 7.9-6.6 (br. m; 6.5 H); 4.2-3.6 (br. m, 3.5 H); 3.0-2.6 (br. M; 7.2% Bisbenzyl); 2.0-0.95 (br. m, 10H); 0.86, 0.84 (2 s, 9H).
GPC: THF + 0.25% Oxalsäure; Säulensatz SDV500, SDV1000, SDV10000 (Fa. PSS), 35°C, UV Detektion 254 nm, Polystyrol-Standard: M_{w} = 7.4×10⁵ g/mol, Mₙ = 7×10⁴ g/mol.
Das ¹H-NMR Spektrum von Polymer V1 ist in Abbildung 1 wiedergegeben.

### Beispiel V2:

### Copolymer aus 50% 2,5-Bis(chlormethyl)-3'-(3,7-dimethyloctyloxy)biphenyl und 50% 2,5-Bis(chlormethyl)-3',4'-bis(2-methylpropyloxy)biphenyl (Polymer V2):

### Herstellung von Poly(2-(3'-(3,7-dimethyloctyloxy)phenyl)-p-phenylenvinylen)co(2-(3',4'-2-methylpropyloxy)phenyl)-p-phenylenvinylen).

In einem ausgeheitzten 1 L Vierhalskolben mit mechanischem Teflonrührer, Intensivkühler, Thermometer und Tropftrichter wurden 600 ml trockenes 1,4-Dioxan vorgelegt, durch 15 minütiges Durchleiten von N₂ wurde entgast und dann wurde unter Rühren zum gelinden Rückfluß (99°C) erhitzt. Anschließend wurden 1.63 g (4.00 mmol) 2,5-Bis(chlormethyl)-3'-(3,7-dimethyloctyloxy)biphenyl und 1.58 g (4.00 mmol), gelöst in 20 ml trockenem 1,4-Dioxan, zugesetzt. Nun wurde eine Lösung von 2.36 g (21 mmol, 2.6 eq) Kalium-tert-butylat in 21 ml getrocknetem 1,4-Dioxan innerhalb von 5 Minuten zu der intensiv gerührten Mischung getropft. Während der Zugabe der Base wurde folgender Farbumschlag beobachtet: farblos―gelb-gelbgrün. Nach weiteren 5 Minuten Rühren bei dieser Temperatur wurden nochmals 1.80 g (16 mmol, 2.0 eq) Kalium-tert-butylat in 16 ml trockenem 1,4-Dioxan innerhalb von einer Minute zugesetzt. Die Temperatur wurde weitere 2 Stunden bei 98-99°C gehalten; nach dieser Zeit wurde auf 45°C abgekühlt und ein Gemisch aus 2.5 ml Essigsäure und 2.5 ml 1,4-Dioxan wurde zugesetzt. Die Farbe der Reaktionsmischung hellt sich dabei etwas auf und die Viskosität stieg. Nach 20 Minuten Rühren wurde die Reaktionsmischung auf 0.65 L intensiv gerührtes Wasser gegossen. Es wurde mit 100 ml Methanol versetzt und noch 20 Minuten gerührt. Nach Filtration über einen Polypropylenrundfilter, zweimaligem Nachwaschen mit Methanol und Vakuumtrocknung erhält man 1.30 g (3.93 mmol, 49%) rohes Polymer als gelbe Fasern.

Nach Trocknung im Vakuum bei Raumtemperatur erfolgt die Reinigung durch zweimaliges Lösen in je 100 ml THF und Ausfällen mit je 100 ml Methanol. Nach Trocknen erhielt man 0.99 g (3.00 mmol, 38%) Polymer V2 als gelbe Fasern.
¹H NMR (400 MHz, CDCl₃): δ (ppm) = 7.8-6.5, darunter br. s bei 6.9 (br. m; 8.8 H);4.0 (br. s, 1.6 H); 3.0-2.6 ppm (br. m, 12% Bisbenzyl); 2.3 (br. s, 0.6 H, CH₃); 2.0 (br. s, 0.6 H, CH₃); 1.8, 1.65, 1.55, 1.3, 1.15 (5 x s, zus. 8 H; alkyl-H); 0.91, 0.85 (2 x s, 7.2H; 3 x CH₃).
GPC: THF + 0.25% Oxals.; Säulensatz SDV500, SDV1000, SDV10000 (Fa. PSS), 35°C, UV Detektion 254 nm, Polystyrol-Standard: M_{w} = 1.8×10⁶ g/mol, Mₙ = 3.9×10⁵ g/mol.
Das ¹H-NMR Spektrum von Polymer V2 ist in Abbildung 2 wiedergegeben.

### Beispiel V3:

### Copolymer aus 50% 2,5-Bis(chlormethyl)-1-methoxy-4-(3,7-dimethyloctyloxy)benzol und 50% 2,5-Bis(chlormethyl)-4'-(3,7-dimethyloctyloxy)biphenyl (Polymer V3):

### Herstellung von Poly(2-methoxy-5-(3,7-dimethyloctyloxy)-p-phenylenvinylen) co-(2-(4'-(3,7-dimethyloctyloxy)phenyl)-p-phenylenvinylen).

In einem trockenen 6 L Vierhalskolben mit mechanischem Teflonrührer, Rückflußkühler, Thermometer und Tropftrichter wurden 3400 ml trockenes und O₂freies 1,4-Dioxan auf 97°C erhitzt. Dann wurde eine Lösung von 8.44 g (23.35 mmol) 2,5-Bis(chlormethyl)-1-methoxy-4-(3',7'-dimethyloctyloxy)benzol und 9.52 g (23.35 mmol) 2,5-Bis(chlormethyl)-4'-(3,7-dimethyloctyloxy)biphenyl in 50 ml trockenem 1,4-Dioxan zugesetzt. Nun wurde eine Lösung von 13.10 g (117 mmol) Kalium-tert.-butylat in 117 ml trockenem 1,4-Dioxan innerhalb von 5 Minuten zu der intensiv gerührten Mischung getropft. Die Farbe veränderte sich dabei von farblos über gelb nach orangerot. Nach 5 Minuten wurden weitere 10.48 g (93 mmol) Kalium-tert-butylat, gelöst in 93 ml 1,4-Dioxan, zugegeben. Nach 2 Stunden Rühren bei 95-97°C wurde auf 45°C abgekühlt und ein Gemisch aus 19 ml Essigsäure und 20 ml 1,4-Dioxan zugesetzt. Die nun orange Lösung wurde auf 4 L intensiv gerührtes Wasser gegossen. Das ausgefallene Polymer wurde durch Filtration durch einen Polypropylenfilter isoliert und im Vakuum getrocknet. Die Rohausbeute betrug 12.65 g (40.6 mmol, 87%).
Das Polymer wurde unter Erhitzen auf 60°C in 1690 ml THF gelöst und durch Zusatz von 1700 ml Methanol bei 40°C gefällt. Nach Trocknen im Vakuum wurde dieser Schritt wiederholt. Man erhielt nach Trocknung im Vakuum 7.10 g (= 22.79 mmol, 49 %) des Polymers V3 als hell-orange Fasern.
¹H NMR (400 MHz, CDCl₃): δ (ppm) = 7.9-6.9 (br. m, 6.5 H); 4.2-3.6 (br. m, 3.5 H); 2.9-2.6 (br. m, 7% Bisbenzyl); 2.0-0.9 (br. m, 10H); 0.89, 0.86 (2 s, 9H).
GPC: THF + 0.25% Oxalsäure; Säulensatz SDV500, SDV1000, SDV10000 (Fa. PSS), 35°C, UV Detektion 254 nm, Polystyrol-Standard: M_{w} = 1.5×10⁶ g/mol, Mₙ = 2.8×10⁵ g/mol.

### Beispiel V4:

### Quarternäres Copolymer aus 2% 2,5-Bis(chlormethyl)-1-methoxy-4-(3,7-dimethyloctyloxy)benzol, 13% 2,5-Bis(chlormethyl)-2',5'-dimethylbiphenyl, 25% 2,5-Bis(chlormethyl)-3'-(3,7-dimethyloctyloxy)biphenyl und 60% 2,5-Bis(chlormethyl)-4'-(3,7-dimethyloctyloxy)biphenyl (Polymer V4):

### Herstellung von Poly(2-methoxy-5-(3,7-dimethyloctyloxy)-p-phenylenvinylen)co(2-(3'-(3,7-dimethyloctyloxy)phenyl)-p-phenylenvinylen)phenylenvinylen)co(2-(4'-(3,7-dimethyloctyloxy)phenyl)-p-phenylenvinylen)co(2-(2',5'-dimethyl)phenyl)-p-phenylenvinylen).

In einem trockenen 6 L Vierhalskolben mit mechanischem Rührer, Rückflußkühler, Thermometer und Tropftrichter wurden 3.55 kg (3.40 L) trockenes und O₂-freies 1,4-Dioxan vorgelegt und unter Rühren auf 98°C erhitzt. Dann wurde eine Lösung von 240 mg (0.66 mmol)-2,5-Bis(chiormethyl)-1-methoxy-4-(3,7-dimethyloctyloxy)benzol, 3.38 g (8.29 mmol) 2,5-Bis(chlormethyl)-3'-(3,7-dimethyloctyloxy)biphenyl, 8.11 g (19.9 mmol) 2,5-Bis(chlormethyl)-4'-(3,7-dimethyloctyloxy)biphenyl und 1.20 g (4.31 mmol) 2,5-Bis(chlormethyl)-2',5'dimethylbiphenyl, gelöst in 50 ml trockenem 1,4-Dioxan, zugesetzt. Dann wurde eine Lösung von 9.30 g (82.9 mmol, 2.6 eq) Kalium-tert-butylat in 83 ml trockenem 1,4-Dioxan innerhalb von 5 Minuten zu der intensiv gerührten Mischung getropft. Die Viskosität der Lösung nahm leicht zu. Nach 5 Minuten Rühren bei 98°C wurden nochmals 7.44 g (66.3 mmol, 2.0 eq) Kalium-tert-butylat in 66 ml 1,4-Dioxan innerhalb von einer Minute zugesetzt. Nach weiteren 2 Stunden Rühren bei 97°-98°C wurde auf 45°C abgekühlt und ein Gemisch aus 19.1 ml Essigsäure und 20 ml 1,4-Dioxan wurden zugesetzt. Das Polymer wurde nach 20 Minuten Nachrühren durch Zusetzen der Reaktionslösung zu 4 L intensiv gerührtem Wasser ausgefällt. Das so erhaltene Polymer wurde abfiltriert und zweimal mit je 300 ml Methanol gewaschen. Nach Vakuumtrocknung bei Raumtemperatur wurden 10.40 g (32.8 mmol, 99%) rohes Polymer erhalten.

Das Rohprodukt wurde unter Erhitzen auf 60°C in 1390 ml THF gelöst und durch Zusatz von 1.4 L Methanol gefällt. Nach Trocknen im Vakuum und Waschen mit 100 ml Methanol wurde dieser Schritt wiederholt (800 ml THF/800 ml Methanol). Man erhielt nach zweitägiger Trocknung im Vakuum 7.90 g (= 24.9 mmol, 75 %) des Polymer V4 als hell-orange Fasern.
¹H NMR (400 MHz, CDCl₃): δ (ppm) = 7.9-6.6 (br. m; ca 9 H); 4.0 (br. s, ca. 2 H); 2.9-2.6 (br. m, 12% Bisbenzyl); 2.4, 2.1 (2 x br. s, 2 x je H); 1.9-0.8 (br. m, ca. 19 H). GPC: THF + 0.25% Oxalsäure; Säulensatz SDV500, SDV1000, SDV10000 (Fa. PSS), 35°C, UV Detektion 254 nm, Polystyrol-Standard: M_{w} = 7.8×10⁵ g/mol, Mₙ = 1.9×10⁵ g/mol.

### Beispiel V5:

### Copolymer aus 82% 2,5-Bis(chlormethyl)-1-(3,7-dimethyloctyloxy)-4-methoxybenzol und 18% 2,5-Bis(chlormethyl)-3'-(3,7-dimethyloctyloxy)-4-methoxybiphenyl (Polymer V5):

### Herstellung von Poly(2-(3,7-dimethyloctyloxy)-5-methoxy-p-phenylenvinylen)co(2-(3'-(3,7-dimethyloctyloxy)phenyl)-5-methoxy-p-phenylenvinylen).

In einem trockenen 1 L Vierhalskolben mit mechanischem Teflonrührer, Rückflußkühler, Thermometer und Tropftrichter wurden 540 ml trockenes und O₂-freies 1,4-Dioxan auf 98°C erhitzt. Dann wurde eine Lösung von 2.37 g (6.56 mmol) 2,5-Bis(chlormethyl)-1-(3,7-dimethyloctyloxy)-4-methoxybenzol und 0.630 g (1.44 mmol) 2,5-Bis(chlormethyl)-3'-(3,7-dimethyloctyloxy)-4-methoxybiphenyl in 10 ml trockenem 1,4-Dioxan zugesetzt. Nun wurde eine Lösung von 2.47 g (22 mmol) Kalium-tert-butylat in 22 ml trockenem 1,4-Dioxan innerhalb von 5 Minuten zu der intensiv gerührten Mischung getropft. Die Farbe veränderte sich dabei von farblos über gelb nach orangerot. Nach 5 Minuten wurden weitere 2,47 g (22 mmol) Kalium-tert-butylat, gelöst in 22 ml 1,4-Dioxan, zugegeben. Nach 2 Stunden Rühren bei 98-99°C wurde auf 42°C abgekühlt. Ein Gemisch aus 6 ml Essigsäure und 6 ml 1,4-Dioxan wurde nun zugesetzt. Die orange trübe Lösung wurde auf 0.6 L intensiv gerührtes Wasser gegossen. Das flockig ausgefallene Polymer wurde durch Filtration durch einen Polypropylenfilter isoliert und im Vakuum getrocknet. Die Rohausbeute betrug 2.46 g (6.56 mmol, 82%).
Das Polymer wurde unter Erhitzen auf Rückfluß in 330 ml THF gelöst. Es wurde durch Zutropfen von 350 ml Methanol gefällt. Nach Trocknen im Vakuum wurde in 300 ml THF gelöst und durch Zugabe von 300 ml Methanol gefällt. Man erhielt nach Waschen mit Methanol und Trocknung im Vakuum 1.62 g (= 4.32 mmol, 54%) von Polymer V5 als orange Fasern.
¹H NMR (400 MHz, CDCl₃): δ (ppm) = 7.9-6.5 (br. m, 4.7 H); 4.4-3.6 (br. m, 5 H); 3.0-2.7 (br. m, 3.5% Bisbenzyl); 2.0-0.7 (br. m, 19 H).
Aufgrund der Neigung von Polymer V5 zur Gelbildung konnte keine GPC Messung vorgenommen werden.

### Beispiel V6:

### Polymerisation von 2,5-Bis(chlormethyl)-3'-(3,7-dimethyloctyloxy)biphenyl (Polymer V6) durch Dehydrohalogenierung:

### Herstellung von Poly[2-(3'-(3,7-dimethyloctyloxy)phenyl)-p-phenylenvinylen].

In einer trockenen Reaktionsapparatur (2 L Vierhalsrundkolben mit Rückflußkühler, mechanischem Rührer, Tropftrichter und Thermometer) wurden 640 g (619 ml) trockenes 1,4-Dioxan vorgelegt und durch 15 minütiges Durchleiten von N₂ entgast. Nach Umstellen auf N₂-Überlagerung wurde auf 98°C erhitzt. Nun wurden 3.26 g (8.00 mmol) 2,5-Bis(chlormethyl)-3'-(3,7-dimethyloctyloxy)biphenyl (gelöst in 30 ml trockenem 1,4-Dioxan) der siedenden Lösung zugesetzt. Eine Lösung von 2.33 g (20.8 mmol, 2.6 eq) Kalium-*tert*-butylat in 21 ml trockenem 1,4-Dioxan wurde innerhalb von 5 Minuten zugetropft; die Farbe der Reaktionsmischung änderte sich dabei von farblos nach grün. Nach 5 Minuten wurden weitere 1.8 g (16 mmol, 2 eq) Kalium-*tert*-butylat (gelöst in 18 ml trockenem 1,4-Dioxan) innerhalb von einer Minute zugesetzt. Es wurde weitere 2 Stunden bei 98°C gerührt. Die Farbe veränderte sich dabei von grün nach gelb-grün. Die Reaktionslösung wurde auf 50°C abgekühlt und mit einem Gemisch aus 3 ml Essigsäure und 3 ml 1,4-Dioxan versetzt. Es wurde weitere 20 Minuten gerührt und dann unter intensivem Rühren auf 700 ml Wasser gegossen. Nach Zugabe von 100 ml Methanol wurde das Polymer (feine grüne Fasern) durch einen Polypropylen Rundfilter abgesaugt, mit 100 ml Methanol/Wasser 1:1 und dann mit 100 ml reinem Methanol gewaschen. Nach Trocknung im Vakuum bei Raumtemperatur wurden 2.60 g (7.77 mmol, 97%) rohes Polymer V6 erhalten.
Die Reinigung erfolgte durch Auflösen des Polymers in 300 ml THF (60°C), Abkühlen auf 30°C und Fällung durch Zutropfen von 300 ml Methanol. Nach Waschen mit 100 ml Methanol wurde bei Raumtemperatur im Vakuum getrocknet. Diese Prozedur wurde noch zweimal mit je 260 ml THF/260 ml Methanol wiederholt. Es wurden 1.85 g (5.53 mmol, 69%) von Polymer V6 als grün fluoreszensierendes faserförmiges Polymer erhalten.
¹H NMR (400 MHz, CDCl₃): (ppm) = 7.85-7.02 (br. m, 7 H; Hₐᵣₒₘ); 6.92, 6.67 (br. s, zus. 2H; Olefin-H) 3.99 (br. s, 2 H; OCH₂); 1.82 (br. s, 1H; aliph. H); 1.72-1.45 (m, 3H); 1.40-1.08 (m, 6H), 0.91 (s, 3H; CH₃); 0.85 (s, 3H; CH₃); 0.83 (s, 3H; CH₃).
GPC: THF + 0.25% Oxals.; Säulensatz SDV500, SDV1000, SDV10000 (Fa. *PSS*), 35°C, UV Detektion 254 nm, Polystyrol-Standard: M_{w} = 6.3×10⁵ g/mol, Mₙ = 6.8×10⁴ g/mol.

### Beispiel V7: Homopolymerisation von 2,5-Bis(chlormethyl)-1-methoxy-4-(3',7'dimethyloctyloxy)benzol (Polymer V7):

### Herstellung von Poly(2-methoxy-5-(3,7-dimethyloctyloxy)-p-phenylenvinylen).

Ein 4 L Vierhalskolben mit mechanischem (Teflon)Rührer, Rückflußkühler, Thermometer und Tropftrichter wurde ausgeheizt (Heißluftfön) und mit N₂ gespült. Dann wurde mit 2.3 L getrocknetem 1,4-Dioxan befüllt und zum Entgasen wurde ca. 15 Minuten N₂ durch das Lösungsmittel geleitet. Es wurde im Ölbad auf 98°C erhitzt und 14.0 g (38.7 mmol) 2,5-Bis(chlormethyl)-1-methoxy-4-(3',7'dimethyloctyloxy)benzol wurden als Feststoff zugesetzt (es wurde mit etwa 10 ml trockenem 1,4-Dioxan nachgespühlt). Durch den Tropftrichter wurden 11.3 g (100 mmol, 2.6 eq) Kalium-*tert*-butylat, gelöst in 100 ml 1,4-Dioxan, innerhalb von 5 Minuten zu der Reaktionslösung getropft. Die Reaktionsmischung verfärbte sich dabei von farblos über grünlich nach gelb/orange, die Viskosität nahm deutlich zu. Nach beendeter Zugabe wurde noch ca. 5 min bei 98°C gerührt, dann wurden 8.70 g Kalium-*tert*-butylat (77 mmol, 2 eq) in 100 ml trockenem 1,4-Dioxan innerhalb von einer Minute zugesetzt und es wurde noch 2 h bei 96-98°C weitergerührt. Dann wurde die Lösung innerhalb von ca. 2 Stunden auf 50°C abgekühlt. Die Reaktion wurde schließlich mit 15 ml (260 mmol, 1.5 eq bez. auf Base) Essigsäure (verdünnt mit der gleichen Menge Dioxan) versetzt und noch 20 Minuten gerührt. Die Lösung war nun tief orange. Zur Aufarbeitung wurde die Reaktionslösung langsam auf 2.5 L intensiv gerührtes Wasser geschüttet. Es wurde noch 10 Minuten gerührt, mit 200 ml Methanol versetzt und das ausgefallene Polymer abfiltriert. Es wurde mit 200 ml Methanol gewaschen und im Vakuum bei Raumtemperatur getrocknet. Man erhielt 10.04 g (34.8 mmol, 90%) rohes Polymer als rote Fasern.
Die Reinigung erfolgte durch Auflösen des Polymers in 1.1 L THF (60°C), Abkühlen auf 40°C und Fällung durch Zutropfen von 1.2 L Methanol. Nach Waschen mit 200 ml Methanol wurde bei Raumtemperatur im Vakuum getrocknet. Diese Prozedur wurde nochmals mit je 1.0 L THF/1.0 L Methanol wiederholt. Es wurden 6.03 g (20.9 mmol, 54%) von Polymer V7 als dunkel-oranges faserförmiges Polymer erhalten
¹H NMR (400 MHz, CDCl₃): (ppm) = 7.7-6.5 (br. m, 4 H; Hₐᵣₒₘ, Olefin-H); 4.5-3.6 (br. m, 5 H; OCH₃, OCH₂); 2.9 (br. s, Bisbenzyl (3,5%)); 2.1-0.6 (br. m, 19H; aliph. H). GPC: THF + 0.25% Oxals.; Säulensatz SDV500, SDV1000, SDV10000 (Fa. *PSS*), 35°C, UV Detektion 254 nm, Polystyrol-Standard: M_{w} = 1.2×10⁶ g/mol, Mₙ = 1.1×10⁵ g/mol.

### Teil 3: Herstellung und Charakterisierung von LEDs:

Die Herstellung von LEDs erfolgte nach dem im folgenden skizzierten allgemeinen Verfahren. Dieses mußte natürlich im Einzelfall auf die jeweiligen Gegebenheiten (z. B. Polymerviskosität und optimale Schichtdicke des Polymers im Device) angepaßt werden. Die im nachfolgenden beschriebenen LEDs waren jeweils Einschichtsysteme, d. h. Substrat//ITO//Polymer//Kathode.

### Allgemeines Verfahren zur Herstellung von hocheffizienten, langlebigen LEDs:

Nachdem man die ITO-beschichteten Substrate (z. B. Glasträger, PET-Folie) auf die richtige Größe zugeschnitten hat, werden sie in mehreren Reinigungsschritten im Ultraschallbad gereinigt (z.B. Seifenlösung, Millipore-Wasser; Isopropanol).
Zur Trocknung werden sie mit einer N₂-Pistole abgepustet und in einem Exsikkator gelagert. Vor der Beschichtung mit dem Polymer werden sie mit einem Ozon-Plasma-Gerät für ca. 20 Minuten behandelt. Von dem jeweiligen Polymer wird eine Lösung (in der Regel mit einer Konzentration von 4-25 mg/ml in beispielsweise Toluol, Chlorbenzol, Xylol:Cyclohexanon (4:1)) angesetzt und durch Rühren bei Raumtemperatur gelöst. Je nach Polymer kann es auch vorteilhaft sein, für einige Zeit bei 50 - 70°C zu rühren. Hat sich das Polymer vollständig gelöst, wird es durch einen 5µm oder kleiner Filter filtriert und bei variablen Geschwindigkeiten (400-6000) mit einem Spin-coater aufgeschleudert. Die Schichtdicken können dadurch im Bereich von ca. 50 und 300nm variiert werden.
Auf die Polymerfilme werden noch Elektroden aufgebracht. Dies geschieht in der Regel durch thermisches Verdampfen (Balzer BA360 bzw. Pfeiffer PL S 500). Anschließend wird die durchsichtige ITO-Elektrode als Anode und die Metallelektrode (z. B. Ca) als Kathode kontaktiert und die Device-Parameter bestimmt.

Die mit den beschriebenen Polymeren erhaltenen Resultate sind in Tabelle 1 zusammengefaßt:

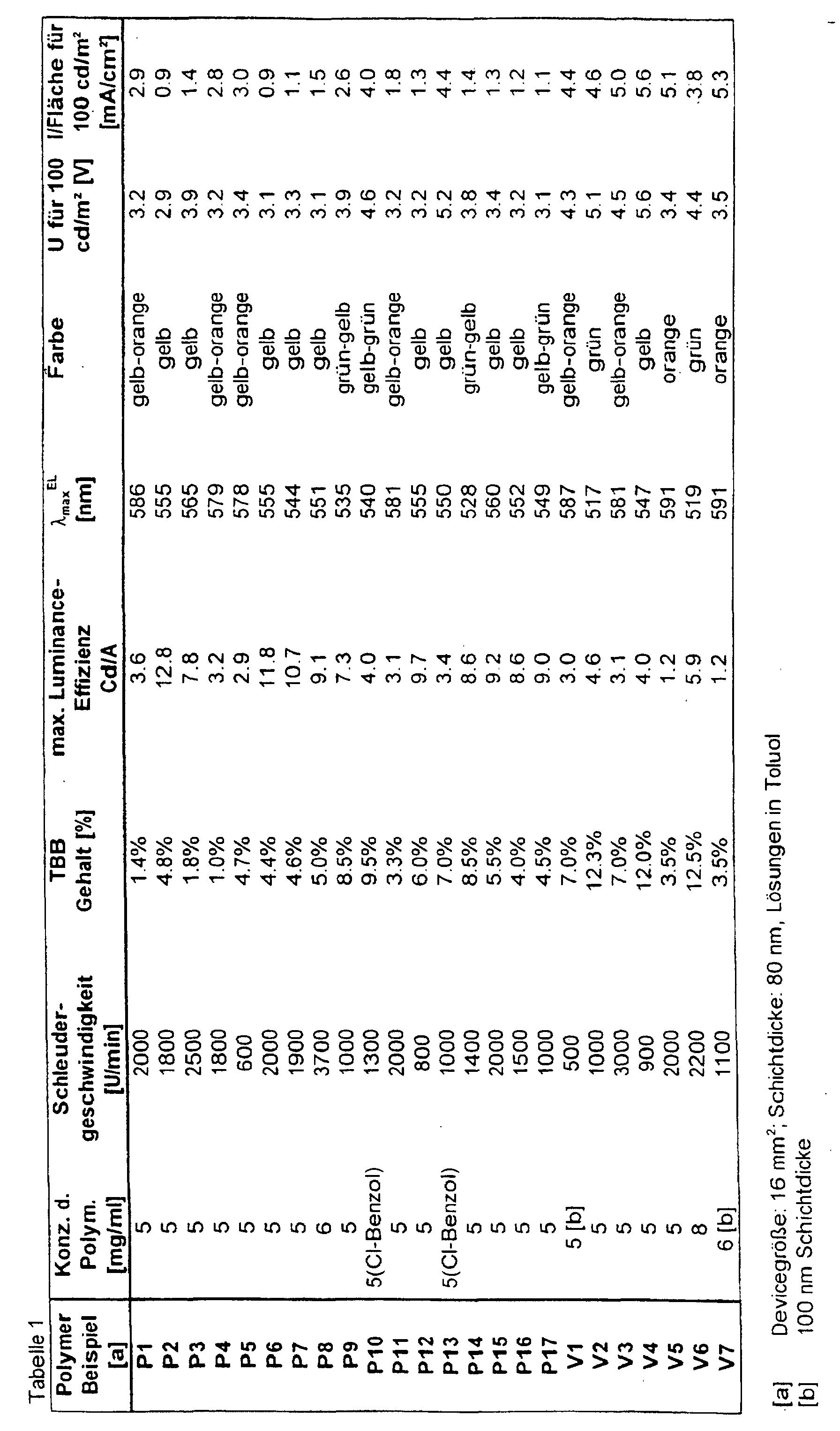

Die erfindungsgemäßen Polymere weisen einen strukturellen Unterschied bezüglich bestimmter Defektstrukturen gegenüber allen bisher bekannten via Dehydrohalogenierung hergestellten PPVs auf, der im folgenden näher erläutert werden soll, ohne die Erfindung darauf einzuschränken, noch die Erfindung vom Wahrheitsgehalt des erläuterten Modells abhängig zu machen. Dieser strukturelle Unterschied kann mit dem Erhalten der gewünschten Eigenschaften (lange aktive Lebensdauer der entsprechenden LEDs; niedriger Spannungsanstieg) modellhaft in Korrelation gesetzt werden.
Bei der Dehydrohalogenierungspolymerisation läuft - dem geschilderten Modell zufolge - folgendes ab: Das stabile, eingesetzte Prämonomer (im bisherigen Text nur Monomer genannt) spaltet unter Einwirkung einer starken Base zunächst einmal HX ab, wodurch das eigentliche Monomer (Chinodimethan) entsteht. Dieses reaktive Intermediat polymerisiert nun sehr schnell (vermutlich anionisch initiert) zum Präpolymeren, welches durch weitere baseninduzierte HX-Eliminierung zum eigentlichen PPV umgewandelt wird (vgl. nf. Schema). 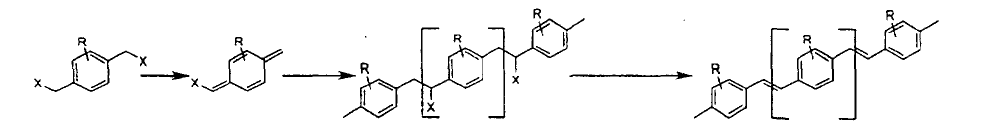 Solange hier immer eine einheitliche Kopf-Schwanz-Polymerisation stattfindet, führt dies zu einem defektfreien PPV. Sobald sich hier allerdings einmal ein Monomer quasi verkehrt herum einordnet (d.h. Kopf-Kopf- und Schwanz-Schwanz-Polymerisation) führt dies zum Auftreten von Dreifach- und Einfachbindungen bzw. zu einem Tolan-Bisbenzyl-Defekt (TBB); vgl. nf. Schema. 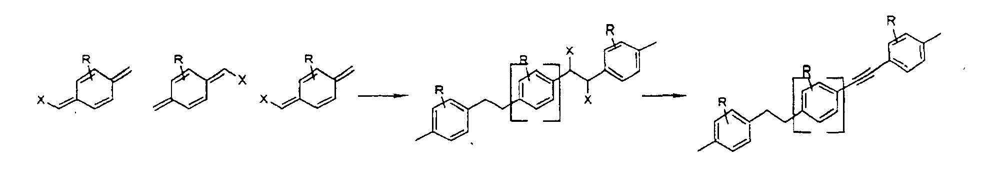 Diese Defekte sind auch analytisch im NMR der entsprechenden Polymere nachzuweisen. Die Bisbenzyleinheit gibt ein breites Signal im Bereich von 2.6 bis 3.0 ppm (¹H NMR; CDCl₃; ca. 300 K). Aus der Integration dieses Signals und dem Vergleich mit anderen Hauptsignalen kann man Aussagen über den Gehalt an fehlerhaften Bindungen machen. Aus einer Anzahl von Experimenten (vgl. Abb. 1 und 2 und Vergleichsexperimente V1-V7) ist nun folgendes bekannt: 2,5-Dialkoxy-PPVs weisen i. d. R. einen TBB-Gehalt im Bereich von 3-5% auf (TBB-Gehalt: Gehalt an Einfach+Dreifachbindungen bezogen auf die Gesamtanzahl an "Vinylischen Bindungen"). Copolymere welche Dialkoxy-PPV-einheiten und arylsubstituierte-PPV-einheiten enthalten, weisen einen höheren TBB-Anteil auf; der vom Monomerenverhältnis abhängt. Homopolymere, welche 2-arylsubstituierte PPVs darstellen, haben einen TBB-Gehalt von über 12%. Ein überraschend gefundenes Merkmal der erfindungsgemäßen Polymere ist, daß der TBB-Gehalt deutlich niedriger liegt als derjenige von Vergleichspolymeren, die keinen weiteren Substituenten in 5 oder 6-Position, d. h. zusätzlich zum Arylsubstituenten am Phenylring tragen: So weißt beispielsweise ein 50/50 Copolymer aus Dialkoxy-PPVmonomeren und 5-Methoxy-2-aryl-PPV-monomeren einen TBB-Gehalt von ca. 1.5% auf (im Vgl. zu ca. 6-8% des entsprechenden Polymers ohne die Methoxysubstitution) (vgl. Bsp. P1). Analog weißt ein 50/50 Copolymer zwischen Aryl-PPV-monomeren und 5-Methoxy-2-aryl-PPV-monomeren einen TBB-Gehalt von ca. 5-6% auf (im Vgl. zu ca. 12% des entsprechenden Polymers ohne die. Methoxysubstitution) (vgl. Bsp. P2).
Dieser niedrigere TBB-Gehalt führt nun (vgl. nachfolgende Tabelle) überraschend zu einer deutlichen Erniedrigung des Spannungsanstiegs (jeweils bezogen auf vergleichbare Polymere) und auch zu höheren aktiven Lebensdauern. Somit kann die hier beschriebene strukturelle Eigenart der erfindungsgemäßen Polymeren retrospektiv als wissenschaftlicher Hintergrund für die überraschend gefundenen wünschenswerten Eigenschaften gesehen werden.

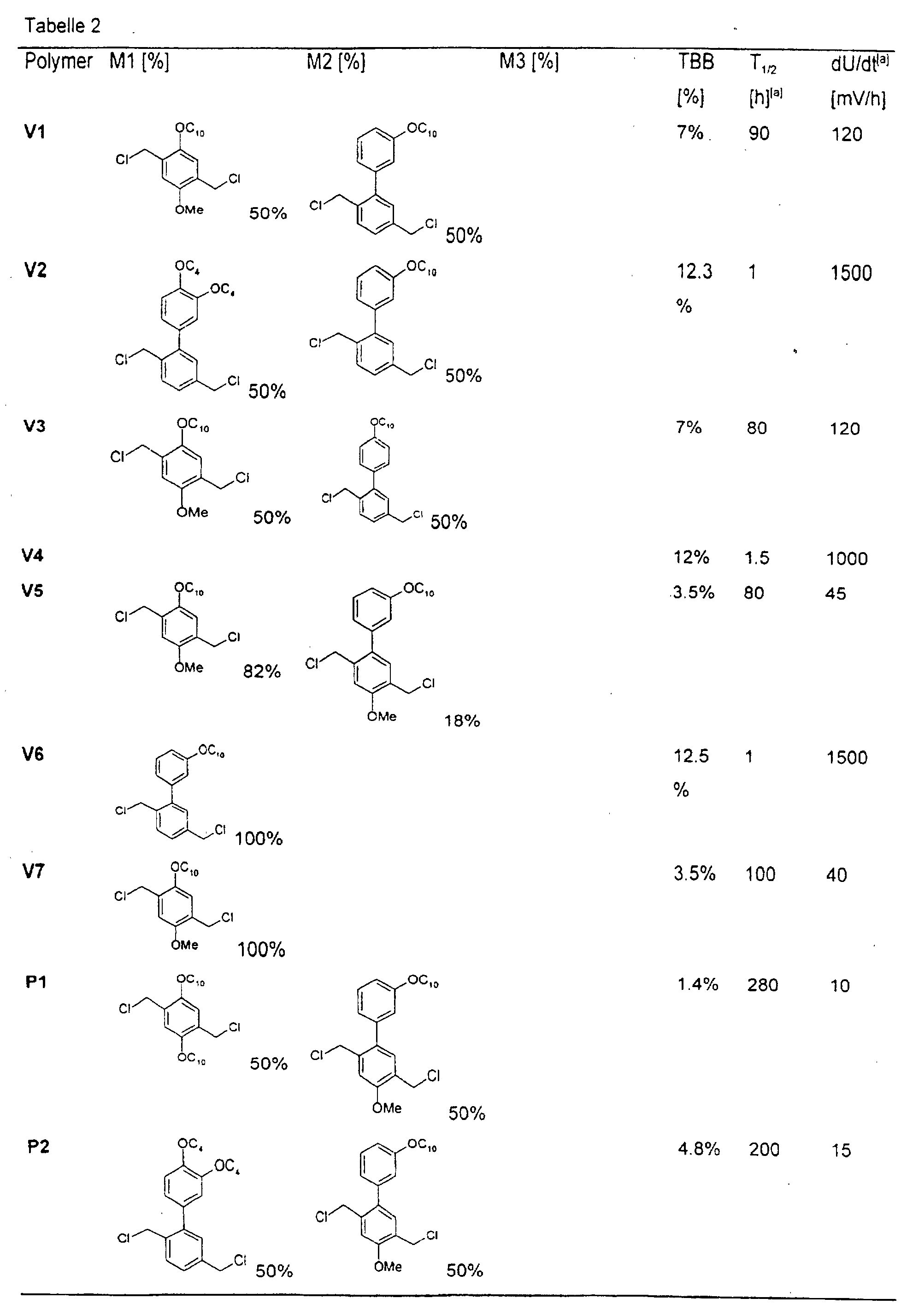

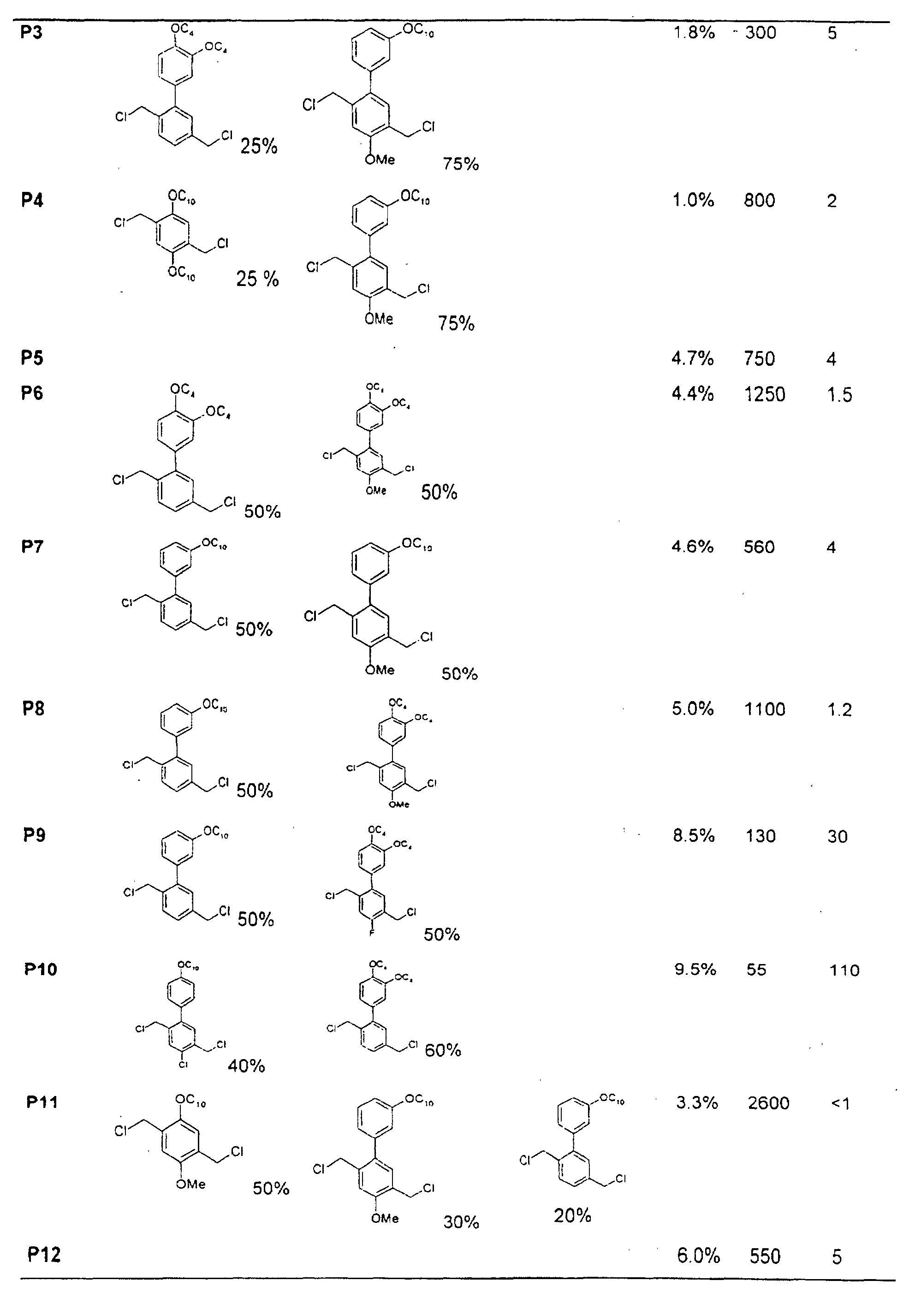

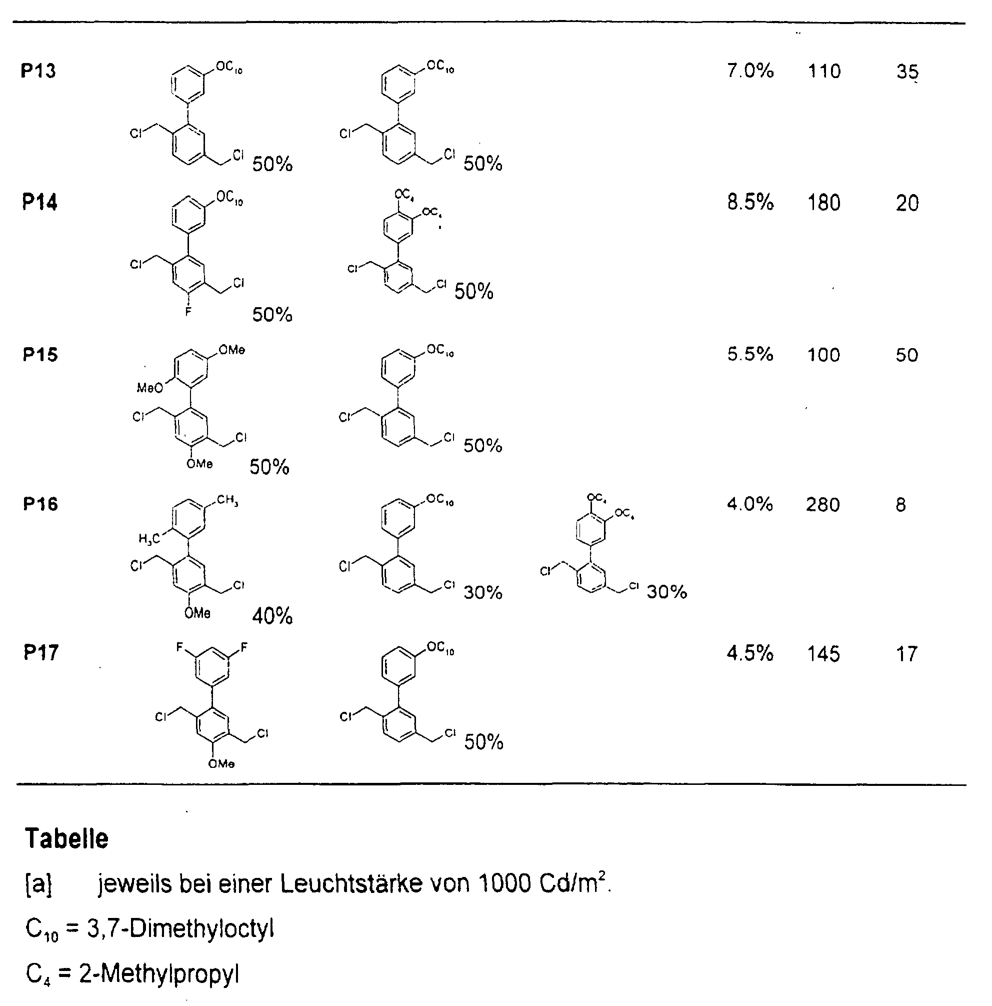

## Patentansprüche

1. Poly(arylenvinylen), enthaltend mindestens 20 % Wiederholeinheiten der Formel (I), 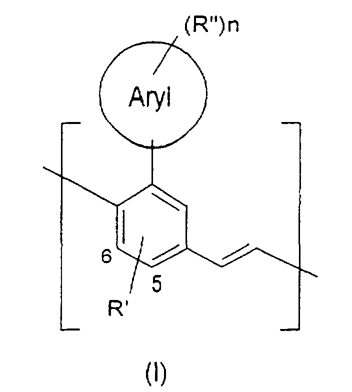 wobei die Symbole und Indizes folgende Bedeutungen haben:
Aryl : ist eine Arylgruppe mit 4 bis 14 C-Atomen;
R' : ist ein Substituent, der sich entweder in der markierten Phenylenposition 5 oder 6 befindet und ist CN, F, CI, N(R¹R²) oder eine geradkettige, verzweigte oder cyclische Alkyl-, Alkoxy- oder Thioalkoxygruppe mit 1 bis 20 C-Atomen, in welcher ein oder mehrere H-Atome auch durch F ersetzt sein können;
R" : ist, gleich oder verschieden, CN, F, CI oder eine geradkettige, verzweigte oder cyclische Alkyl- oder Alkoxygruppe mit 1 bis 20 C-Atomen, wobei ein oder mehrere nicht benachbarte CH₂-Gruppen durch -O-, -S-, -CO-, -COO-, -O-CO-, -NR¹-, -(NR²R³)⁺-A⁻, oder -CONR⁴- ersetzt sein können und wobei ein oder mehrere H-Atome durch F ersetzt sein können, oder eine Arylgruppe mit 4 bis 14 C-Atome, die durch einen oder mehrere, nicht aromatische Reste R' substituiert sein kann;
R¹,R²,R³,R⁴ sind gleich oder verschieden, H oder ein aliphatischer oder aromatischer Kohlenwasserstoffrest mit 1 bis 20 C-Atomen;
A⁻ : ein einfach geladenes Anion oder dessen Äquivalent;
n : 0, 1, 2, 3, 4 oder 5;

2. Poly(arylenvinylen) gemäß Anspruch 1, **dadurch gekennzeichnet, daß** es 10 bis 10 000 Wiederholeinheiten aufweist.

3. Poly(arylenvinylen) gemäß Anspruch 1 und/oder 2, bestehend im wesentlichen aus Wiederholeinheiten der Formel (I).

4. Poly(arylenvinylen) gemäß Anspruch 1 und/oder 2, **dadurch gekennzeichnet, daß** es ein Copolymer ist.

5. Poly(aryfenvinylen) gemäß Anspruch 4, **dadurch gekennzeichnet, daß** es mindestens zwei verschiedene Wiederholeinheiten der Formel (I) enthält.

6. Poly(arylenvinylen) gemäß Anspruch 5, **dadurch gekennzeichnet, daß** es neben einer oder mehreren Wiederholeinheiten der Formel (I) eine oder mehrere weitere Poly(arylenvinylen)-Wiederholeinheiten enthält.

7. Poly(arylenvinylene) gemäß Anspruch 6, **dadurch gekennzeichnet, daß** sie eine oder mehrere 2,5-Dialkoxy-1,4-phenylenvinylen-Wiederholeinheiten enthalten.

8. Poly(arylenvinylen) gemäß einem oder mehreren der vorhergehenden Ansprüche, wobei die Symbole und Indizes in der Formel (I) folgende Bedeutungen haben:
Aryl ist Phenyl, 1- bzw. 2-Naphthyl, 1-, 2- bzw. 9-Anthracenyl, 2-, 3- bzw. 4-Pyridinyl, 2-, 4- bzw. 5-Pyrimidinyl, 2-Pyrazinyl, 3- bzw. 4-Pyridazinyl, 2-, 3-, 4-, 5-, 6-, 7- bzw. 8-Chinolin, 2- bzw. 3-Thiophenyl, 2- bzw. 3-Pyrrolyl, 2- bzw. 3-Furanyl und 2-(1,3,4-Oxadiazol)yl;
R' ist gleich oder verschieden, CN, F, Cl, CF₃ oder eine geradkettige oder verzweigte Alkoxygruppe mit 1 bis 12 C-Atomen;
R" ist gleich oder verschieden eine geradkettige oder verzweigte Alkyl - oder Alkoxygruppe mit 1 bis 12 C-Atomen;
n ist 0, 1, 2 oder 3, besonders bevorzugt 0, 1 oder 2.

9. Poly(arylenvinylen) gemäß Anspruch 8, **dadurch gekennzeichnet, daß** Aryl in der Formel (I) die Bedeutung Phenyl, 1-Naphthyl, 2-Naphthyl oder 9-Anthracenyl, hat.

10. Poly(arylenvinylen) gemäß Anspruch 9, **dadurch gekennzeichnet, daß** in der Wiederholeinheit der Formel (I) der Arylsubstituent folgendes Substitutionsmuster aufweist:
2-, 3- bzw. 4-Alkyl(oxy)phenyl, 2,3-, 2,4-, 2,5-, 2,6-, 3,4- bzw. 3,5-Dialkyl(oxy)phenyl, 2,3,4,-, 2,3,5-, 2,3,6-, 2,4,5, 2,4,6- bzw. 3,4,5-Trialkyl(oxy)phenyl, 2-, 3-, 4-, 5-, 6-, 7-bzw. 8-Alkyl(oxy)-1-naphthyl, 1-, 3-, 4-, 5-, 6-, 7- bzw. 8-Alkyl(oxy)-2-naphthyl und 1 0-Alkyl(oxy)-9-anthracenyl.

11. Verfahren zur Herstellung eines Poly(arylenvinylens) gemäß einem oder mehreren der Ansprüche 1 bis 10, **dadurch gekennzeichnet, daß** man ein oder mehrere Monomere, die ein oder mehrere polymerisierbare Biaryle der Formel (II) enthalten, 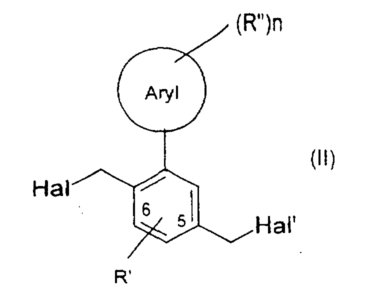 wobei Hal, Hal' gleich oder verschieden Cl, Br oder I ist, und die übrigen Symbole und Indizes die in der Formel (I) angegebenen Bedeutungen haben, via baseninduzierter Dehydrohalogenierung polymerisiert.

12. Verwendung eines Poly(arylenvinylens) gemäß einem oder mehreren der Ansprüche 1 bis 10 als Elektrolumineszenzmaterial.

13. Elektrolumineszenzmaterial, enthaltend ein oder mehrere Poly(arylenvinylene) gemäß einem oder mehreren der Ansprüche 1 bis 10.

14. Verfahren zur Herstellung eines Elektrolumineszenzmaterials gemäß Anspruch 13, **dadurch gekennzeichnet, daß** man ein oder mehrere Poly(arylenvinylene), enthaltend Wiederholeinheiten der Formel (I), als Film auf ein Substrat aufbringt, das gegebenenfalls weitere Schichten enthält.

15. Elektrolumineszenzvorrichtung, enthaltend eine oder mehrere aktive Schichten, wobei mindestens eine dieser aktiven Schichten ein oder mehrere Poly(arylenvinylene) gemäß einem oder mehreren der Ansprüche 1 bis 10 enthält.

16. Poly(arylenvinylen) gemäß einem der Ansprüche 1 bis 10, **dadurch gekennzeichnet, daß** der Anteil der TBB-Defektstrukturen (Tolan-Bisbenzyl-Defekt) kleiner 10 % ist.

17. Polymerisierbare Biarylderivate der Formel (II), 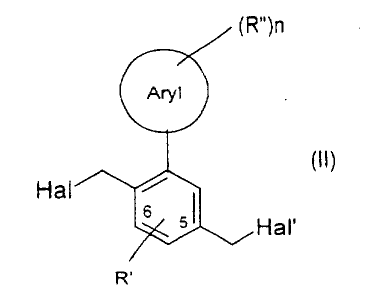 wobei Hal, Hal' gleich oder verschieden Cl, Br oder I ist, und die übrigen Symbole und Indizes die in der Formel (I) angegebenen Bedeutungen haben; mit Ausnahme von 2,5-Bis(chlormethyl)-4-methoxy-4'-(3,7-dimethyloctyloxy)-biphenyl und 2;5-Bis(chlormethyl)-4-methoxy-3'-(3,7-dimethyloctyloxy)-biphenyl.

18. Polymerisierbare Biarylderivate gemäß Anspruch 17, **dadurch gekennzeichnet, daß** der Substituent R' eine geradkettige oder verzweigte Alkoxygruppe mit 1 bis 10 C-Atomen, besonders bevorzugt Methoxy, bedeutet.

19. Verfahren zur Herstellung von polymerisierbaren Biarylderivaten gemäß Anspruch 17 oder 18, **dadurch gekennzeichnet, daß** mindestens eine C-C-Kupplungsreaktion in Gegenwart eines Katalysators erfolgt, der Palladium enthält.

20. Verwendung eines Poly(arylenvinylen) gemäß einem oder mehreren der Ansprüche 1 bis 10 als organischer Halbleiter, **dadurch gekennzeichnet, daß** das Poly(arylenvinylen) als Lösung in einem organischen Lösungsmittel verarbeitet wird.

## Claims

1. Poly(arylenevinylene) containing at least 20% of repeat units represented by Formula (I), 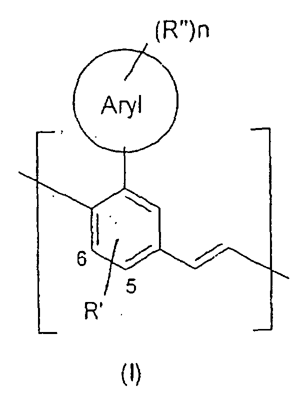 where the symbols and indices have the following significances:
Aryl : is an aryl group containing 4 to 14 C-atoms;
R' : is a substituent which is located either in the marked phenyl position 5 or 6 and is CN, F, Cl, N(R¹ R²) or a straight-chained-, branched- or cyclic alkyl-, alkoxy- or thioalkoxy group with 1 to 20 C-atoms, in which one or more H-atoms may also be replaced by F;
R" : consists of one of or any selection from CN, F, Cl or straight-chained-, branched-or cyclic alkyl-, or alkoxy group with 1 to 20 C-atoms where one or two non-adjacent CH₂-groups may be replaced by -O-, -S-, -CO-, -COO-, -O-CO-, NR¹-, -(NR²R³)⁺-A⁻ or CONR⁴ and where one or more H-atoms may be replaced by F, or where an aryl group with 4 to 14 C-atoms may be replaced by one or more non-aromatic residues R¹;
R¹R²R³R⁴ consists of one of or any selection from H or an aliphatic or aromatic hydrocarbon residue with 1 to 20 C-atoms;
A : is a simple charged anion or its equivalent;
n : 0, 1, 2, 3, 4 or 5;

2. Poly(arylenevinylene) in accordance with claim 1 **characterised in that** it has 10 to 10, 000 repeat units.

3. Poly(arylenevinylene) in accordance with claim 1 and / or 2 consisting essentially of repeat units as represented by Formula (I).

4. Poly(arylenevinylene) in accordance with claim 1 and / or 2, **characterised in that** it is a co-polymer.

5. Poly(arylenevinylene) in accordance with claim 4, **characterised in that** it contains at least two different repeat units represented by the Formula (I).

6. Poly(arylenevinylene) in accordance with claim 5, **characterised in that** in addition to one or more repeat units represented by Formula (1) it contains one or more further poly(arylenevinylene) repeat units.

7. Poly (arylenevinylene) in accordance with claim 6, **characterised in that** it contains one or more 2,5-dialkoxy-1,4-phenylene vinylene repeat units.

8. Poly(arylenevinylene) in accordance with one or more of the preceding claims where the symbols and indices in Formula (I) have the following significances:
Aryl is phenyl, 1 or 2-naphthyl, 1-, 2- or 9-anthracenyl, 2-, 3- or 4-pyridinyl, 2-, 4- or 5-pyrimidinyl, 2-pyrazinyl, 3- or 4-pyridazinyl, 2-, 3-, 4-, 5-, 6-, 7- or 8 quinoline, 2- or 3-thiophenyl, 2- or 3-pyrrolyl, 2- or 3-furanyl and 2-(1,3,4-oxadiazol)yl;
R' is one of or any selection from CN, F, Cl, CF₃ or a straight- or branched chained alkoxy group with I to 12 C-atoms;
R" is one of or any selection from a straight- or branched chain alkyl- or alkoxy group with 1 to 12 C-atoms;
n is 0, 1, 2 or 3 with a particular preference for 0, 1 or 2.

9. Poly(arylenevinylene) in accordance with claim 8, **characterised in that** aryl in Formula (I) has the meaning of phenyl, 1-naphthyl, 2-naphthyl or 9-anthracenyl.

10. Poly(arylenevinylene) in accordance with claim 9, **characterised in that** in the repeat unit of Formula (I) the aryl substituent has the following substitution possibilities: 2-, 3-, or 4-alkyl(oxy)phenyl, 2,3-, 2,4-, 2,5-, 2,6-, 3,4- or 3,5-dialkyl (oxy)phenyl, 2,3,4,-, 2,3,5-, 2,3,6-, 2,4,5, 2,4,6- or 3,4,5,-trialkyl(oxy) phenyl, 2-, 3-, 4-, 5-, 6-, 7-, or 8-alkyl(oxy)-1 naphthyl, 1-, 3-, 4-, 5-, 6-, 7- or 8-alkyl(oxy)-2-naphthyl and 10-alkyl(oxy)-9-anthracenyl.

11. Procedure for the manufacture of a poly(arylenevinylene) in accordance with one or more of claims 1 to 10, **characterised in that** one or more monomers which contain one or more polymerisable bi-aryls represented by Formula (II) 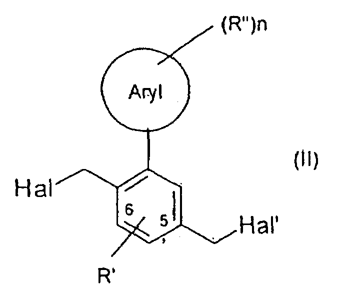 undergo polymerisation as a consequence of base-induced elimination of hydrogen halides, where in Formula (II) Hal, Hal' are the same or different members of the group of Cl, Br or I and the other symbols and indices have the significance attributed to them in Formula (I).

12. Use of a poly(arylenevinylene) in accordance with one or more of claims 1to 10 as an electro-luminescent material.

13. Electroluminescent material containing one or more poly-(arylenevinylene)s in accordance with one or more of claims 1 to 10.

14. Procedure for the manufacture of an electroluminescent material in accordance with claim 13 **characterised in that** one or more poly(arylenevinylene)s containing repeat units represented by Formula (I) are applied in the form of a film to a substrate which may, if required, contain other layers.

15. An electroluminescence device containing one or several active layers, where at least one of these active layers contains one or more poly(arylenevinylene)s in accordance with one or several of claims 1 to 10.

16. Poly(arylenevinylene)s in accordance with one of claims 1 to 10, **characterised in that** the proportion of the TBB-defect-structures (Tolan-bisbenzyl-defect) amounts to less than 10%.

17. Polymerisable bi-aryl derivatives which are represented by Formula (II) 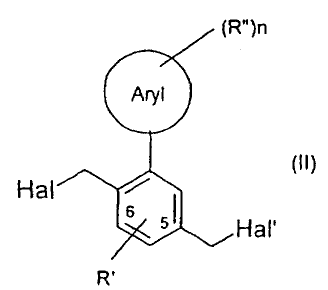 where either or both of Hal, Hal' can be Cl, Br or I and the other symbols and indices have the significance attributed to them in Formula (I), with the exception of 2,5-bis(chloromethyl)-4-methoxy-4'-(3,7-dimethyloctyloxy)-biphenyl and 2, 5-bis(chloromethyl)-4-methoxy-3'-(3,7-dimethyloctyloxy)-biphenyl.

18. Polymerisable bi-aryl derivatives in accordance with claim 17, **characterised in that** the substituent R' is a straight- or branched alkoxy group with 1 to 10 C-atoms, with a special preference for methoxy.

19. Procedure for the manufacture of polymerisable bi-aryl derivatives in accordance with claim 17 or 18, **characterised in that** that at least one C-C-coupling reaction takes place in the presence of a catalyst which contains palladium.

20. Use of a poly(arylenevinylene) in accordance with one or more of claims 1 to 10 as an organic semi-conductor, **characterised in that** the poly(arylenevinylene) is processed in the form of a solution in inorganic solvent.

## Revendications

1. Poly(arylène-vinylène) comprenant au moins 20 % de motifs répétitifs de formule (I), 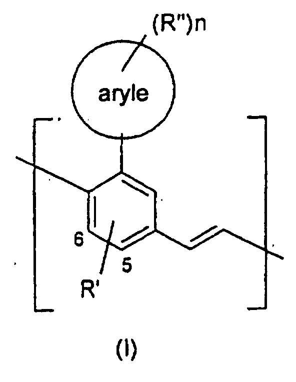 dans laquelle les symboles et indices ont les significations suivantes :
aryle : est un groupe aryle ayant de 4 à 14 atomes de C ;
R' : est un substituant qui se trouve soit en position 5 soit 6 du phénylène marqué et est CN, F, Cl, N(R¹R²) ou un groupe alkyle, alcoxy ou thioalcoxy linéaire, ramifié ou cyclique ayant de 1 à 20 atomes de C, dans lequel un ou plusieurs atomes de H peuvent également être remplacés par F ;
R'' : est, qu'il soit identique ou différent, CN, F, Cl ou un groupe alkyle ou alcoxy linéaire, ramifié ou cyclique ayant de 1 à 20 atomes de C, dans lequel un ou plusieurs groupes CH₂ non voisins peuvent être remplacés par -O-, -S-, -CO-, -COO-, -O-CO-, NR¹-, -(NR²R³)⁺-A⁻ ou -CONR⁴- et dans lequel un ou plusieurs atomes de H peuvent être remplacés par F ou un groupe aryle ayant de 4 à 14 atomes de C, qui peut être substitué par un ou plusieurs radicaux non aromatiques R' ;
R¹, R², R³, R⁴ : sont, qu'ils soient identiques ou différents, H ou un radical d'hydrocarbure aliphatique ou aromatique ayant de 1 à 20 atomes de C ;
A⁻ : est un anion chargé simplement ou son équivalent ;
n : est égal à 0, 1, 2, 3, 4 ou 5 ;

2. Poly(arylène-vinylène) selon la revendication 1, **caractérisé en ce qu'**il présente 10 à 10 000 motifs répétitifs.

3. Poly(arylène-vinylène) selon la revendication 1 et/ou 2, constitué essentiellement de motifs répétitifs de formule (I).

4. Poly(arylène-vinylène) selon la revendication 1 et/ou 2, **caractérisé en ce que** c'est un copolymère.

5. Poly(arylène-vinylène) selon la revendication 4, **caractérisé en ce qu'**il comprend au moins deux motifs répétitifs différents de formule (I).

6. Poly(arylène-vinylène) selon la revendication 5, **caractérisé en ce qu'**il comprend, hormis un ou plusieurs motifs répétitifs de formule (I), un ou plusieurs autres motifs répétitifs de poly(arylène-vinylène).

7. Poly(arylène-vinylènes) selon la revendication 6, **caractérisés en ce qu'**ils comprennent un ou plusieurs motifs répétitifs de 2,5-dialcoxy-1,4-phénylènevinylène.

8. Poly(arylène-vinylène) selon l'une quelconque ou plusieurs des revendications précédentes, dans lequel les symboles et indices dans la formule (I) ont les significations suivantes :
aryle : est un groupe phényle, 1- ou 2-napthyle, 1-, 2- ou 9-anthracényle, 2-, 3- ou 4-pyridinyle, 2-, 4- ou 5-pyrimidinyle, 2-pyrazinyle, 3- ou 4-pyridazinyle, 2-, 3-, 4-, 5-, 6-, 7- ou 8-quinoline, 2- ou 3-thiophényle, 2- ou 3-pyrrolyle, 2- ou 3-furanyle et 2-(1,3,4-oxadiazol)yle ;
R' : est, qu'il soit identique ou différent, CN, F, Cl, CF₃ ou un groupe alcoxy linéaire ou ramifié ayant de 1 à 12 atomes de C ;
R'' : est, qu'il soit identique ou différent, un groupe alkyle ou alcoxy linéaire ou ramifié ayant de 1 à 12 atomes de C ;
n : est égal à 0, 1, 2 ou 3, particulièrement préférentiellement à 0, 1 ou 2.

9. Poly(arylène-vinylène) selon la revendication 8, **caractérisé en ce que** l'aryle dans la formule (I) représente un groupe phényle, 1-napthyle, 2-naphtyle ou 9-anthracényle.

10. Poly(arylène-vinylène) selon la revendication 9, **caractérisé en ce que**, dans le motif répétitif de formule (I), le substituant aryle présente le modèle de substitution suivant :
2-, 3- ou 4-alkyl(oxy)phényle, 2,3-, 2,4-, 2,5-, 2,6-, 3,4- ou 3,5-dialkyl(oxy)phényle, 2,3,4-, 2,3,5-, 2,3,6-, 2,4,5-, 2,4,6- ou 3,4,5-trialkyl(oxy)phényle, 2-, 3-, 4-, 5-, 6-, 7- ou 8-alkyl(oxy)-1-naphtyle, 1-, 3-, 4-, 5-, 6-, 7- ou 8-alkyl(oxy)-2-naphtyle et 10-alkyl(oxy)-9-anthracényle.

11. Procédé de fabrication d'un poly(arylène-vinylène) selon l'une quelconque ou plusieurs des revendications 1 à 10, **caractérisé en ce que** l'on polymérise, par déshydrohalogénation induite par une base, un ou plusieurs monomères qui comprennent un ou plusieurs biaryles polymérisables de formule (II), 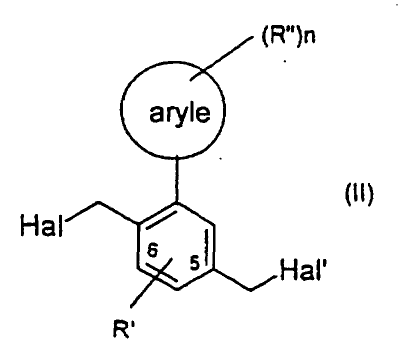 dans laquelle Hal, Hal', qu'ils soient identiques ou différents, sont Cl, Br ou I, et les autres symboles et indices ont les significations indiquées dans la formule (I).

12. Utilisation d'un poly(arylène-vinylène) selon l'une quelconque ou plusieurs des revendications 1 à 10 à titre de matière électroluminescente.

13. Matière électroluminescente, comprenant un ou plusieurs poly(arylène-vinylènes) selon l'une quelconque ou plusieurs des revendications 1 à 10.

14. Procédé de fabrication d'une matière électroluminescente selon la revendication 13, **caractérisé en ce que** l'on dépose à titre de film un ou plusieurs poly(arylène-vinylènes) comprenant des motifs répétitifs de formule (I) sur un substrat comprenant éventuellement d'autres couches.

15. Dispositif électroluminescent, comprenant une ou plusieurs couches actives, dans lequel au moins une de ces couches actives comprend un ou plusieurs poly(arylène-vinylène) selon l'une quelconque ou plusieurs des revendications 1 à 10.

16. Poly(arylène-vinylène) selon l'une quelconque des revendications 1 à 10, **caractérisé en ce que** la part des structures déficientes en TBB (déficientes en toluène-bisbenzyle) est inférieure à 10 %.

17. Dérivés biaryle polymérisables de formule (II), 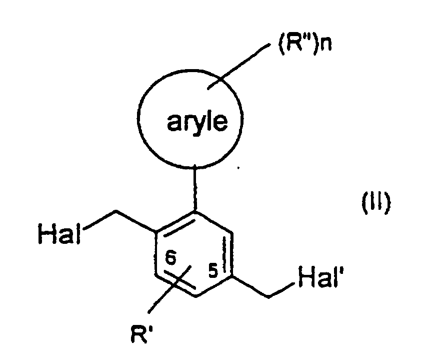 dans laquelle Hal, Hal', qu'ils soient identiques ou différents, sont Cl, Br ou I, et les autres symboles et indices ont les significations indiquées dans la formule (I) ; à l'exception du 2,5-bis(chlorométhyl)-4-méthoxy-4'-(3,7-diméthyloctyloxy)-biphényle et 2,5-bis(chlorométhyl)-4-méthoxy-3'-(3,7-diméthyloctyloxy)-biphényle.

18. Dérivés biaryle polymérisables selon la revendication 17, **caractérisés en ce que** le substituant R' représente un groupe alcoxy linéaire ou ramifié ayant de 1 à 10 atomes de C, particulièrement préférentiellement méthoxy.

19. Procédé de fabrication de dérivés de biaryle polymérisables selon la revendication 17 ou 18, **caractérisé en ce qu'**il se produit au moins une réaction de couplage C-C en présence d'un catalyseur comprenant du palladium.

20. Utilisation d'un poly(arylène-vinylène) selon l'une quelconque ou plusieurs des revendications 1 à 10 à titre de conducteur organique, **caractérisée en ce que** le poly(arylène-vinylène) est transformé à titre de solution dans un solvant organique.
